(19) Europäisches Patentamt
European Patent Office
Office européen des brevets

(11) EP 3 209 746 B1

# (12) EUROPÄISCHE PATENTSCHRIFT

(45) Veröffentlichungstag und Bekanntmachung des Hinweises auf die Patenterteilung:
**08.05.2019 Patentblatt 2019/19**

(21) Anmeldenummer: **15778211.1**

(22) Anmeldetag: **07.10.2015**

(51) Int Cl.:
***C09K 11/06*** *(2006.01)* ***H01L 51/50*** *(2006.01)*
***H01L 51/00*** *(2006.01)* ***C09K 11/02*** *(2006.01)*

(86) Internationale Anmeldenummer:
**PCT/EP2015/001987**

(87) Internationale Veröffentlichungsnummer:
**WO 2016/062376 (28.04.2016 Gazette 2016/17)**

## (54) ORGANISCHE ELEKTROLUMINESZENZVORRICHTUNG

ORGANIC ELECTROLUMINESCENT DEVICE

DISPOSITIF ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.10.2014 EP 14003625**

(43) Veröffentlichungstag der Anmeldung:
**30.08.2017 Patentblatt 2017/35**

(73) Patentinhaber: **Merck Patent GmbH**
**64293 Darmstadt (DE)**

(72) Erfinder:
- **STOESSEL, Philipp**
**60389 Frankfurt am Main (DE)**
- **KAISER, Joachim**
**64289 Darmstadt (DE)**
- **KROEBER, Jonas Valentin**
**60311 Frankfurt am Main (DE)**
- **GROSSMANN, Tobias**
**64297 Darmstadt (DE)**

(56) Entgegenhaltungen:
**EP-A1- 1 659 129**
**WO-A1-2014/094964**
**WO-A2-2014/023377**
**DE-A1-102010 012 738**
**DE-A1-102010 019 306**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 209 746 B1

**Beschreibung**

Die vorliegende Erfindung betrifft organische Elektrolumineszenzvorrichtungen, welche Mischungen aus einem phosphoreszierenden Material und mehreren elektronentransportierenden Materialien enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei insbesondere auch metallorganische Iridiumkomplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich.

Im Stand der Technik werden verschiedene Matrixmaterialien für phosphoreszierende Emitter verwendet, unter anderem Triazinderivate, Pyrimidinderivate oder Lactamderivate. Diese können entweder als Einzelmaterial oder in Mischung mit einem weiteren Matrixmaterial als Matrix für phosphoreszierende Emitter eingesetzt werden. Häufig werden bei Verwendung einer Mischung aus zwei Matrixmaterialien bessere Ergebnisse erzielt als bei Verwendung eines einzelnen Matrixmaterials. Generell wird häufig eine Mischung aus einem Lochtransportmaterial und einem Elektronentransportmaterial als gemischte Matrix für phosphoreszierende Emitter eingesetzt (z. B. gemäß WO 02/047457, WO 2004/062324). Bei derartigen Mischungen gibt es jedoch noch weiteren Verbesserungsbedarf, insbesondere in Bezug auf die Lebensdauer. Auch Mischungen zwischen Triazin- bzw. Pyrimidinderivaten und Lactamderivaten als gemischte Matrix für phosphoreszierende Emitter sind bekannt (z. B. gemäß WO 2014/094964). Diese Mischungen zeigen bei Verwendung in organischen Elektrolumineszenzvorrichtungen sehr gute Lebensdauern, was einen erheblichen Fortschritt darstellt. Allerdings benötigen sie dafür auch eine höhere Emitterkonzentration als Mischungen mit einem loch- und einem elektronentransportierenden Matrixmaterial, überlicherweise in der Größenordnung von mehr als 12 Vol.%. Weiterhin weisen sie typischerweise eine um ca. 0.5 V höhere Betriebsspannung auf, so dass hier weitere Verbesserungen wünschenswert sind.

Bei den üblicherweise verwendeten Iridiumverbindungen handelt es sich um Komplexe, die drei bidentate, monoanionische Liganden aufweisen, von denen mindestens zwei über jeweils ein Kohlenstoffatom und ein Stickstoffatom oder über zwei Kohlenstoffatome an das Iridium binden. Verbesserungen der Iridiumverbindungen können erzielt werden, indem an den Liganden aliphatische Alkylgruppen ankondensiert werden, wie beispielsweise in WO 2014/023377 beschrieben. Auch hier sind jedoch weitere Verbesserungen wünschenswert. In WO2014094964 A1 (Beispiel E75) wird eine ähnliche organische Elektrolumineszenzvorrichtung beschrieben.

Generell gibt es bei organischen Elektrolumineszenzvorrichtungen, die phosphoreszente Emission zeigen, noch weiteren Verbesserungsbedarf, insbesondere im Hinblick auf die Kombination von hoher Effizienz, geringer Spannung und hoher Lebensdauer. So ist zwar die Optimierung einzelner dieser Eigenschaften möglich, jedoch ist es problematisch, alle diese Eigenschaften gleichzeitig zu optimieren. Dies kann mit herkömmlichen Emittern nur bei Verwendung einer hohen Emitterkonzentration erreicht werden, was im Hinblick auf die Ressourcenschonung des enthaltenen Metalls Iridium nicht wünschenswert ist, so dass hier Verbesserungen wünschenswert sind. Dasselbe gilt für die nachfolgend beschriebenen Emitter, wenn diese in einer herkömmlichen Matrix oder Matrixmischung verwendet werden, so dass auch bei Verwendung dieser Emitter noch Verbesserungen wünschenswert sind. Die der vorliegenden Erfindung zugrunde liegende technische Aufgabe ist somit die Bereitstellung von phosphoreszierenden OLEDs, die verbesserte Eigenschaften aufweisen, insbesondere in Bezug auf eine Kombination der oben genannten Eigenschaften.

Zusammenfassend lässt sich sagen, dass es die Aufgabe der vorliegenden Erfindung ist, OLEDs bereitzustellen, die gute Effizienz und niedrige Betriebsspannung bei gleichzeitig guter Lebensdauer und Verwendung einer geringen Emitterkonzentration aufweisen. Gegenüber einer OLED, die zwar einen Emitter wie nachfolgend beschrieben aufweisen, aber in einer Matrix aus einem lochtransportierenden und einem elektronentransportierenden Material, ist die Aufgabe, insbesondere die Lebensdauer der OLED zu verbessern. Dagegen ist gegenüber einer OLED, die einen Triplettemitter aufweist, der keine Gruppe der Formel (1) bis (7) wie nachfolgend beschrieben enthält, jedoch eine Mischung aus zwei elektronentransportierenden Matrixmaterialien, die Aufgabe, die Effizienz der OLED zu verbessern und gleichzeitig die dafür erforderliche Konzentration des Triplettemitters zu reduzieren.

Überraschend wurde gefunden, dass organische Elektrolumineszenzvorrichtungen, die in der emittierenden Schicht mindestens einen phosphoreszierenden Emitter, wie nachfolgend beschrieben, und mindestens zwei elektronentransportierende Matrixmaterialien aufweisen, diese Aufgabe lösen und zu Verbesserungen der organischen Elektrolumineszenzvorrichtung führen. Derartige organische Elektrolumineszenzvorrichtungen sind daher der Gegenstand der vorliegenden Erfindung.

Gegenstand der vorliegenden Erfindung ist eine organische Elektrolumineszenzvorrichtung, enthaltend Kathode, Anode und eine emittierende Schicht, die die folgenden Verbindungen enthält:

(A) mindestens eine elektronentransportierende Verbindung, die ein LUMO $\leq$ -2.4 eV aufweist; und

(B) mindestens eine weitere elektronentransportierende Verbindung, die von der ersten elektronentransportierenden Verbindung verschieden ist und ein LUMO $\leq$ -2.4 eV aufweist; und

(C) mindestens eine phosphoreszierende Iridiumverbindung, die mindestens einen mindestens bidentaten Liganden aufweist, der über ein Kohlenstoffatom und ein Stickstoffatom oder über zwei Kohlenstoffatome an das Iridium bindet und der mindestens eine Einheit gemäß einer der folgenden Formeln (1) bis (7) aufweist,

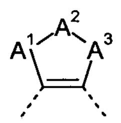
Formel (1)

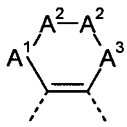
Formel (2)

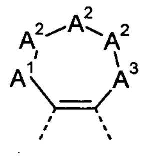
Formel (3)

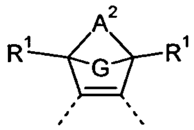
Formel (4)

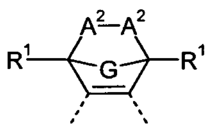
Formel (5)

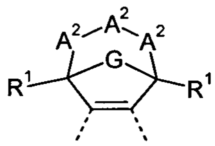
Formel (6)

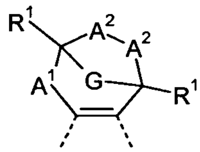
Formel (7)

wobei die beiden explizit eingezeichneten Kohlenstoffatome Atome sind, die Teil des Liganden sind, und die gestrichelten Bindungen die Verknüpfung der beiden Kohlenstoffatome im Liganden andeuten und weiterhin gilt:

$A^1$, $A^3$ ist gleich oder verschieden bei jedem Auftreten $C(R^3)_2$, O, S, $NR^3$ oder C(=O);

$A^2$ ist $C(R^1)_2$, O, S, $NR^3$ oder C(=O);

mit der Maßgabe, dass in den Gruppen der Formeln (1) bis (7) nicht zwei Heteroatome direkt aneinander gebunden sind und dass nicht zwei Gruppen C=O direkt aneinander gebunden sind;

G ist eine Alkylengruppe mit 1, 2 oder 3 C-Atomen, welche mit einem oder mehreren Resten $R^2$ substituiert sein kann, $-CR^2=CR^2-$ oder eine ortho-verknüpfte Arylen- oder Heteroarylengruppe mit 5 bis 14 aromatischen Ringatomen, welche durch einen oder mehrere Reste $R^2$ substituiert sein kann;

$R^1$ ist bei jedem Auftreten gleich oder verschieden H, D, F, Cl, Br, I, $N(R^2)_2$, CN, $Si(R^2)_3$, $B(OR^2)_2$, $C(=O)R^2$, eine geradkettige Alkyl-, Alkoxy- oder Thioalkoxygruppe mit 1 bis 20 C-Atomen oder eine geradkettige Alkenyl- oder Alkinylgruppe mit 2 bis 20 C-Atomen oder eine verzweigte oder cyclische Alkyl-, Alkenyl-, Alkinyl-, Alkoxy- oder Thioalkoxygruppe mit 3 bis 20 C-Atomen, die jeweils mit einem oder mehreren Resten $R^2$ substituiert sein kann, wobei eine oder mehrere nicht benachbarte $CH_2$-Gruppen durch $R^2C=CR^2$, $Si(R^2)_2$, C=O, $NR^2$, O, S oder $CONR^2$ ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 40 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann; dabei können zwei oder mehrere benachbarte Reste $R^1$ miteinander ein aliphatisches Ringsystem bilden;

$R^2$ ist bei jedem Auftreten gleich oder verschieden H, D, F oder ein aliphatischer, aromatischer und/oder heteroaromatischer organischer Rest mit 1 bis 20 C-Atomen, insbesondere ein Kohlenwasserstoffrest, in dem auch ein oder mehrere H-Atome durch D oder F ersetzt sein können; dabei können zwei oder mehrere Substituenten $R^2$ auch miteinander ein aliphatisches oder aromatisches Ringsystem bilden;

$R^3$ ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, die jeweils

mit einem oder mehreren Resten $R^2$ substituiert sein kann, wobei eine oder mehrere nicht benachbarte $CH_2$-Gruppen durch $R^2C=CR^2$, $Si(R^2)_2$, C=O, $NR^2$, O, S oder $CONR^2$ ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste $R^2$ substituiert sein kann, oder eine Aryloxy- oder Heteroaryloxygruppe mit 5 bis 24 aromatischen Ringatomen, die durch einen oder mehrere Reste $R^2$ substituiert sein kann, oder eine Aralkyl- oder Heteroaralkylgruppe mit 5 bis 24 aromatischen Ringatomen, die durch einen oder mehrere Reste $R^2$ substituiert sein kann; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest $R^1$ ein aliphatisches Ringsystem bilden.

Im Sinne der vorliegenden Erfindung werden alle lumineszierenden Iridiumverbindungen als phosphoreszierend bezeichnet.

Eine elektronentransportierende Verbindung im Sinne der vorliegenden Erfindung, wie sie in der emittierenden Schicht der erfindungsgemäßen organischen Elektrolumineszenzvorrichtung vorliegt, ist eine Verbindung, die ein LUMO $\leq$ -2.40 eV aufweist. Bevorzugt ist das LUMO von mindestens eine der beiden elektronentransportierenden Verbindungen $\leq$ -2.50 eV und von der anderen elektronentransportierenden Verbindung $\leq$ -2.40 eV. Besonders bevorzugt ist das LUMO von jeder der elektronentransportierenden Verbindungen $\leq$ -2.50 eV, ganz besonders bevorzugt $\leq$ -2.60 eV und insbesondere $\leq$ -2.65 eV. Dabei ist das LUMO das niedrigste unbesetzte Molekülorbital (lowest unoccupied molecular orbital). Der Wert des LUMO der Verbindungen im Sinne der vorliegenden Anmeldung wird durch quantenchemische Rechnung bestimmt, wie hinten im Beispielteil allgemein beschrieben.

Benachbarte Substituenten im Sinne der vorliegenden Anmeldung sind Substituenten, die entweder an dasselbe Kohlenstoffatom gebunden sind oder die an Kohlenstoffatome gebunden sind, welche direkt aneinander gebunden sind.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 80 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein C-, N- oder O-Atom, verbunden sein können. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine kurze Alkylgruppe verbunden sind.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 40 C-Atome enthalten kann, und in der auch einzelne H-Atome oder $CH_2$-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden

Erfindung geradkettig, verzweigt oder cyclisch sein, wobei eine oder mehrere nicht-benachbarte $CH_2$-Gruppen durch die oben genannten Gruppen ersetzt sein können; weiterhin können auch ein oder mehrere H-Atome durch D, F, Cl, Br, I, CN oder $NO_2$, bevorzugt F, Cl oder CN, weiter bevorzugt F oder CN, besonders bevorzugt CN ersetzt sein.

Unter einem aromatischen oder heteroaromatischen Ringsystem mit 5 - 30 bzw. 5 - 60 aromatischen Ringatomen, welches noch jeweils mit den oben genannten Resten R, $R^1$ oder $R^2$ substituiert sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombination dieser Systeme.

In einer bevorzugten Ausführungsform besteht die emittierende Schicht der organischen Elektrolumineszenzvorrichtung nur aus den beiden elektronentransportierenden Verbindungen und der phosphoreszierenden Iridiumverbindung und enthält keine weiteren Verbindungen.

In einer weiteren Ausführungsform der Erfindung enthält die emittierende Schicht außer den beiden elektronentransportierenden Verbindungen und der oben beschriebenen phosphoreszierenden Iridiumverbindung noch mindestens eine weitere Iridiumverbindung, die entweder kürzer- oder längerwellig als die oben beschriebene Iridiumverbindung emittiert.

In einer bevorzugten Ausführungsform der Erfindung sind die elektronentransportierenden Verbindungen in der Mischung die Matrixmaterialien, die nicht oder nicht wesentlich zur Emission der Mischung beitragen, und die phosphoreszierende Iridiumverbindung ist die emittierende Verbindung, d. h. die Verbindung, deren Emission aus der emittierenden Schicht beobachtet wird.

Damit die phosphoreszierende Iridiumverbindung die emittierende Verbindung in der Mischung der emittierenden Schicht ist, ist es bevorzugt, dass die niedrigste Triplettenergie der elektronentransportierenden Verbindungen maximal 0.1 eV niedriger ist als die Triplettenergie der phosphoreszierenden Iridiumverbindung. Insbesondere bevozugt ist $T_1$(Matrix) $\geq$ $T_1$(Emitter), wobei diese Beziehung bevorzugt für jedes der beiden Matrixmaterialien gilt.
Besonders bevorzugt gilt: $0 \leq T_1(\text{Matrix}) - T_1(\text{Emitter}) \leq 0.3$ eV;
ganz besonders bevorzugt $0 \leq T_1(\text{Matrix}) - T_1(\text{Emitter}) \leq 0.1$ eV.
Dabei steht $T_1$(Matrix) für die niedrigste Triplettenergie der elektronentransportierenden Verbindung und $T_1$(Emitter) für die niedrigste Triplettenergie der phosphoreszierenden Iridiumverbindung. Dabei werden die Triplettenergie der Matrix $T_1$(Matrix) und des Emitters $T_1$(Emitter) im Sinne der vorliegenden Anmeldung durch quantenchemische Rechnung bestimmt, wie hinten im Beispielteil allgemein beschrieben.

Im Folgenden werden Verbindungsklassen beschrieben, die sich bevorzugt als elektronentransportierende Verbindungen in der erfindungsgemäßen organischen Elektrolumineszenzvorrichtung eignen.

Geeignete elektronentransportierende Verbindungen sind ausgewählt aus den Stoffklassen der Triazine, der Pyrimidine, der Pyrazine, der Pyridazine, der Pyridine, der Lactame, der Metallkomplexe, insbesondere der Be-, Zn- bzw. Al-Komplexe, der aromatischen Ketone, der aromatischen Phosphinoxide, der Azaphosphole, der Azaborole, welche mit mindestens einem elektronentransportierenden Substituenten substituiert sind, und der Chinoxaline. Dabei ist es erfindungswesentlich, dass diese Materialien ein LUMO von $\leq$ -2.40 eV aufweisen. Viele Derivate der oben genannten Stoffklassen weisen ein solches LUMO auf, so dass diese Stoffklassen generell als geeignet gelten können, auch wenn einzelne Verbindungen dieser Stoffklassen möglicherweise ein LUMO > -2.40 eV aufweisen. Erfindungsgemäß werden jedoch nur solche Materialien eingesetzt, die ein LUMO $\leq$ -2.40 eV aufweisen. Der Fachmann kann ohne erfinderisches Zutun aus den Materialien dieser Stoffklassen, von denen eine Vielzahl an Materialien bereits bekannt sind, Verbindungen auswählen, die diese Bedingung für das LUMO erfüllen.

In einer bevorzugten Ausführungsform der Erfindung handelt es sich bei den elektronentransportierenden Verbindungen um rein organische Verbindungen, d.h. um Verbindungen, die keine Metalle enthalten.

In einer bevorzugten Ausführungsform der Erfindung ist mindestens eine der elektronentransportierenden Verbindungen eine Triazin- oder Pyrimidinverbindung, insbesondere eine Triazinverbindung. Besonders geeignete Triazin- und Pyrimidinverbindungen sind unten detailliert ausgeführt.

In einer weiteren bevorzugten Ausführungsform der Erfindung ist mindestens eine der elektronentransportierenden Verbindungen eine Lactamverbindung. Besonders geeignete Lactame sind unten detailliert ausgeführt.

In einer besonders bevorzugten Ausführungsform der Erfindung ist die eine der elektronentransportierenden Verbindungen eine Triazin- oder Pyrimidinverbindung, insbesondere eine Triazinverbindung, und die andere der elektronentransportierenden Verbindungen eine Lactamverbindung.

Wenn die elektronentransportierende Verbindung eine Triazin- oder Pyrimidinverbindung ist, dann ist diese Verbindung bevorzugt ausgewählt aus den Verbindungen der folgenden Formeln (8) bzw. (9),

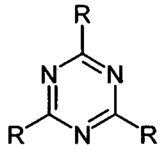
Formel (8)

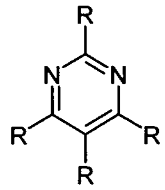
Formel (9)

wobei $R^1$ und $R^2$ die oben genannten Bedeutungen aufweisen und weiterhin gilt:

R ist bei jedem Auftreten gleich oder verschieden ausgewählt aus der Gruppe bestehend aus H, D, F, Cl, Br, I, CN, $NO_2$, $N(R^1)_2$, $C(=O)R^1$, $P(=O)R^1$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenyl- oder Alkinylgruppe mit 2 bis 20 C-Atomen, die jeweils mit einem oder mehreren Resten $R^1$ substituiert sein kann, wobei eine oder mehrere nicht-benachbarte $CH_2$-Gruppen durch $R^1C=CR^1$, C≡C, $Si(R^1)_2$, C=O, C=S, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 40 aromatischen Ringatomen, das jeweils mit einem oder mehreren Resten $R^1$ substituiert sein kann, einer Aryloxy- oder Heteroaryloxygruppe mit 5 bis 40 aromatischen Ringatomen, die mit einem oder mehreren Resten $R^1$ substituiert sein kann, oder einer Aralkyl- oder Heteroaralkylgruppe mit 5 bis 40 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann.

In einer bevorzugten Ausführungsform der Verbindungen gemäß Formel (8) bzw. Formel (9) steht mindestens einer der Substituenten R für ein aromatisches oder heteroaromatisches Ringsystem, das jeweils durch einen oder mehrere Reste $R^1$ substituiert sein kann. In Formel (1) stehen besonders bevorzugt alle drei Substituenten R für ein aromatisches oder heteroaromatisches Ringsystem, das jeweils durch einen oder mehrere Reste $R^1$ substituiert sein kann. In Formel (2) stehen besonders bevorzugt zwei oder drei Substituenten R für ein aromatisches oder heteroaromatisches Ringsystem, das jeweils durch einen oder mehrere Reste $R^1$ substituiert sein kann, und die anderen Substituenten R stehen für H. Besonders bevorzugte Ausführungsformen sind somit die Verbindungen der folgenden Formeln (8a) bzw. (9a) bis (9d),

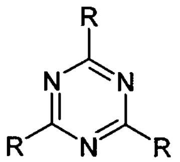
Formel (8a)

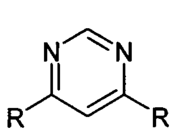
Formel (9a)

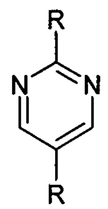
Formel (9b)

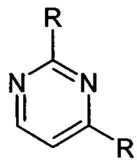
Formel (9c)

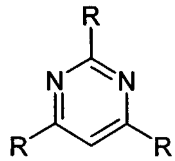
Formel (9d)

wobei R gleich oder verschieden für ein aromatisches oder heteroaromatisches Ringsystem mit 5 bis 40 aromatischen Ringatomen steht, das jeweils mit einem oder mehreren Resten $R^1$ substituiert sein kann, und $R^1$ die oben genannte Bedeutung aufweist.

Dabei sind bei den Pyrimidin-Verbindungen die Verbindungen der Formeln (9a) und (9d) bevorzugt, insbesondere Verbindungen der Formel (9d).

Bevorzugte aromatische oder heteroaromatische Ringsysteme R in Formel (8) und (9) enthalten 5 bis 30

aromatische Ringatome, insbesondere 6 bis 24 aromatische Ringatome, und können durch einen oder mehrere Reste $R^1$ substituiert sein. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. So ist es bevorzugt, wenn R beispielsweise keine Naphthylgruppen oder höhere kondensierte Arylgruppen aufweist und ebenso keine Chinolingruppen, Acridingruppen, etc.. Dagegen ist es möglich, dass R beispielsweise Carbazolgruppen, Dibenzofurangruppen, etc. aufweist, weil in diesen Strukturen keine 6-Ring-Aromaten bzw. -Heteroaromaten direkt aneinander ankondensiert sind. Weitere geeignete Substituenten sind Phenanthren und Triphenylen.

Bevorzugte Substituenten R in Formel (8) und (9) sind gleich oder verschieden bei jedem Auftreten ausgewählt aus der Gruppe bestehend aus Benzol, Biphenyl, insbesondere ortho-, meta- oder para-Biphenyl, Terphenyl, insbesondere ortho-, meta-, para- oder verzweigtem Terphenyl, Quaterphenyl, insbesondere ortho-, meta-, para- oder verzweigtem Quaterphenyl, Fluorenyl, insbesondere 1-, 2-, 3- oder 4-Fluorenyl, Spirobifluorenyl, insbesondere 1-, 2-, 3- oder 4-Spirobifluorenyl, Naphthyl, insbesondere 1- oder 2-Naphthyl, Pyrrol, Furan, Thiophen, Indol, Benzofuran, Benzothiophen, Carbazol, insbesondere 1-, 2-, 3- oder 4-Carbazol, Dibenzofuran, insbesondere 1-, 2-, 3- oder 4-Dibenzofuran, Dibenzothiophen, insbesondere 1-, 2-, 3- oder 4-Dibenzothiophen, Indenocarbazol, Indolocarbazol, Pyridin, insbesondere 2-, 3- oder 4-Pyridin, Pyrimidin, insbesondere 2-, 4- oder 5-Pyrimidin, Pyrazin, Pyridazin, Triazin, Phenanthren, Triphenylen oder Kombinationen aus zwei oder drei dieser Gruppen, welche jeweils mit einem oder mehreren Resten $R^1$ substituiert sein können. Dabei bedeutet "Kombination aus zwei oder drei dieser Gruppen", dass zwei oder drei der zuvor genannten Gruppen direkt aneinander gebunden sind.

Insbesondere bevorzugt ist es, wenn mindestens eine Gruppe R ausgewählt ist aus den Strukturen der folgenden Formeln (10) bis (52),

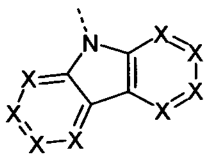

Formel (10)

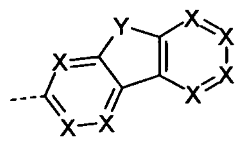

Formel (11)

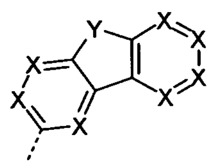

Formel (12)

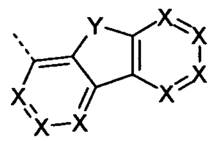

Formel (13)

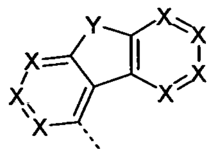

Formel (14)

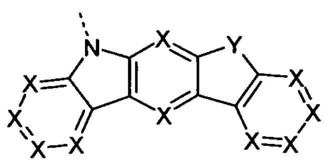

Formel (15)

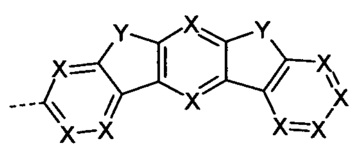

Formel (16)

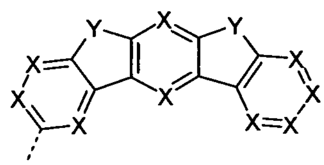

Formel (17)

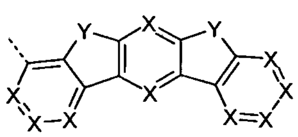

Formel (18)

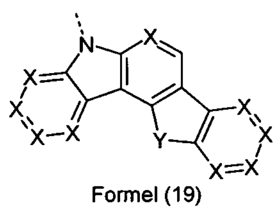

Formel (19)

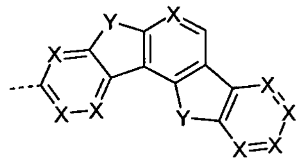

Formel (20)

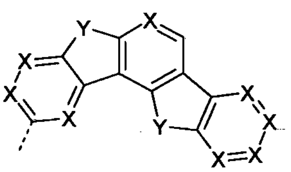
Formel (21)

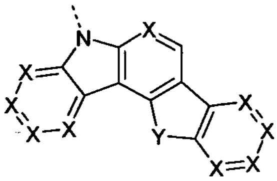
Formel (22)

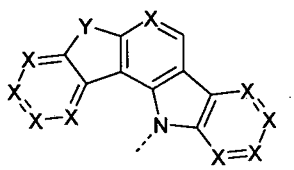
Formel (23)

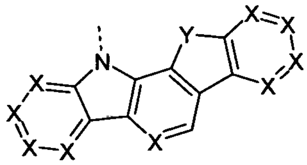
Formel (24)

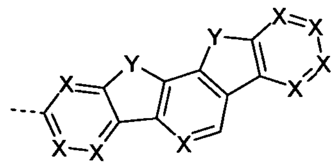
Formel (25)

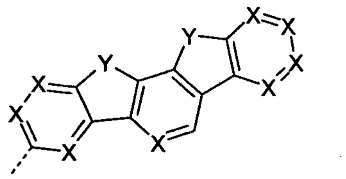
Formel (26)

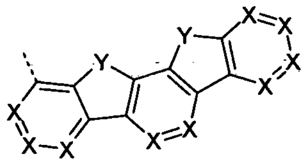
Formel (27)

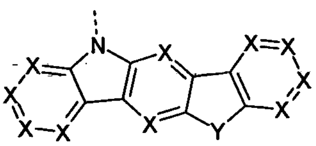
Formel (28)

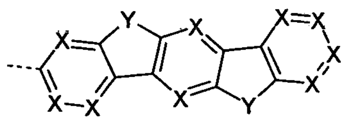
Formel (29)

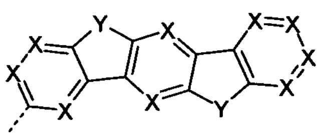
Formel (30)

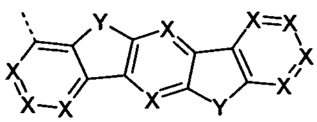
Formel (31)

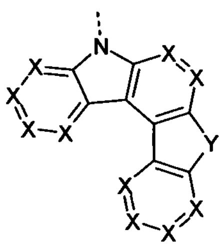
Formel (32)

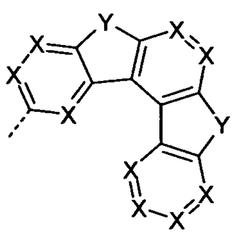
Formel (33)

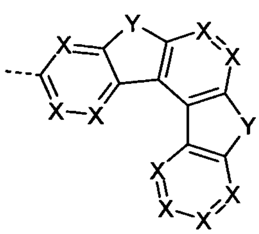
Formel (34)

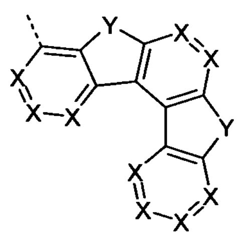
Formel (35)

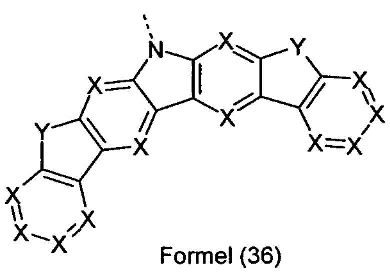
Formel (36)

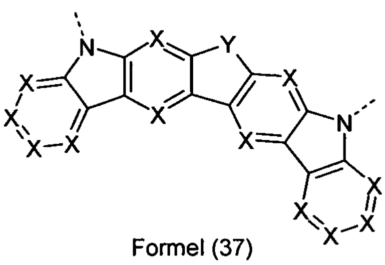
Formel (37)

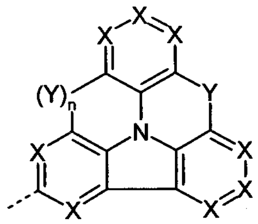

Formel (38)

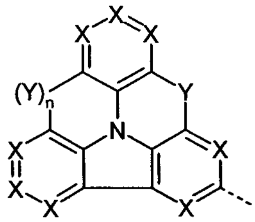

Formel (39)

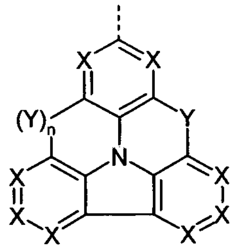

Formel (40)

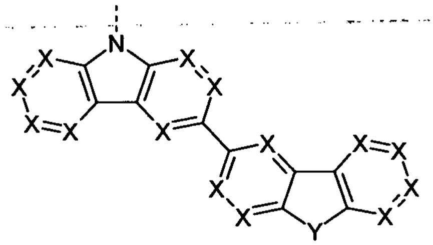

Formel (41)

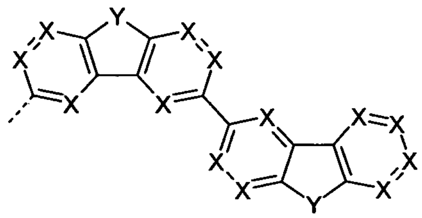

Formel (42)

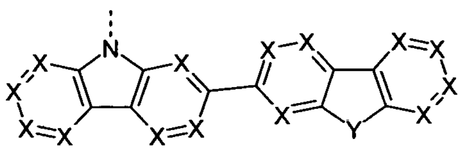

Formel (43)

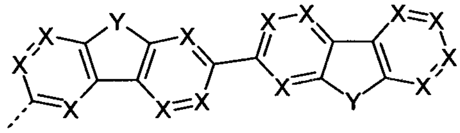

Formel (44)

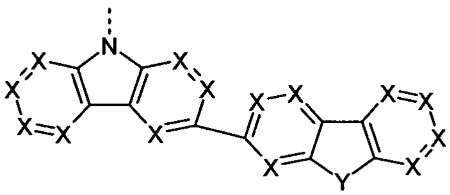

Formel (45)

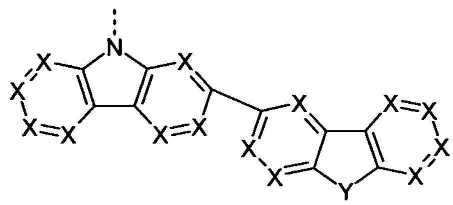

Formel (46)

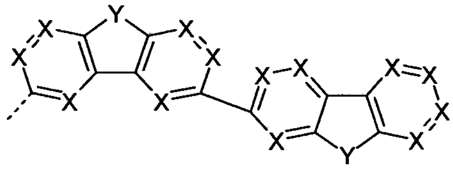

Formel (47)

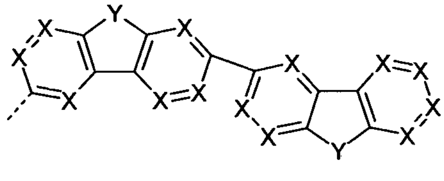

Formel (48)

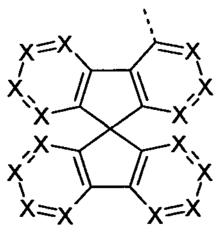

Formel (49)

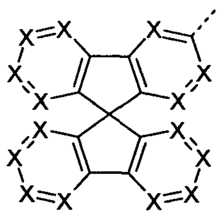

Formel (50)

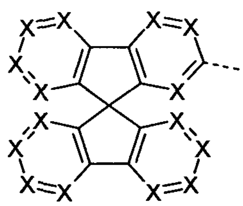

Formel (51)

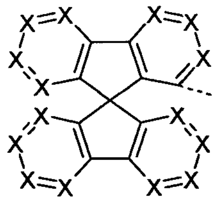

Formel (52)

wobei $R^1$ und $R^2$ die oben genannten Bedeutungen aufweisen, die gestrichelte Bindung die Bindung an die Gruppe der Formel (8) bzw. (9) darstellt und weiterhin gilt:

X ist bei jedem Auftreten gleich oder verschieden $CR^1$ oder N, wobei bevorzugt maximal 2 Symbole X pro Cyclus für N stehen;

Y ist bei jedem Auftreten gleich oder verschieden $C(R^1)_2$, $NR^1$, O oder S;

n ist 0 oder 1, wobei n gleich 0 bedeutet, dass an dieser Position keine Gruppe Y gebunden ist und an den entsprechenden Kohlenstoffatomen statt dessen Reste $R^1$ gebunden sind.

Der Begriff "Cyclus", wie er in der Definition von X und im Folgenden verwendet wird, bezieht sich auf jeden einzelnen 5- oder 6-Ring innerhalb der Struktur.

In bevorzugten Gruppen der oben genannten Formeln (10) bis (52) steht maximal ein Symbol X pro Cyclus für N. Besonders bevorzugt steht das Symbol X gleich oder verschieden bei jedem Auftreten für $CR^1$, insbesondere für CH.

Wenn die Gruppen der Formeln (10) bis (52) mehrere Gruppen Y aufweisen, so kommen hierfür alle Kombinationen aus der Definition von Y in Frage. Bevorzugt ist in Gruppen der Formeln (11) bis (14) bzw. (41) bis (48), wenn Y gleich oder verschieden bei jedem Auftreten für $NR^1$, O oder S steht. Bevorzugt ist weiterhin in Gruppen der Formeln (15) bis (37), wenn Y gleich oder verschieden bei jedem Auftreten für $NR^1$, $C(R^1)_2$ oder O steht. Wenn die Gruppen der Formeln (15) bis (37) zwei Gruppen Y aufweisen, so ist es besonders bevorzugt, wenn eine Gruppe Y für $NR^1$ und die andere für $C(R^1)_2$ steht oder wenn beide Gruppen Y für O stehen oder wenn beide Gruppen Y für $NR^1$ stehen. Wenn die Gruppen der Formeln (38) bis (40) zwei Gruppen Y aufweisen, so ist es bevorzugt, wenn diese gleich oder verschieden für $C(R^1)_2$ oder $NR^1$ stehen, besonders bevorzugt für $C(R^1)_2$.

Wenn Y für $NR^1$ steht, steht der Substituent $R^1$, der direkt an ein Stickstoffatom gebunden ist, bevorzugt für ein aromatisches oder heteroaromatisches Ringsystem mit 5 bis 24 aromatischen Ringatomen, welches auch durch einen oder mehrere Reste $R^2$ substituiert sein kann. In einer besonders bevorzugten Ausführungsform steht dieser Substituent $R^1$ gleich oder verschieden bei jedem Auftreten für ein aromatisches oder heteroaromatisches Ringsystem mit 6 bis 24, bevorzugt 6 bis 18, besonders bevorzugt 6 bis 12 aromatischen Ringatomen, welches keine kondensierten Arylgruppen aufweist und welches keine kondensierten Heteroarylgruppen, in welchen zwei oder mehr aromatische bzw. heteroaromatische 6-RingGruppen direkt aneinander ankondensiert sind, aufweist und welches jeweils auch durch einen oder mehrere Reste $R^2$ substituiert sein kann.

Wenn Y für $C(R^1)_2$ steht, steht $R^1$ bevorzugt gleich oder verschieden bei jedem Auftreten für eine lineare Alkylgruppe mit 1 bis 10 C-Atomen, bevorzugt mit 1 bis 4 C-Atomen, oder für eine verzweigte oder cyclische Alkylgruppe mit 3 bis 10 C-Atomen, bevorzugt mit 3 bis 4 C-Atomen, oder für ein aromatisches oder heteroaromatisches Ringsystem mit 6 bis 24, bevorzugt 6 bis 12 aromatischen Ringatomen, welches auch durch einen oder mehrere Reste $R^2$ substituiert sein kann. Ganz besonders bevorzugt steht $R^1$ für eine Methylgruppe oder für eine Phenylgruppe, welche auch durch einen oder mehrere Reste $R^2$ substituiert sein kann, wobei durch Ringbildung der beiden Phenylgruppen auch ein Spirosystem gebildet werden kann.

Weiterhin kann es bevorzugt sein, wenn die Gruppe der oben genannten Formeln (10) bis (52) nicht direkt an das Triazin in Formel (8) bzw. das Pyrimidin in Formel (9) binden, sondern über eine verbrückende Gruppe. Diese verbrückende Gruppe ist dann bevorzugt ausgewählt aus einem aromatischen oder heteroaromatischen Ringsystem mit 5 bis 24 aromatischen Ringatomen, insbesondere mit 6 bis 12 aromatischen Ringatomen, welches jeweils mit einem oder mehreren Resten $R^1$ substituiert sein kann. Dabei enthält das aromatische bzw. heteroaromatische Ringsystem bevorzugt keine Aryl- oder Heteroarylgruppen, in denen mehr als zwei aromatische Sechsringe aneinander ankondensiert sind. Besonders bevorzugt enthält das aromatische bzw. heteroaromatische Ringsystem keine Aryl- oder Heteroarylgruppen, in denen aromatische Sechsringe aneinander ankondensiert sind. Bevorzugte derartige verbrückende Gruppen sind ausgewählt aus Phenylen, insbesondere ortho-, meta- oder para-Phenylen, oder Biphenyl, welches jeweils

durch einen oder mehrere Reste $R^1$ substituiert sein kann, wobei unsubstituiertes meta-Phenylen besonders bevorzugt ist.

Beispiele für bevorzugte Verbindungen gemäß Formel (8) bzw. (9) sind die in der folgenden Tabelle aufgeführten Verbindungen.

| | | |
|---|---|---|
| 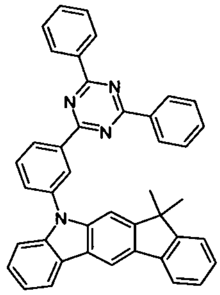 | 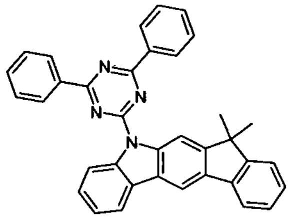 | 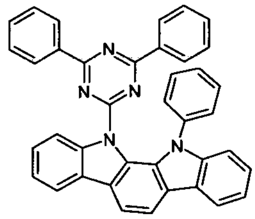 |
| 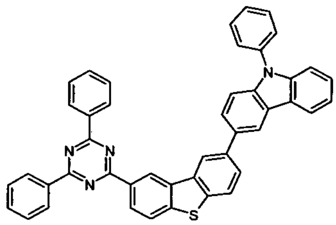 | 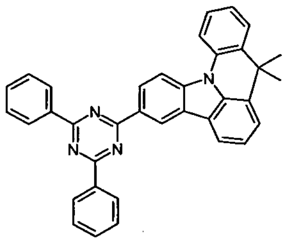 | 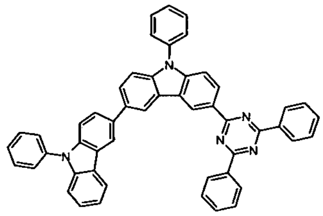 |
| 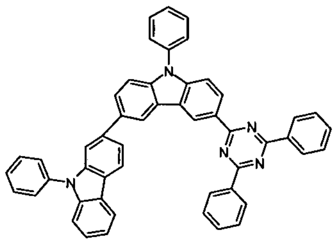 | 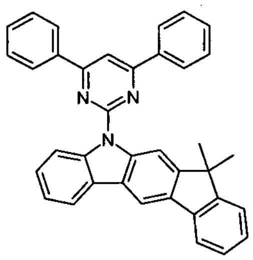 | 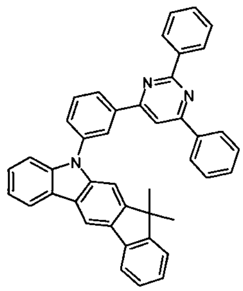 |

| | | |
|---|---|---|
| 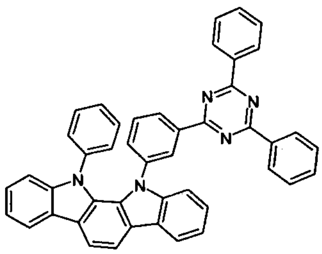 | 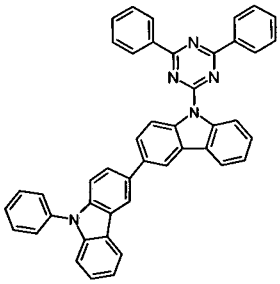 | 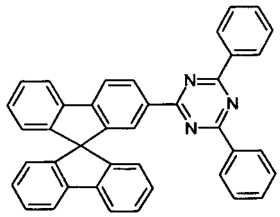 |
| 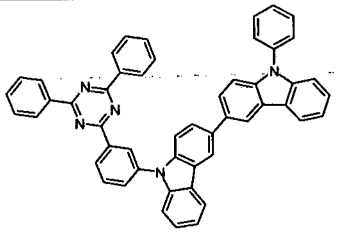 | 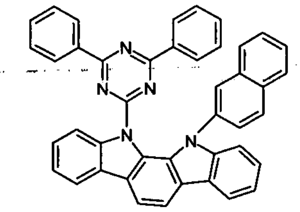 | 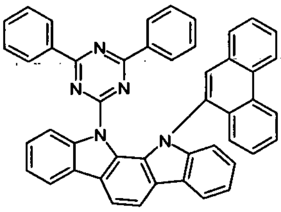 |
| 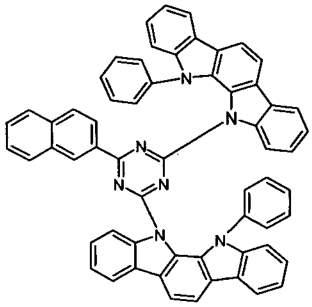 | 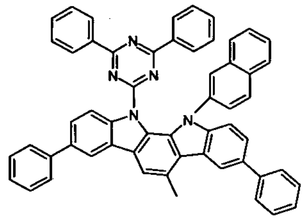 | 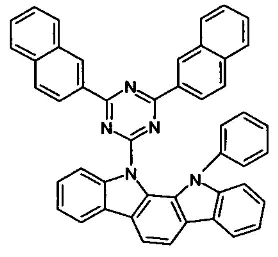 |
| 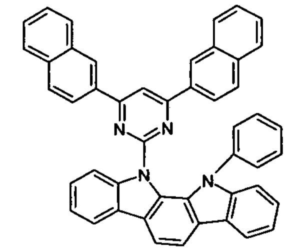 | 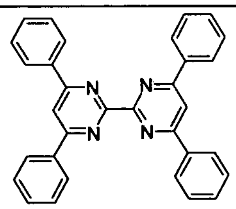 | 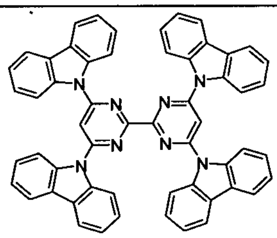 |
| 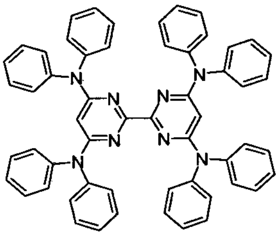 | 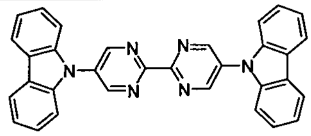 | 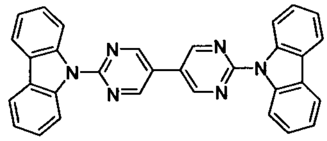 |
| 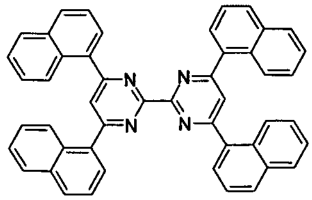 | 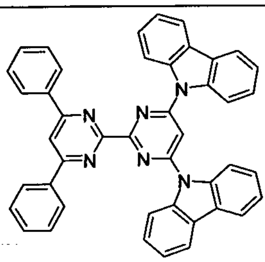 | 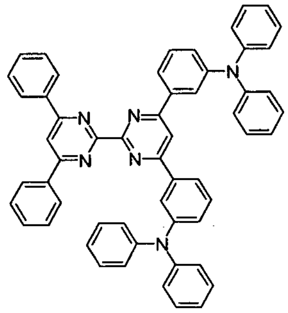 |

| | | |
|---|---|---|
| 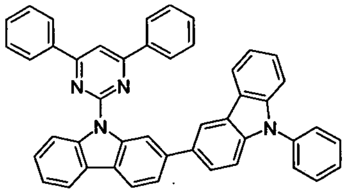 | 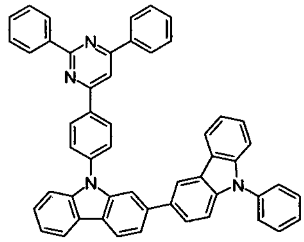 | 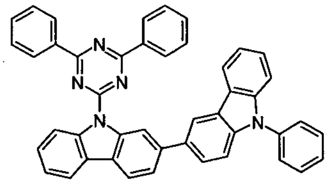 |
| 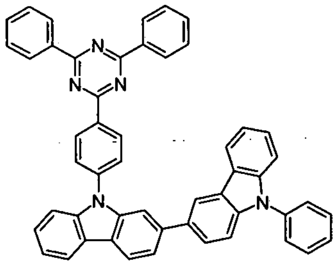 | 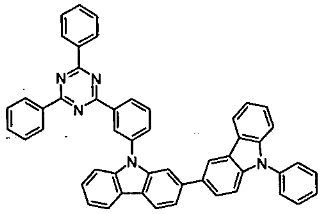 | 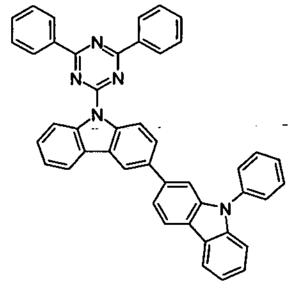 |
| 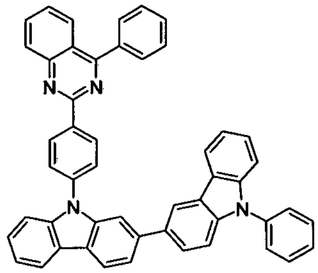 | 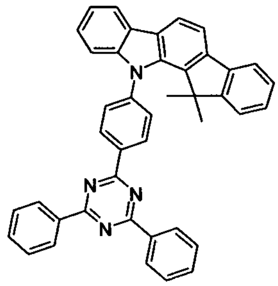 | 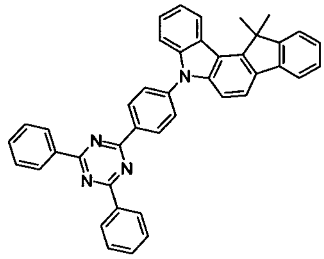 |
| 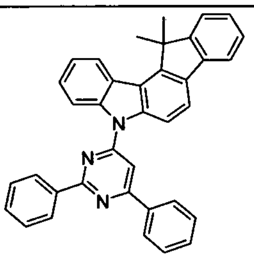 | 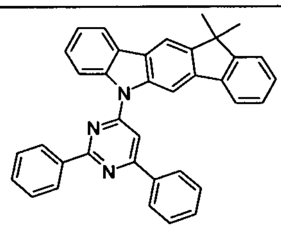 | 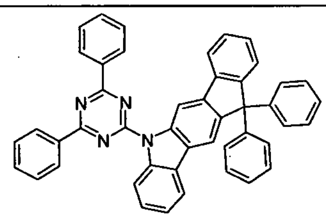 |
| 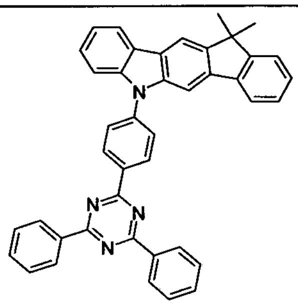 | 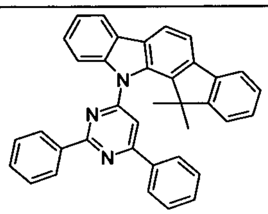 | 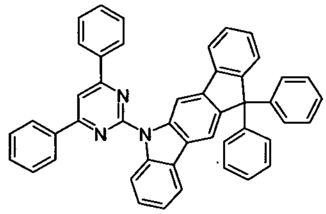 |
| 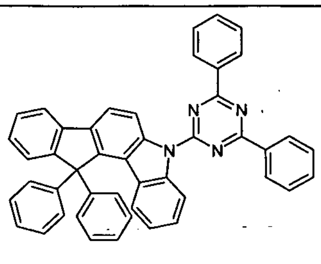 | 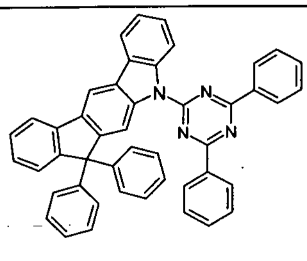 | 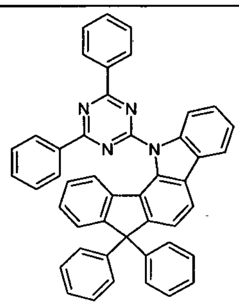 |

| | | |
|---|---|---|
| 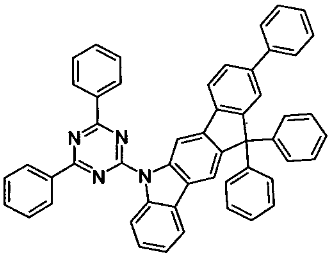 | 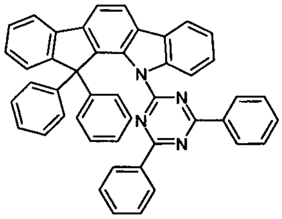 | 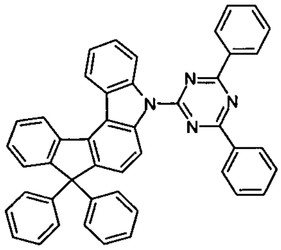 |
| 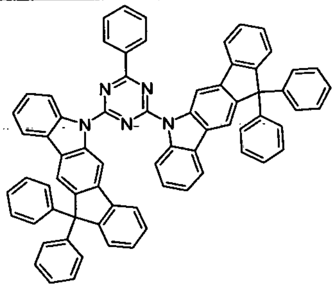 | 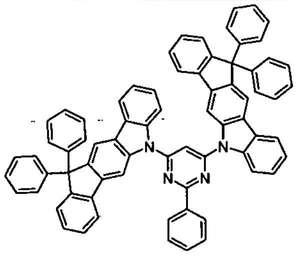 | 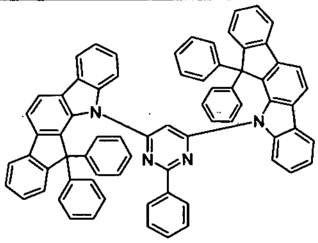 |
| 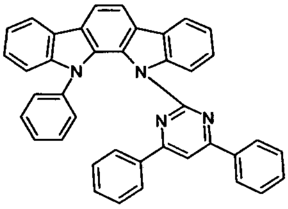 | 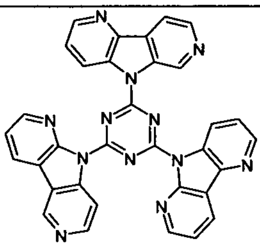 | 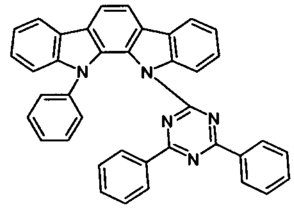 |
| 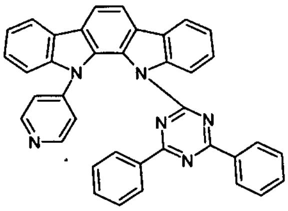 | 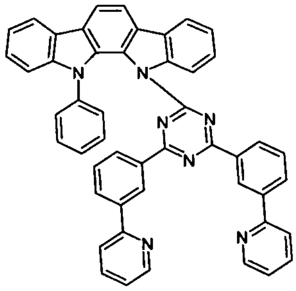 | 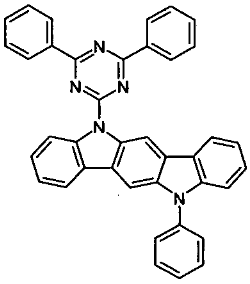 |
| 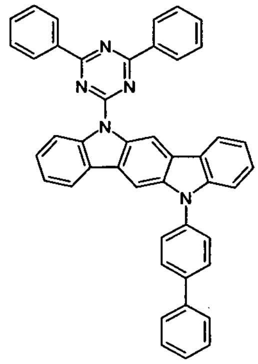 | 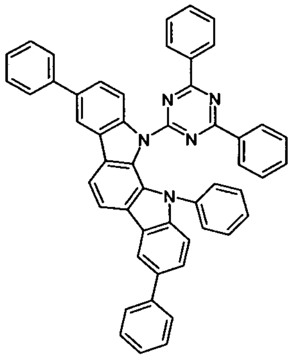 | 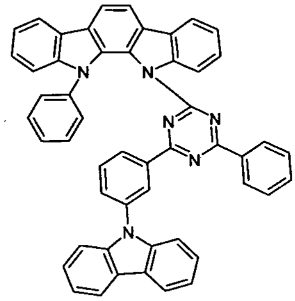 |
| 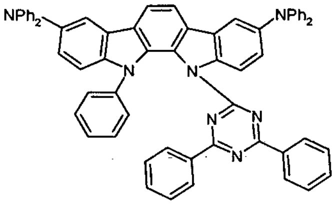 | 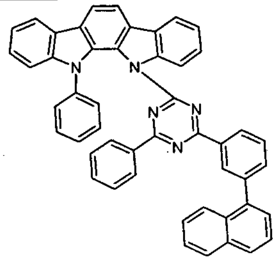 | 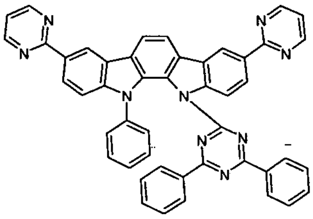 |

| | | |
|---|---|---|
| 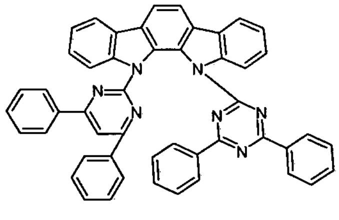 | 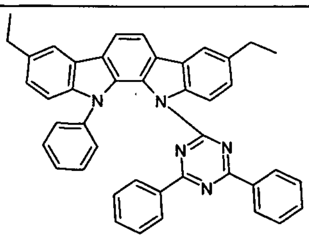 | 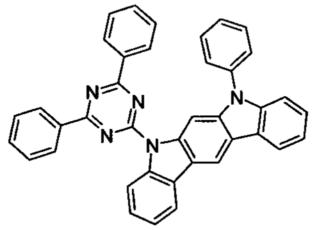 |
| 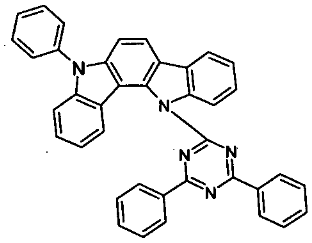 | 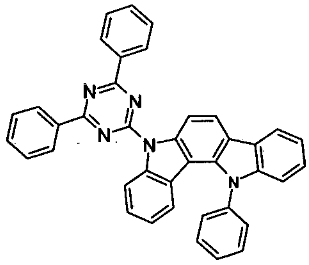 | 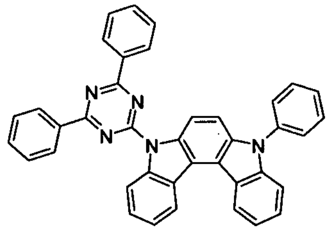 |
| 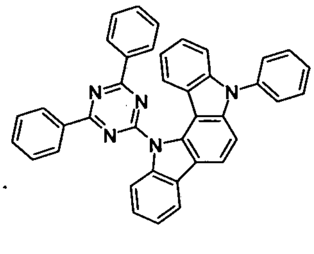 | 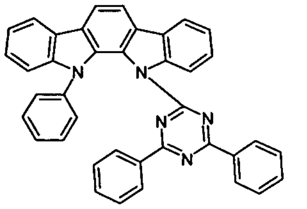 | 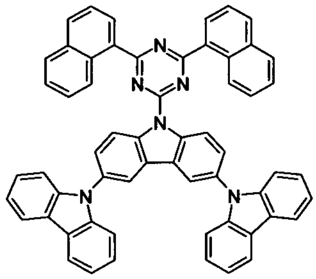 |
| 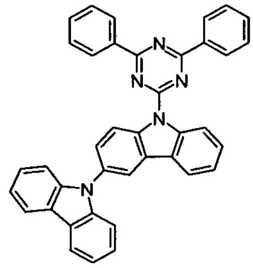 | 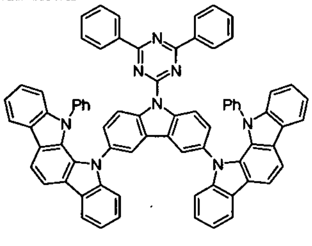 | 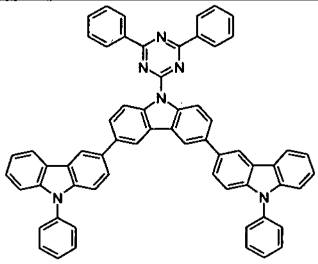 |
| 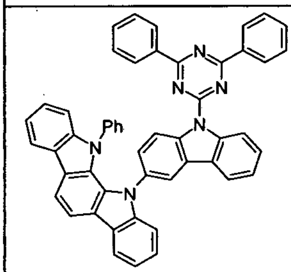 | 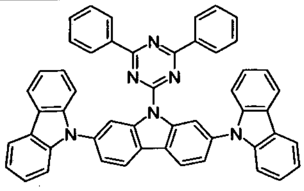 | 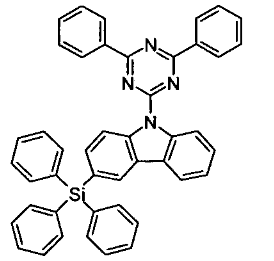 |
| 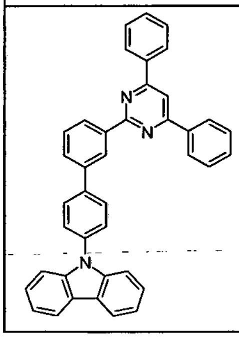 | 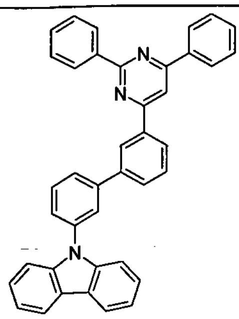 | 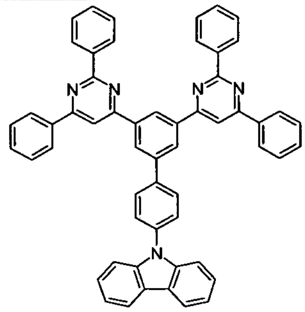 |

| | | |
|---|---|---|
| 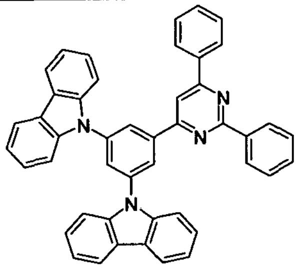 | 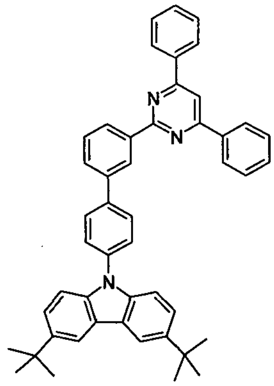 | 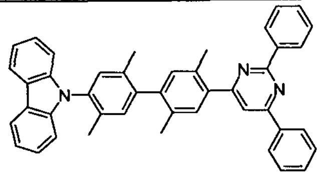 |
| 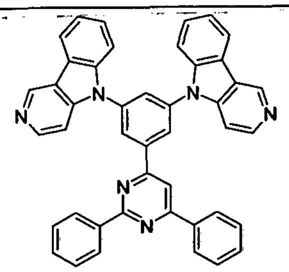 | 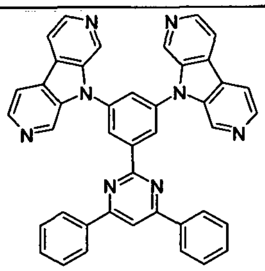 | 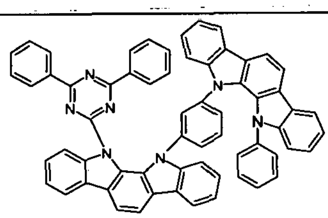 |
| 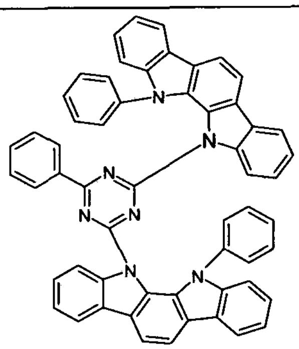 | 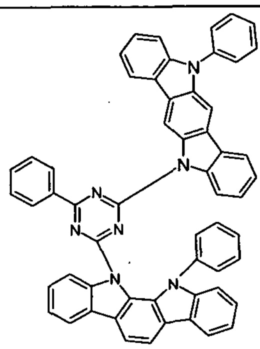 | 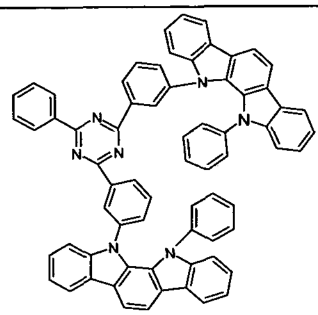 |
| 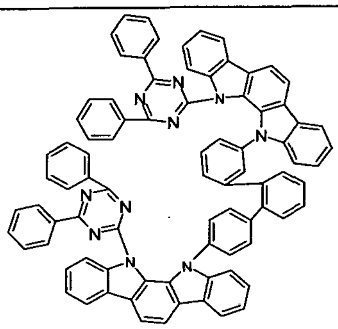 | 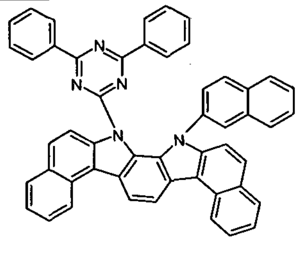 | 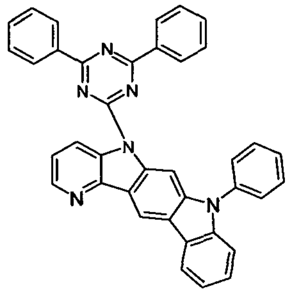 |
| 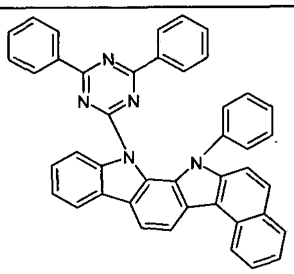 | 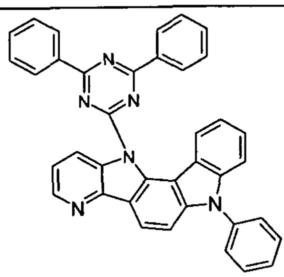 | 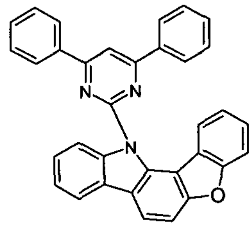 |

| | | |
|---|---|---|
| 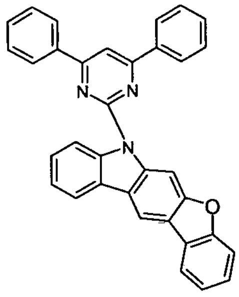 | 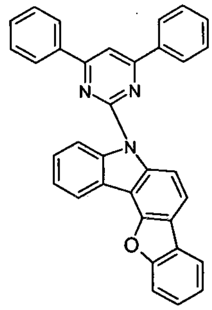 | 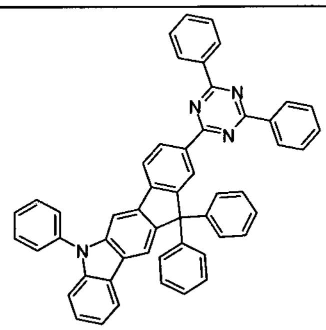 |
| 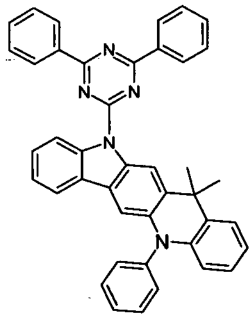 | 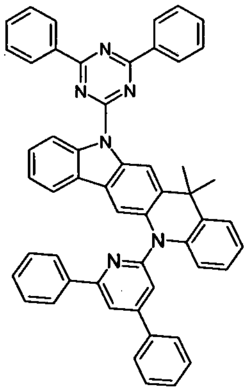 | 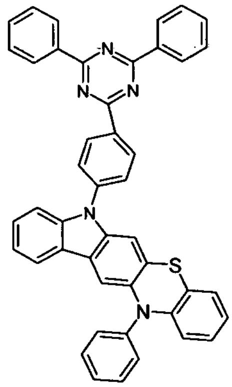 |
| 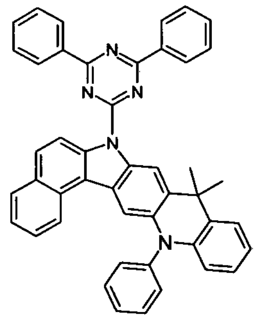 | 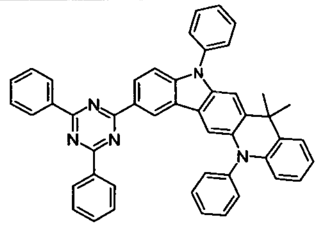 | 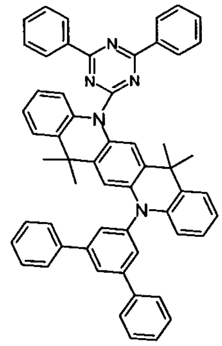 |
| 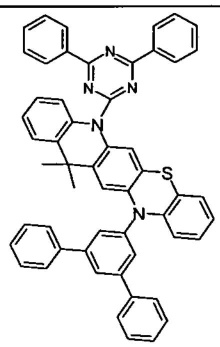 | 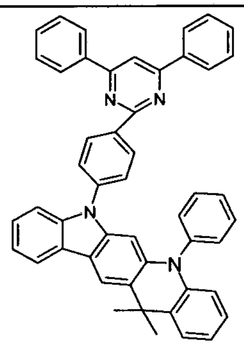 | 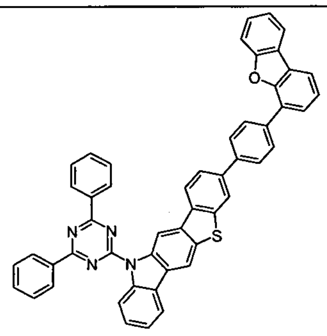 |
| 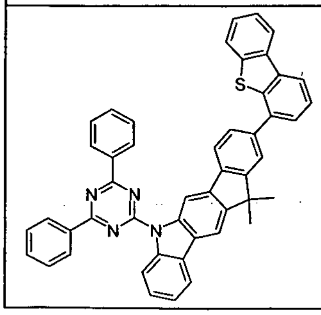 | 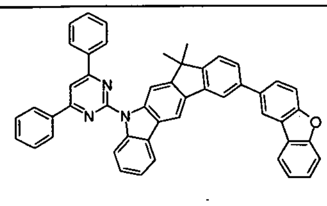 | 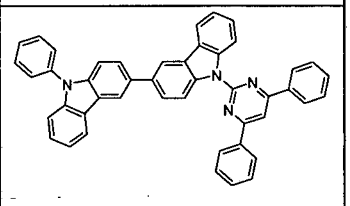 |

| | | |
|---|---|---|
| 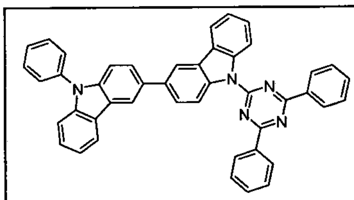 | 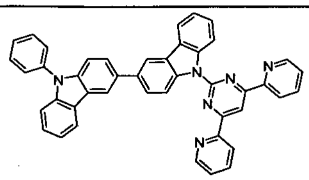 | 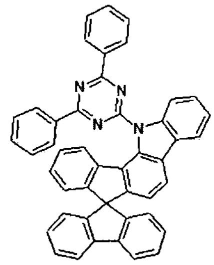 |
| 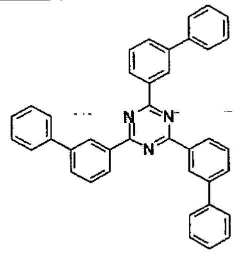 | | |

| | |
|---|---|
| 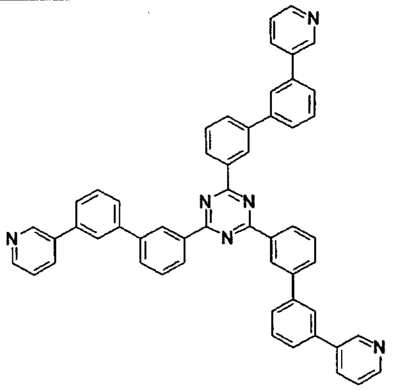 | 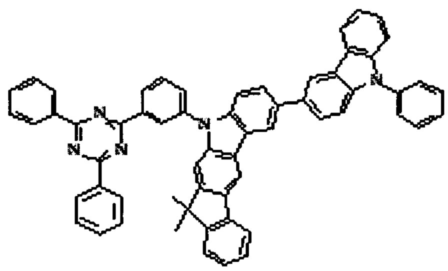 |
| 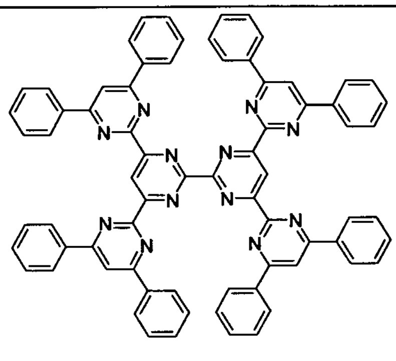 | 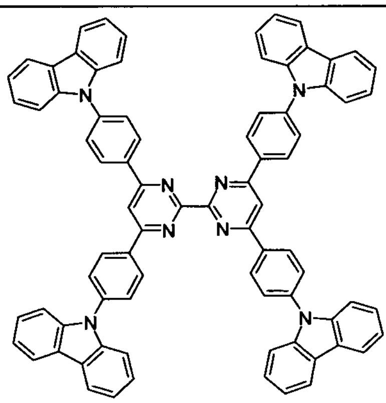 |
| 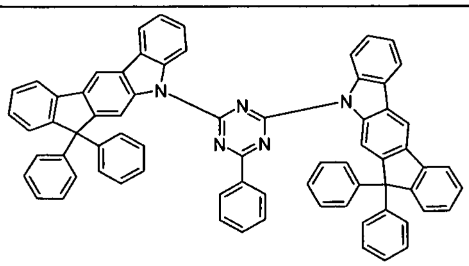 | 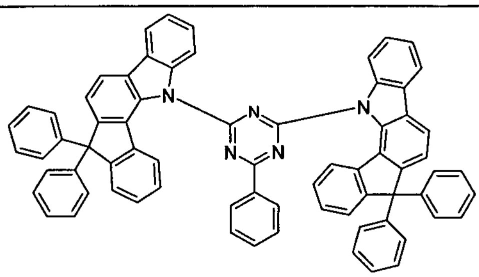 |

| | |
|---|---|
| 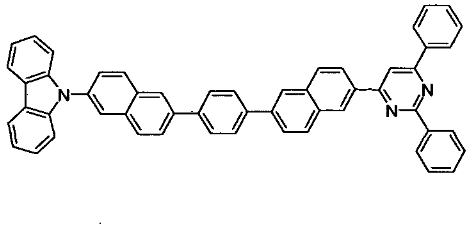 | 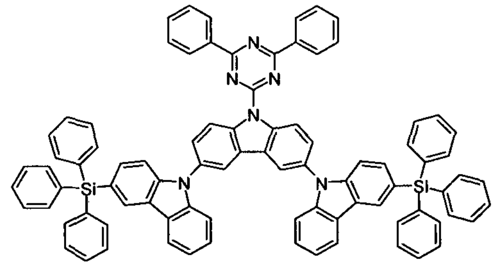 |
| 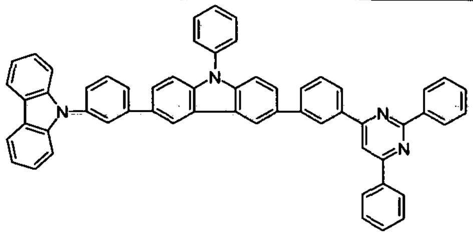 | 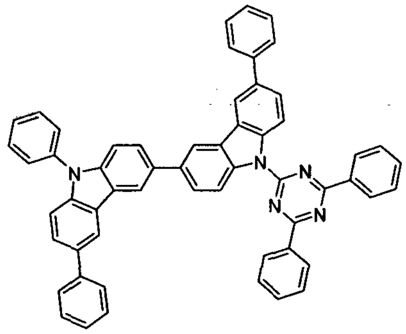 |
| 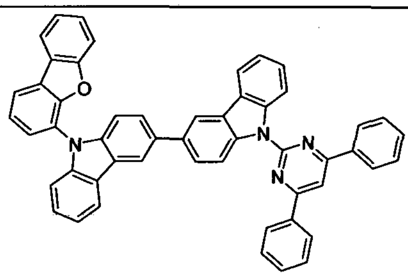 | 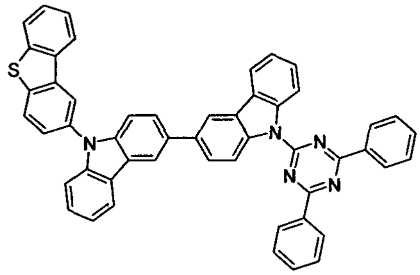 |
| 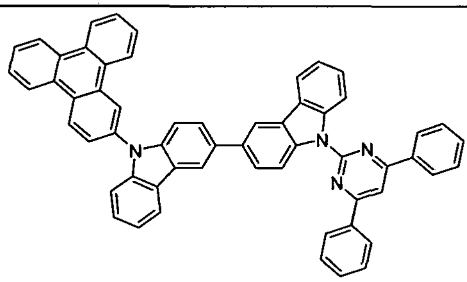 | 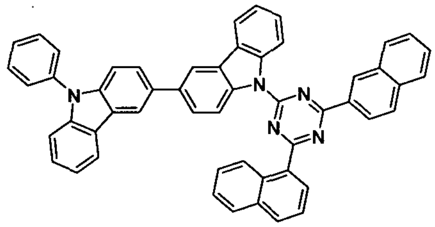 |

Wenn die elektronentransportierende Verbindung ein Lactam ist, dann ist diese Verbindung bevorzugt ausgewählt aus den Verbindungen der folgenden Formeln (53) bzw. (54),

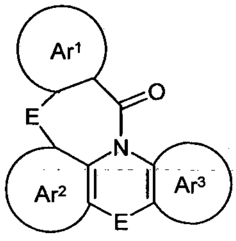

Formel (53)

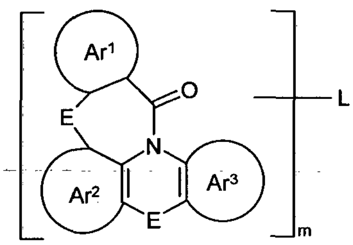

Formel (54)

wobei R, $R^1$ und $R^2$ die oben genannten Bedeutungen aufweisen und für die weiteren verwendeten Symbole und Indizes gilt:

E ist gleich oder verschieden bei jedem Auftreten eine Einfachbindung, NR, $CR_2$, O oder S;

$Ar^1$ ist zusammen mit den explizit dargestellten Kohlenstoffatomen ein aromatisches oder heteroaromatisches Ringsystem mit 5 bis 18 aromatischen Ringatomen, welches durch einen oder mehrere Reste R substituiert sein kann;

$Ar^2$, $Ar^3$ ist gleich oder verschieden bei jedem Auftreten zusammen mit den explizit dargestellten Kohlenstoffatomen ein aromatisches oder heteroaromatisches Ringsystem mit 5 bis 18 aromatischen Ringatomen, welches durch einen oder mehrere Reste R substituiert sein kann;

L ist für m = 2 eine Einfachbindung oder eine bivalente Gruppe, bzw. für m = 3 eine trivalente Gruppe bzw. für m = 4 eine tetravalente Gruppe, welche jeweils an eine beliebige Position an $Ar^1$, $Ar^2$ oder $Ar^3$ oder statt einem Rest R an E gebunden ist;

m ist 2, 3 oder 4.

In einer bevorzugten Ausführungsform der Erfindung sind $Ar^1$, $Ar^2$ und $Ar^3$ gleich oder verschieden bei jedem Auftreten zusammen mit den explizit dargestellten Kohlenstoffatomen Aryl- oder Heteroarylgruppen mit 5 bis 10 aromatischen Ringatomen, insbesondere mit 5 oder 6 aromatischen Ringatomen, welche durch einen oder mehrere Reste R substituiert sein können.

In einer bevorzugten Ausführungsform der Verbindung gemäß Formel (53) bzw. (54) steht die Gruppe $Ar^1$ für eine Gruppe der folgenden Formel (55), (56), (57) oder (58),

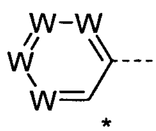
Formel (55)

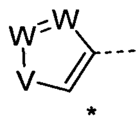
Formel (56)

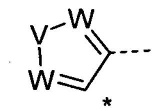
Formel (57)

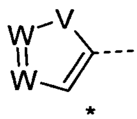
Formel (58)

wobei die gestrichelte Bindung die Verknüpfung mit der Carbonylgruppe andeutet, * die Position der Verknüpfung mit E andeutet und weiterhin gilt:

W ist gleich oder verschieden bei jedem Auftreten CR oder N; oder zwei benachbarte Gruppen W stehen für eine Gruppe der folgenden Formel (59) oder (60),

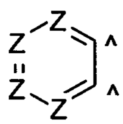
Formel (59)

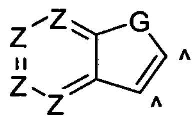
Formel (60)

wobei G für $CR_2$, NR, O oder S steht, Z gleich oder verschieden bei jedem Auftreten für CR oder N steht und ^ die entsprechenden benachbarten Gruppen W in der Formel (55) bis (58) andeuten;

V ist NR, O oder S.

In einer weiteren bevorzugten Ausführungsform der Erfindung steht die Gruppe $Ar^2$ für eine Gruppe gemäß einer der folgenden Formeln (61), (62) oder (63),

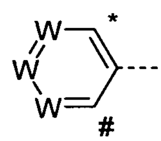
Formel (61)

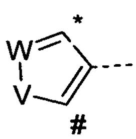
Formel (62)

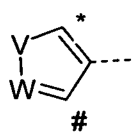
Formel (63)

wobei die gestrichelte Bindung die Verknüpfung mit N andeutet, # die Position der Verknüpfung mit E und $Ar^3$ andeutet, * die Verknüpfung mit E und $Ar^1$ andeutet und W und V die oben genannten Bedeutungen aufweisen.

In einer weiteren bevorzugten Ausführungsform der Erfindung steht die Gruppe $Ar^3$ für eine Gruppe gemäß einer der folgenden Formeln (64), (65), (66) oder (67),

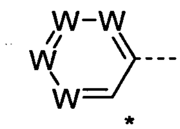
Formel (64)

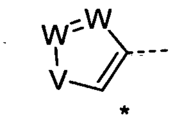
Formel (65)

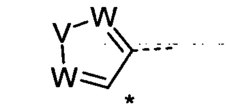
Formel (66)

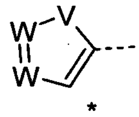
Formel (67)

wobei die gestrichelte Bindung die Verknüpfung mit N andeutet, * die Verknüpfung mit E andeutet und W und V die oben genannten Bedeutungen aufweisen.

Dabei können die oben genannten bevorzugten Gruppen $Ar^1$, $Ar^2$ und $Ar^3$ beliebig miteinander kombiniert werden.

In einer weiteren bevorzugten Ausführungsform der Erfindung steht mindestens eine Gruppe E für eine Einfachbindung. Besonders bevorzugt stehen alle Gruppen E für Einfachbindungen.

In einer bevorzugten Ausführungsform der Erfindung treten die oben genannten Bevorzugungen gleichzeitig auf. Besonders bevorzugt sind daher Verbindungen gemäß Formel (53) bzw. (54), für die gilt:

$Ar^1$ ist ausgewählt aus den Gruppen der oben genannten Formeln (55), (56), (57) oder (58);
$Ar^2$ ist ausgewählt aus den Gruppen der oben genannten Formeln (61), (62) oder (63);
$Ar^3$ ist ausgewählt aus den Gruppen der oben genannten Formeln (64), (65), (66) oder (67).

Besonders bevorzugt stehen mindestens zwei der Gruppen $Ar^1$, $Ar^2$ und $Ar^3$ für eine 6-Ring-Aryl- oder eine 6-Ring-Heteroarylgruppe. Besonders bevorzugt steht $Ar^1$ für eine Gruppe der Formel (55) und gleichzeitig steht $Ar^2$ für eine Gruppe der Formel (61), oder $Ar^1$ steht für eine Gruppe der Formel (55) und gleichzeitig steht $Ar^3$ für eine Gruppe der Formel (64), oder $Ar^2$ steht für eine Gruppe der Formel (61) und gleichzeitig steht $Ar^3$ für eine Gruppe der Formel (64).

Besonders bevorzugte Ausführungsformen der Formel (53) sind daher die Verbindungen der folgenden Formeln (65) bis (74),

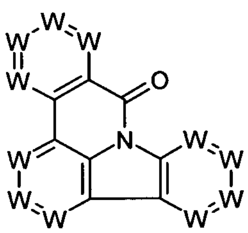
Formel (65)

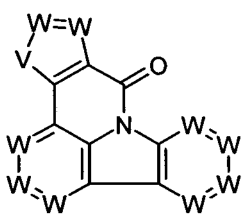
Formel (66)

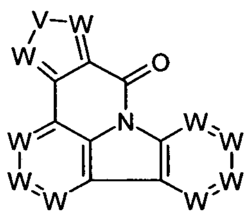
Formel (67)

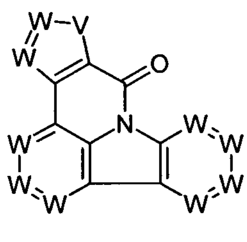
Formel (68)

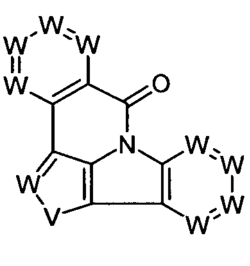
Formel (69)

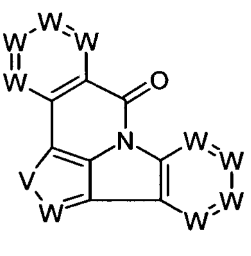
Formel (70)

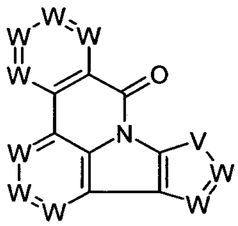
Formel (71)

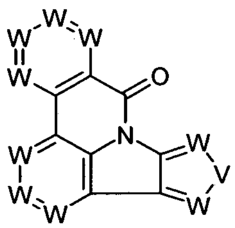
Formel (72)

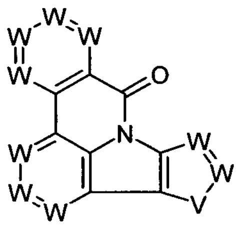
Formel (73)

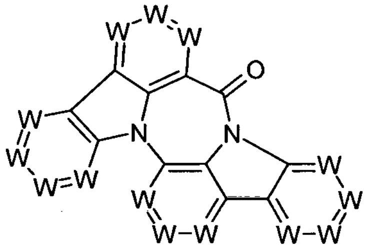
Formel (74)

wobei die verwendeten Symbole die oben genannten Bedeutungen aufweisen.

Es ist weiterhin bevorzugt, wenn W für CR oder N steht und nicht für eine Gruppe der Formel (59) oder (60). In einer bevorzugten Ausführungsform der Verbindungen gemäß Formel (65) bis (74) steht pro Cyclus insgesamt maximal ein Symbol W für N, und die verbleibenden Symbole W stehen für CR. In einer besonders bevorzugten Ausführungsform der Erfindung stehen alle Symbole W für CR. Besonders bevorzugt sind daher die Verbindungen gemäß den folgenden Formeln (65a) bis (74a),

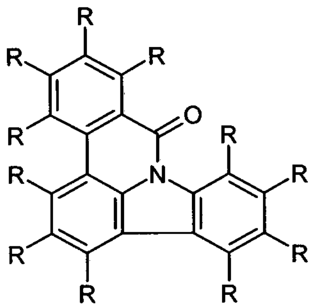
Formel (65a)

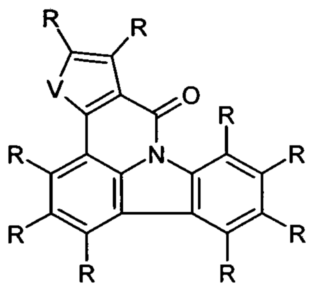
Formel (66a)

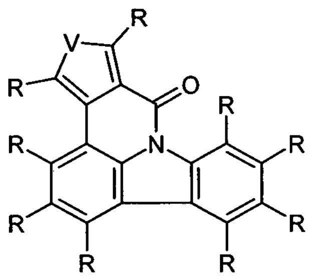
Formel (67a)

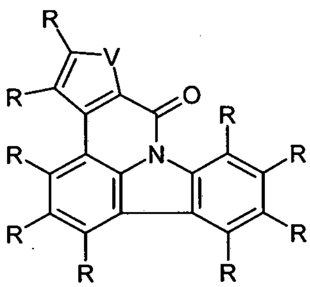
Formel (68a)

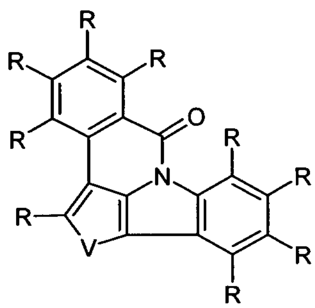
Formel (69a)

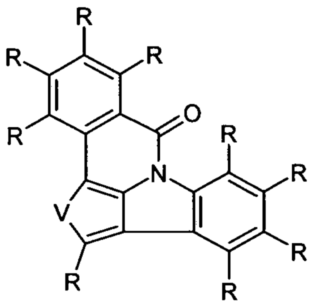
Formel (70a)

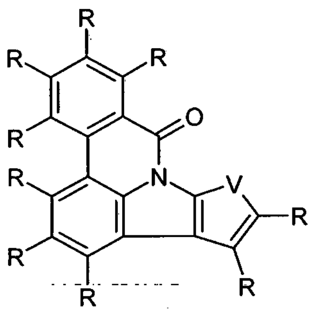

Formel (71a)

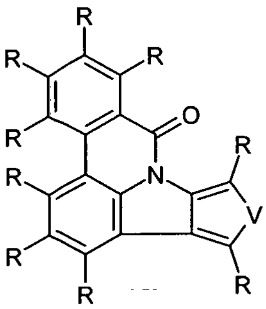

Formel (72a)

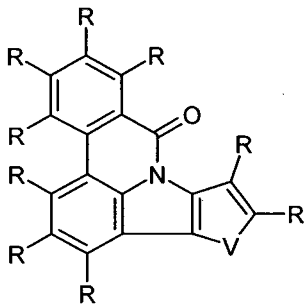

Formel (73a)

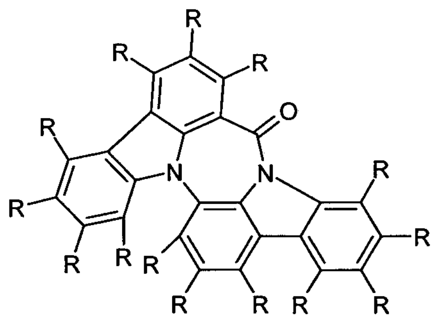

Formel (74a)

wobei die verwendeten Symbole die oben genannten Bedeutungen aufweisen.

Ganz besonders bevorzugt sind die Strukturen der Formeln (65b) bis (74b),

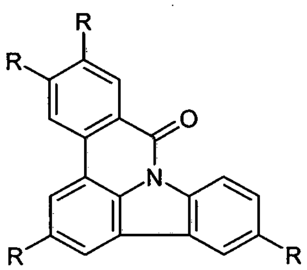

Formel (65b)

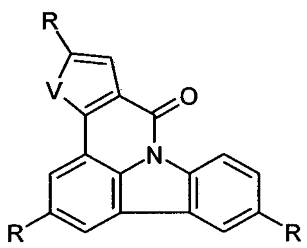

Formel (66b)

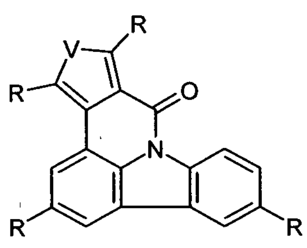

Formel (67b)

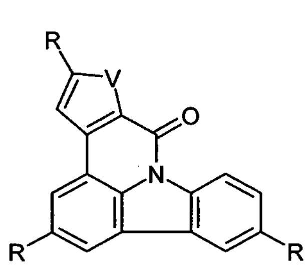

Formel (68b)

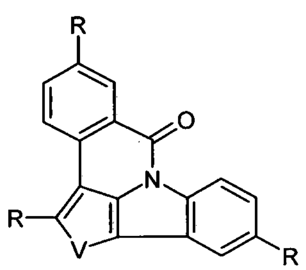

Formel (69b)

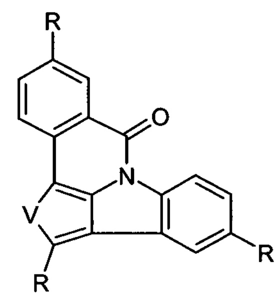

Formel (70b)

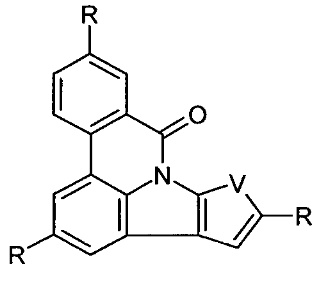

Formel (71b)

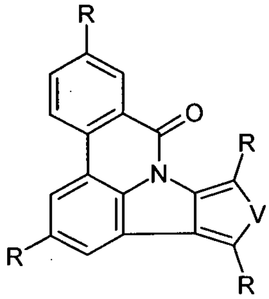

Formel (72b)

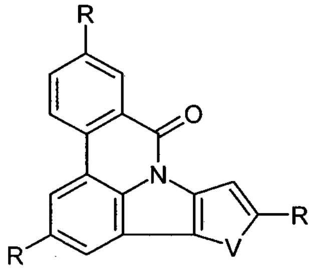

Formel (73b)

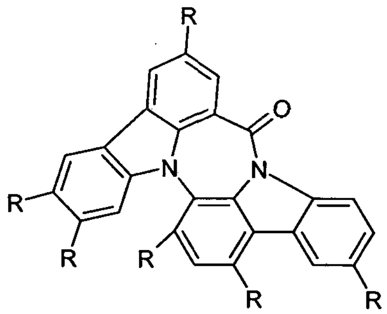

Formel (74b)

wobei die verwendeten Symbole die oben genannten Bedeutungen aufweisen.

Ganz besonders bevorzugt sind die Verbindungen der Formel (65) bzw. (65a) bzw. (65b).

Die verbrückende Gruppe L in den Verbindungen der Formeln (54) ist bevorzugt ausgewählt aus einer Einfachbindung oder einem aromatischen oder heteroaromatischen Ringsystem mit 5 bis 24, bevorzugt 6 bis 12 aromatischen Ringatomen, welches durch einen oder mehrere Reste R substituiert sein kann. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind.

In einer weiteren bevorzugten Ausführungsform der Erfindung ist der Index m in Verbindungen der Formel (54) = 2 oder 3, insbesondere gleich 2. Ganz besonders bevorzugt werden Verbindungen der Formel (53) eingesetzt.

In einer bevorzugten Ausführungsform der Erfindung ist R in den Lactamen der oben genannten Formeln gleich oder verschieden bei jedem Auftreten ausgewählt aus der Gruppe bestehend aus H, D, F, Cl, Br, CN, $N(R^1)_2$, $C(=O)R^1$, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen oder einer Alkenylgruppe mit 2 bis 10 C-Atomen, die jeweils mit einem oder mehreren Resten $R^1$ substituiert sein kann, wobei eine oder mehrere nicht-benachbarte $CH_2$-Gruppen durch O ersetzt sein können und wobei ein oder mehrere H-Atome durch D oder F ersetzt sein können, einem aromatischen oder heteroaromatischen Ringsystem mit 5 bis 30 aromatischen Ringatomen, das jeweils mit einem oder mehreren Resten $R^1$ substituiert sein kann, einer Aryloxy- oder Heteroaryloxygruppe mit 5 bis 30 aromatischen Ringatomen, die mit einem oder mehreren Resten $R^1$ substituiert sein kann.

In einer besonders bevorzugten Ausführungsform der Erfindung ist R in den Lactamen oben genannten Formeln gleich oder verschieden bei jedem Auftreten ausgewählt aus der Gruppe bestehend aus H, D, F, Cl, Br, CN, einer geradkettigen Alkylgruppe mit 1 bis 10 C-Atomen, bevorzugt mit 1 bis 4 C-Atomen, oder einer verzweigten oder cyclischen Alkylgruppe mit 3 bis 10 C-Atomen, bevorzugt mit 3 bis 4 C-Atomen, die jeweils mit einem oder mehreren Resten $R^1$ substituiert sein kann, wobei ein oder mehrere H-Atome durch D oder F ersetzt sein können, einem aromatischen oder heteroaromatischen Ringsystem mit 5 bis 18 aromatischen Ringatomen, das jeweils mit einem oder mehreren Resten $R^1$ substituiert sein kann.

Dabei enthalten die Reste R, wenn diese aromatische oder heteroaromatischen Ringsysteme enthalten, bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. Insbesondere bevorzugt sind hier Phenyl, Biphenyl, Terphenyl, Quaterphenyl, Carbazol, Dibenzothiophen, Dibenzofuran, Indenocarbazol, Indolocarbazol, Triazin oder Pyrimidin, welches jeweils auch durch einen oder mehrere Reste $R^1$ substituiert sein kann.

Die Verbindungen der Formeln (53) und (54) sind prinzipiell bekannt. Die Synthese dieser Verbindungen kann

gemäß den in der WO 2011/116865 und WO 2011/137951 beschriebenen Verfahren erfolgen.

Beispiele für bevorzugte Verbindungen gemäß den oben aufgeführten Ausführungsformen sind die in der folgenden Tabelle aufgeführten Verbindungen.

| | | |
|---|---|---|
| 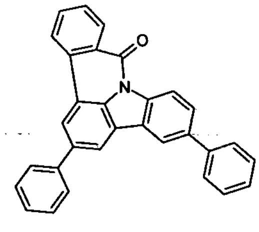 | 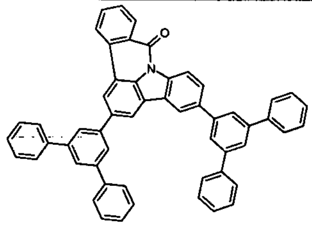 | 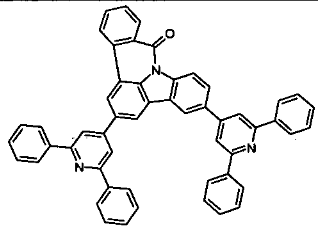 |
| 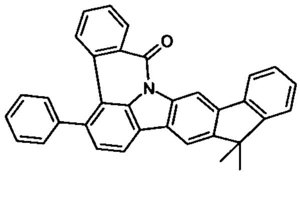 | 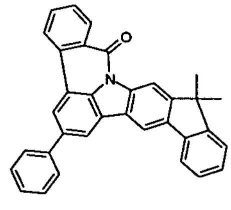 | 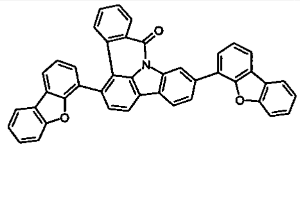 |
| 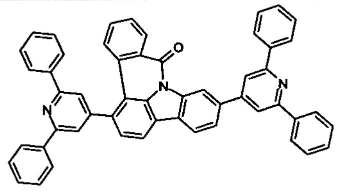 | 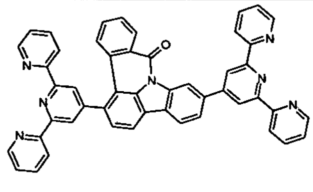 | 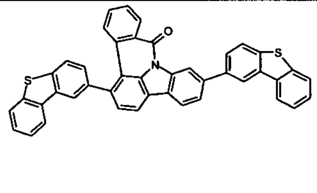 |
| 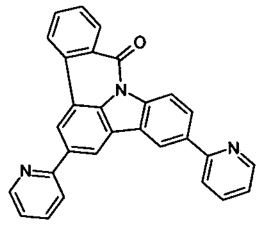 | 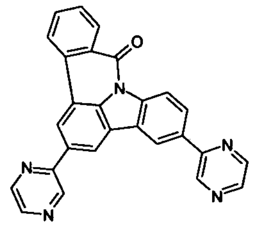 | 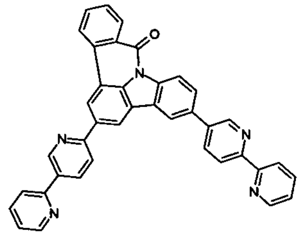 |
| 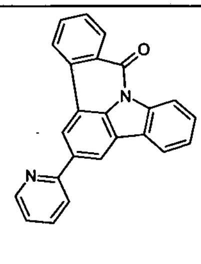 | 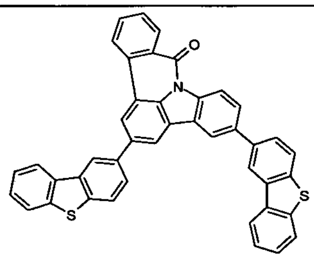 | 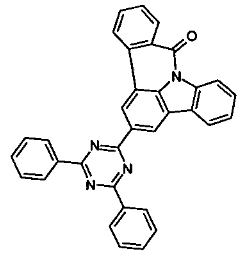 |
| 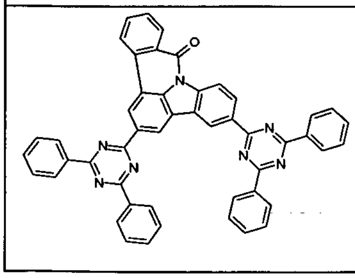 | 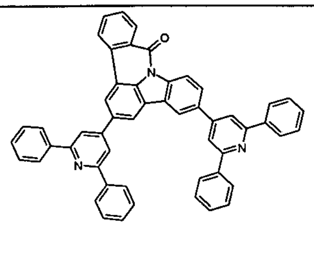 | 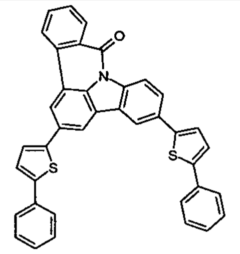 |

| | | |
|---|---|---|
| 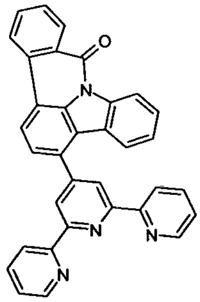 | 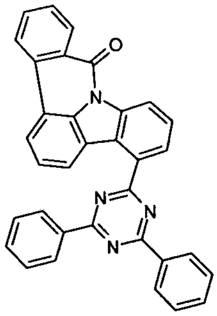 | 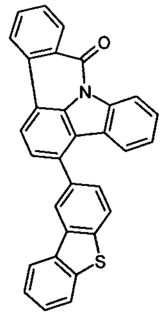 |
| 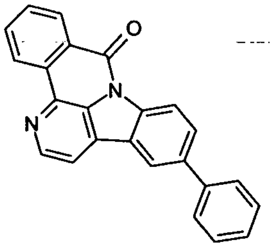 | 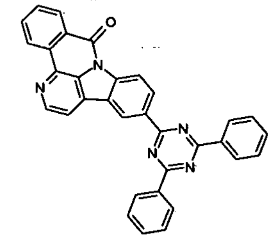 | 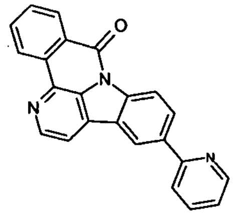 |
| 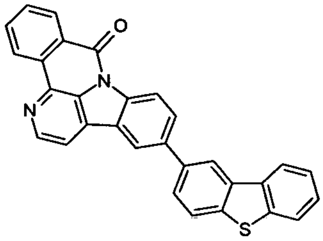 | 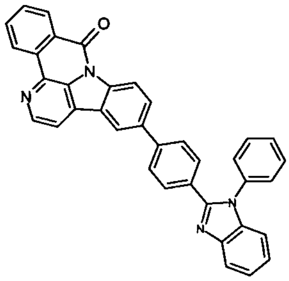 | 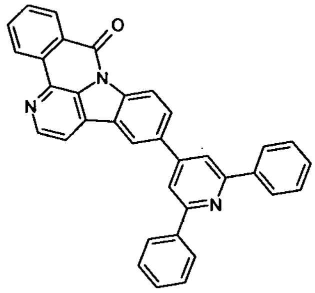 |
| 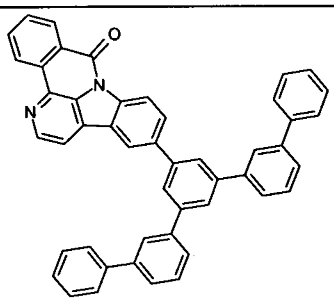 | 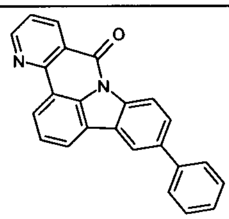 | 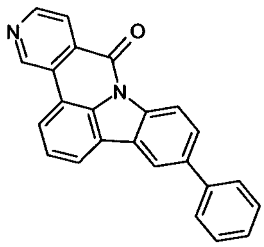 |
| 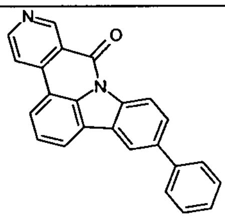 | 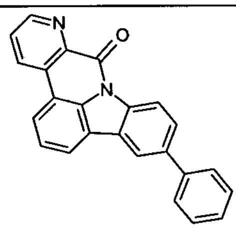 | 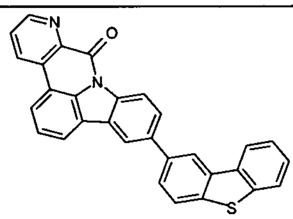 |
| 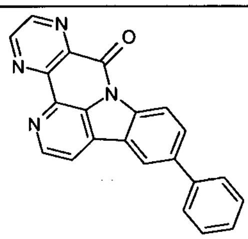 | 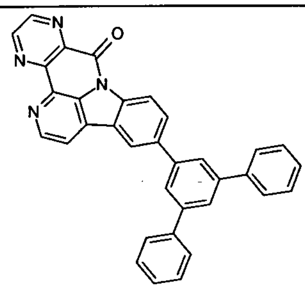 | 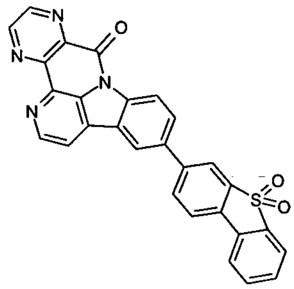 |

| | | |
|---|---|---|
| 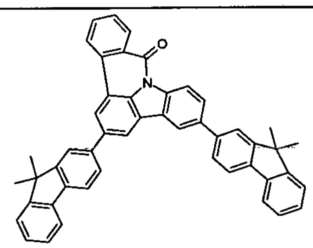 | 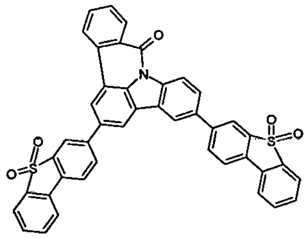 | 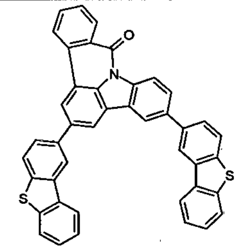 |
| 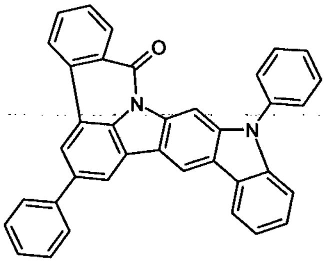 | 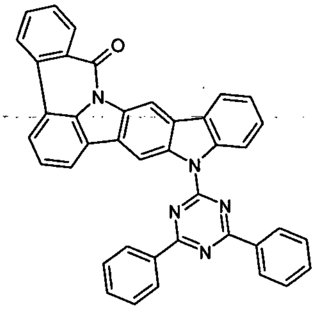 | 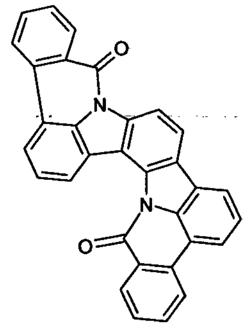 |
| 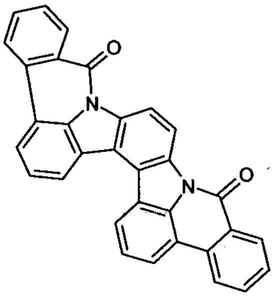 | 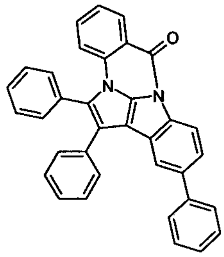 | 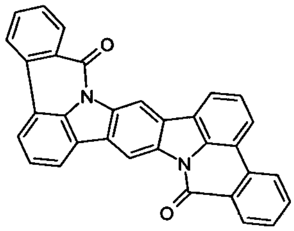 |
| 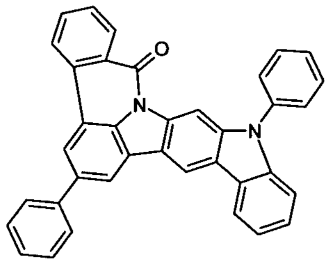 | 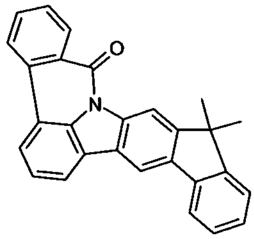 | 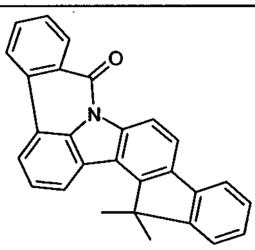 |
| 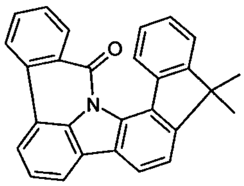 | 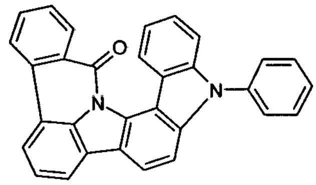 | 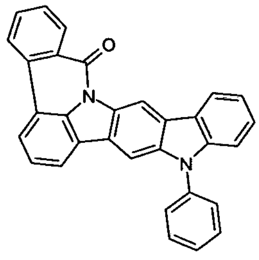 |
| 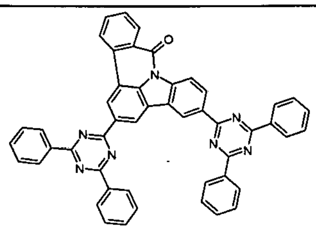 | 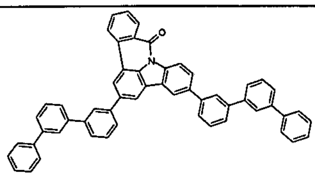 | 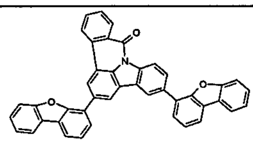 |

| | | |
|---|---|---|
| 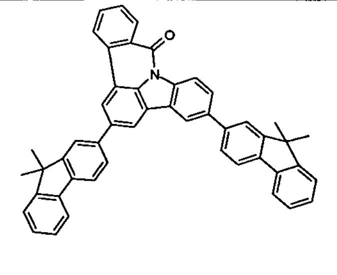 | 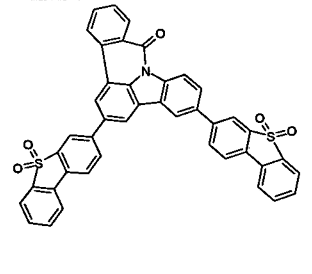 | 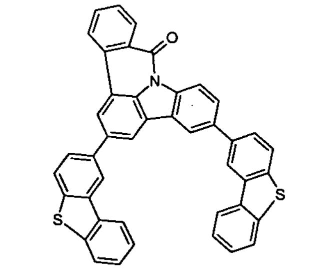 |
| 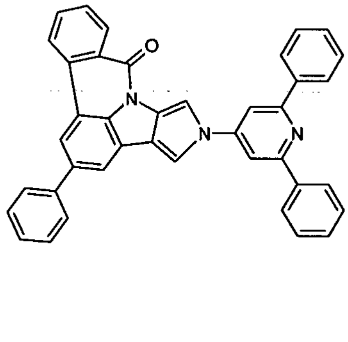 | 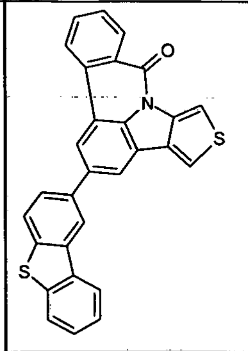 | 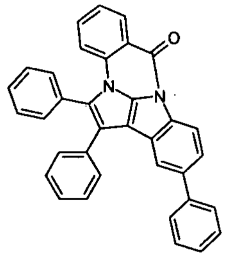 |
| 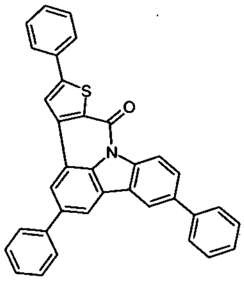 | 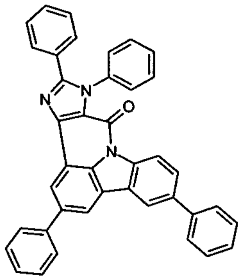 | 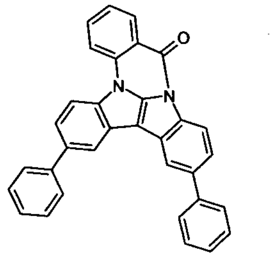 |
| 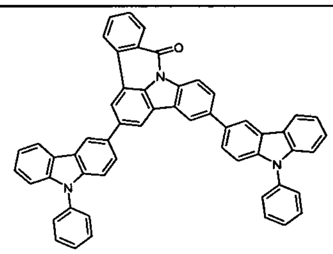 | 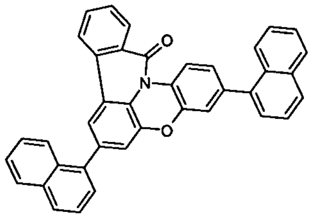 | 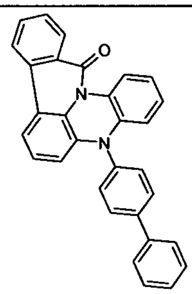 |
| 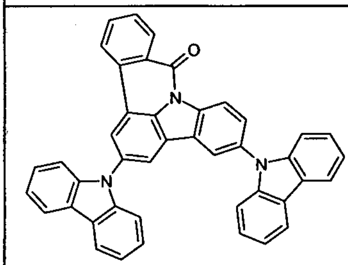 | 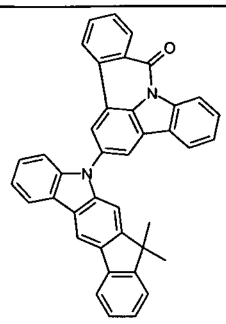 | 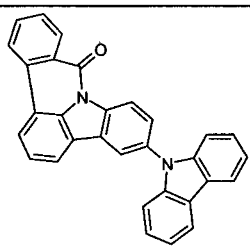 |

| | | |
|---|---|---|
| 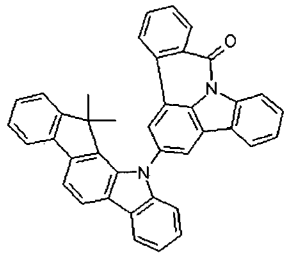 | 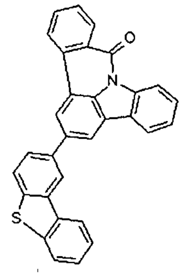 | 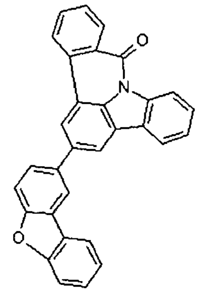 |
| 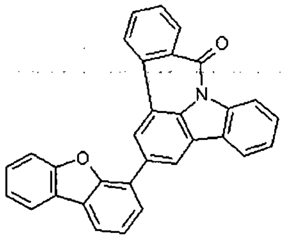 | 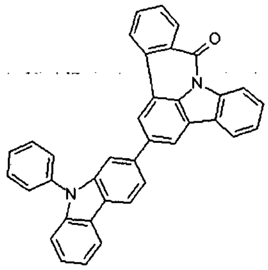 | 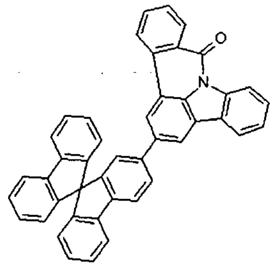 |
| 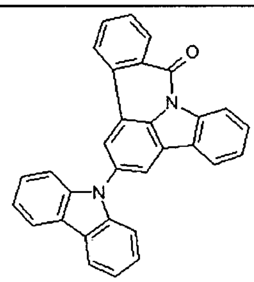 | 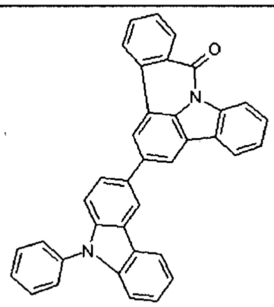 | 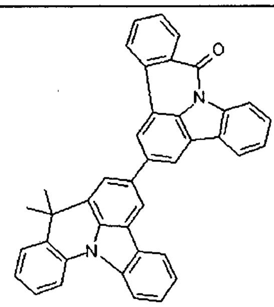 |
| 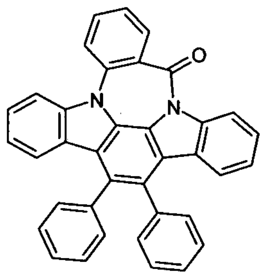 | 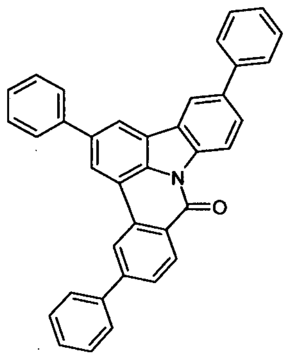 | 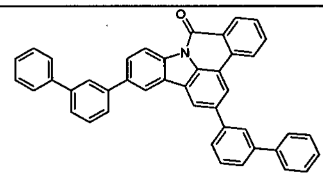 |
| 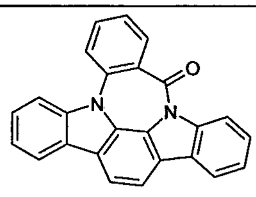 | 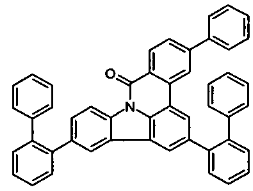 | 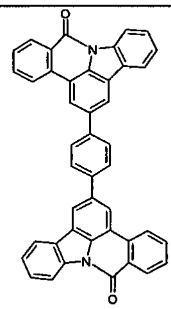 |

| | | |
|---|---|---|
| 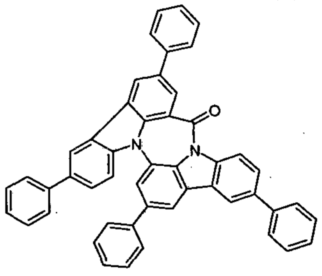 | 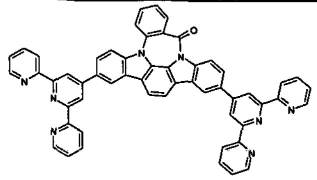 | 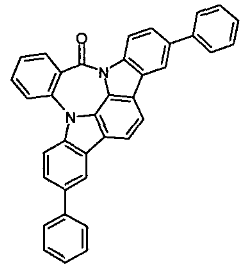 |
| 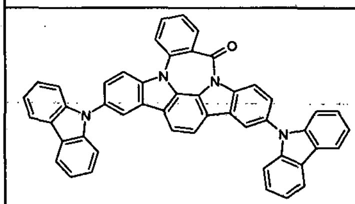 | 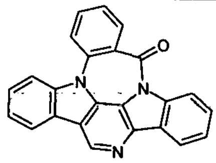 | 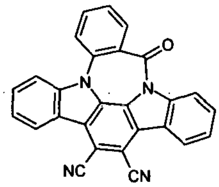 |
| 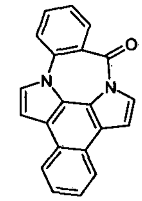 | 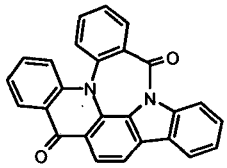 | 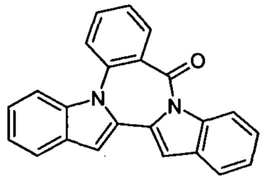 |
| 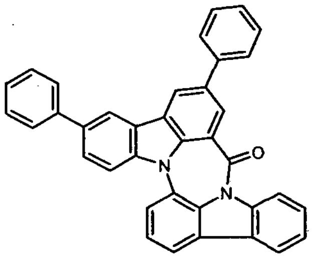 | 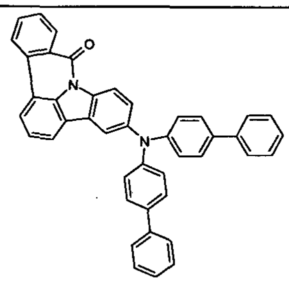 | 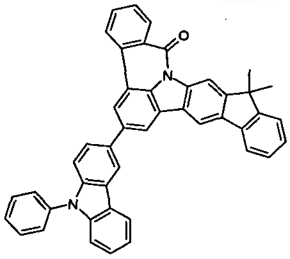 |
| 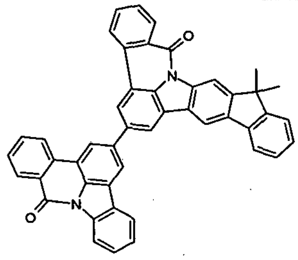 | 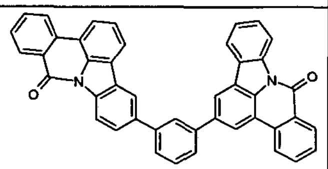 | 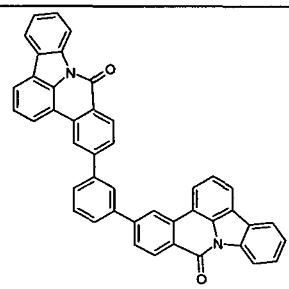 |
| 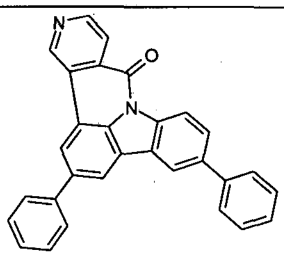 | | |

Weiterhin eignen sich aromatische Ketone oder aromatische Phosphinoxide als elektronentransportierende Verbindung, sofern das LUMO dieser Verbindungen ≤ -2.4 eV ist. Unter einem aromatischen Keton im Sinne dieser Anmeldung wird eine Carbonylgruppe verstanden, an die zwei aromatische oder heteroaromatische Gruppen bzw. aromatische oder heteroaromatische Ringsysteme direkt gebunden sind. Unter einem aromatischen Phosphinoxid im Sinne dieser Anmeldung wird eine P=O Gruppe verstanden, an die drei aromatische oder heteroaromatische Gruppen bzw. aromatische oder heteroaromatische Ringsysteme direkt gebunden sind. Beispiele für geeignete Ketone und Phosphinoxide können den Anmeldungen WO 2004/093207, WO 2005/003253 und WO 2010/006680 entnommen werden.

Geeignete Azaphosphole, die als elektronentransportierende Verbindung in der erfindungsgemäßen organischen Elektrolumineszenzvorrichtung eingesetzt werden können, sind solche Verbindungen, wie sie in WO 2010/054730 offenbart sind, sofern das LUMO dieser Verbindungen $\leq$ -2.4 eV beträgt.

Geeignete Azaborole, die als elektronentransportierende Verbindung in der erfindungsgemäßen organischen Elektrolumineszenzvorrichtung eingesetzt werden können, sind Azaborolderivate, welche mit mindestens einem elektronentransportierenden Substituenten substituiert sind, sofern das LUMO dieser Verbindungen $\leq$ -2.4 eV beträgt. Solche Verbindungen sind in der WO 2013/091762 offenbart.

Im Folgenden wird die phosphoreszierende Iridiumverbindung näher beschrieben.

Wie oben beschrieben, weist die phosphoreszierende Iridiumverbindung eine Gruppe gemäß einer der der oben genannten Formeln (1) bis (7) auf.

In den Strukturen der Formeln (1) bis (7) sowie in den nachfolgend als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wesentlich bei den Gruppen der Formeln (1) bis (7) ist, dass diese keine aziden benzylischen Protonen aufweisen. Unter benzylischen Protonen werden Protonen verstanden, die an ein Kohlenstoffatom binden, welches direkt an den Liganden gebunden ist. Die Abwesenheit von aziden benzylischen Protonen wird in den Formeln (1) bis (3) dadurch erreicht, dass $A^1$ und $A^3$, wenn diese für $C(R^3)_2$ stehen, so definiert sind, dass $R^3$ ungleich Wasserstoff ist. Die Abwesenheit von aziden benzylischen Protonen ist in Formeln (4) bis (7) dadurch erreicht, dass es sich dabei um eine bicyclische Struktur handelt. Aufgrund der starren räumlichen Anordnung ist $R^1$, wenn es für H steht, deutlich weniger azide als benzylische Protonen, da das korrespondierende Anion der bicyclischen Struktur nicht mesomeriestabilisiert ist. Auch wenn $R^1$ in Formeln (4) bis (7) für H steht, handelt es sich dabei daher um ein nicht-azides Proton im Sinne der vorliegenden Anmeldung.

In einer bevorzugten Ausführungsform der Struktur gemäß Formel (1) bis (7) steht maximal eine der Gruppen $A^1$, $A^2$ und $A^3$ für ein Heteroatom, insbesondere für O oder $NR^3$, und die anderen Gruppen stehen für $C(R^3)_2$ bzw. $C(R^1)_2$, oder $A^1$ und $A^3$ stehen gleich oder verschieden bei jedem Auftreten für O oder $NR^3$ und $A^2$ steht für $C(R^1)_2$. In einer besonders bevorzugten Ausführungsform der Erfindung stehen $A^1$ und $A^3$ gleich oder verschieden bei jedem Auftreten für $C(R^3)_2$ und $A^2$ steht für $C(R^1)_2$ und besonders bevorzugt für $C(R^3)_2$ oder $CH_2$.

Bevorzugte Ausführungsformen der Formel (1) sind somit die Strukturen der Formel (1-A), (1-B), (1-C) und (1-D), und eine besonders bevorzugte Ausführungsform der Formel (1-A) sind die Strukturen der Formel (1-E) und (1-F),

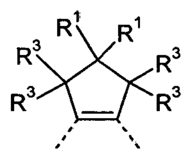

Formel (1-A)

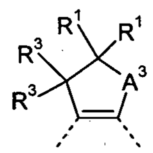

Formel (1-B)

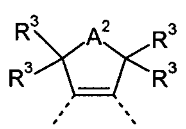

Formel (1-C)

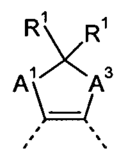

Formel (1-D)

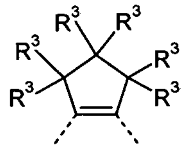

Formel (1-E)

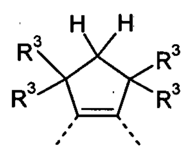

Formel (1-F)

wobei $R^1$ und $R^3$ die oben genannten Bedeutungen aufweisen und $A^1$, $A^2$ und $A^3$ gleich oder verschieden bei jedem Auftreten für O oder $NR^3$ steht.

Bevorzugte Ausführungsformen der Formel (2) sind die Strukturen der folgenden Formeln (2-A) bis (2-F),

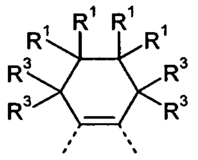
Formel (2-A)

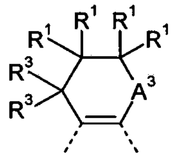
Formel (2-B)

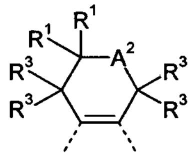
Formel (2-C)

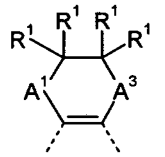
Formel (2-D)

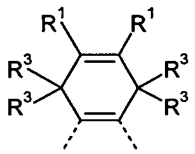
Formel (2-E)

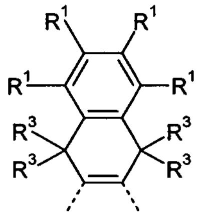
Formel (2-F)

wobei $R^1$ und $R^3$ die oben genannten Bedeutungen aufweisen und $A^1$, $A^2$ und $A^3$ gleich oder verschieden bei jedem Auftreten für O oder $NR^3$ steht.

Bevorzugte Ausführungsformen der Formel (3) sind die Strukturen der folgenden Formeln (3-A) bis (3-E),

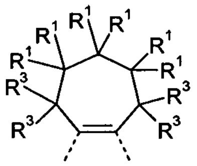
Formel (3-A)

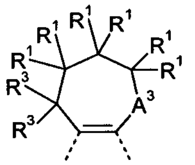
Formel (3-B)

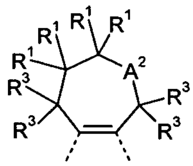
Formel (3-C)

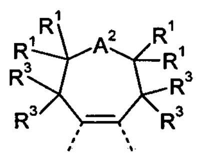
Formel (3-D)

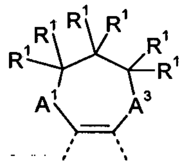
Formel (3-E)

wobei $R^1$ und $R^3$ die oben genannten Bedeutungen aufweisen und $A^1$, $A^2$ und $A^3$ gleich oder verschieden bei jedem Auftreten für O oder $NR^3$ steht.

In einer bevorzugten Ausführungsform der Struktur gemäß Formel (4) stehen die Reste $R^1$, die an den Brückenkopf gebunden sind, für H, D, F oder $CH_3$. Weiterhin bevorzugt steht $A^2$ für $C(R^1)_2$ oder O, und besonders bevorzugt für $C(R^3)_2$. Bevorzugte Ausführungsformen der Formel (4) sind somit eine Strukturen der Formel (4-A) und (4-B), und eine besonders bevorzugte Ausführungsform der Formel (4-A) ist eine Struktur der Formel (4-C),

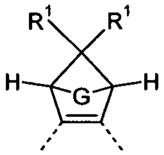
Formel (4-A)

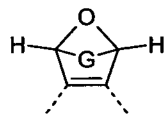
Formel (4-B)

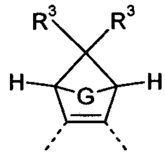
Formel (4-C)

wobei die verwendeten Symbole die oben genannten Bedeutungen aufweisen.

In einer bevorzugten Ausführungsform der Struktur gemäß Formel (5), (6) und (7) stehen die Reste $R^1$, die an

den Brückenkopf gebunden sind, für H, D, F oder $CH_3$. Weiterhin bevorzugt steht $A^2$ für $C(R^1)_2$. Bevorzugte Ausführungsformen der Formel (5), (6) und (7) sind somit die Strukturen der Formeln (5-A), (6-A) und (7-A),

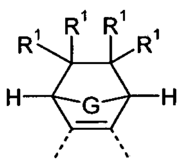
Formel (5-A)

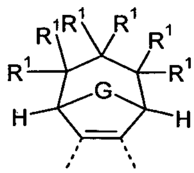
Formel (6-A)

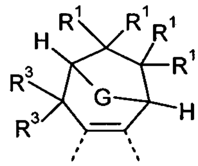
Formel (7-A)

wobei die verwendeten Symbole die oben genannten Bedeutungen aufweisen.

Weiterhin bevorzugt steht die Gruppe G in den Formeln (4), (4-A), (4-B), (4-C), (5), (5-A), (6), (6-A), (7) und (7-A) für eine 1,2-Ethylengruppe, welche mit einem oder mehreren Resten $R^2$ substituiert sein kann, wobei $R^2$ bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten $R^2$ substituiert sein kann, bevorzugt aber unsubstituiert ist, insbesondere eine ortho-Phenylengruppe, welche mit einem oder mehreren Resten $R^2$ substituiert sein kann, bevorzugt aber unsubstituiert ist.

In einer weiteren bevorzugten Ausführungsform der Erfindung steht $R^3$ in den Gruppen der Formel (1) bis (7) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 10 C-Atomen, wobei jeweils eine oder mehrere nicht benachbarte $CH_2$-Gruppen durch $R^2C=CR^2$ ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste $R^2$ substituiert sein kann; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden.

In einer besonders bevorzugten Ausführungsform der Erfindung steht $R^3$ in den Gruppen der Formeln (1) bis (7) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste $R^2$ substituiert sein kann, bevorzugt aber unsubstituiert ist; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest R oder $R^1$ ein aliphatisches Ringsystem bilden. Wenn zwei Reste $R^3$, die an dasselbe Kohlenstoffatom gebunden sind, miteinander ein aliphatisches Ringsystem aufspannen, so handelt es sich dabei bevorzugt um eine Cyclopentylgruppe oder eine Cyclohexylgruppe.

Beispiele für besonders geeignete Gruppen der Formel (1) sind die im Folgenden aufgeführten Gruppen (1-1) bis (1-69):

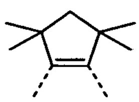
(1-1)

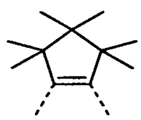
(1-2)

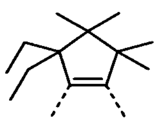
(1-3)

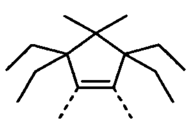
(1-4)

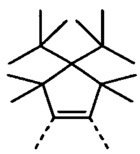
(1-5)

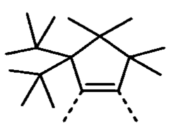
(1-6)

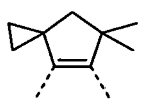
(1-7)

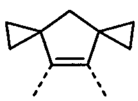
(1-8)

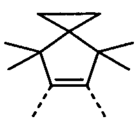
(1-9)

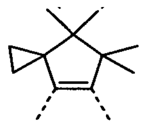
(1-10)

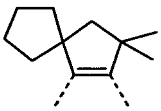
(1-11)

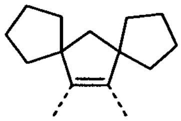
(1-12)

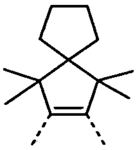
(1-13)

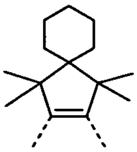
(1-14)

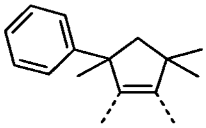
(1-15)

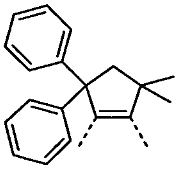
(1-16)

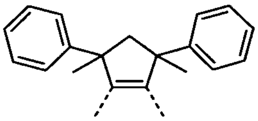
(1-17)

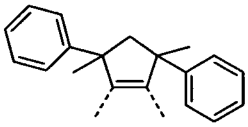
(1-18)

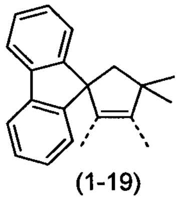
(1-19)

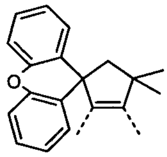
(1-20)

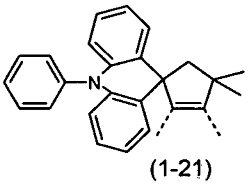
(1-21)

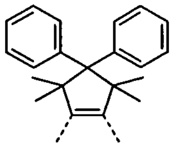
(1-22)

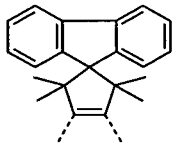
(1-23)

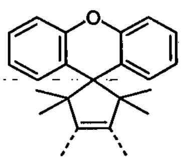
(1-24)

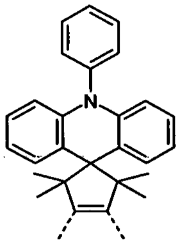
(1-25)

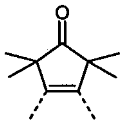
(1-26)

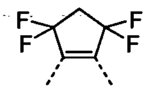
(1-27)

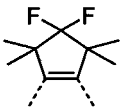
(1-28)

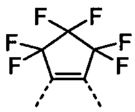
(1-29)

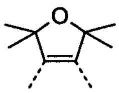
(1-30)

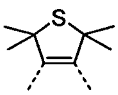
(1-31)

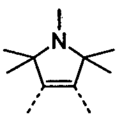
(1-32)

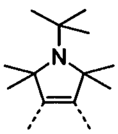
(1-33)

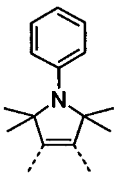
(1-34)

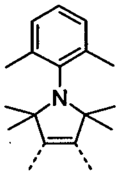
(1-35)

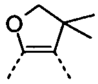
(1-36)

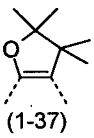
(1-37)

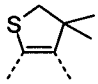
(1-38)

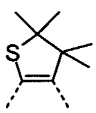
(1-39)

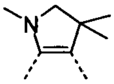
(1-40)

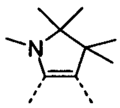
(1-41)

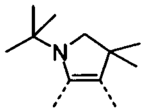 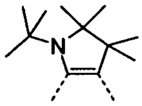 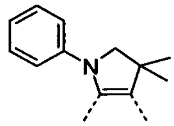 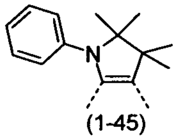 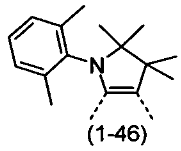

(1-42) (1-43) (1-44) (1-45) (1-46)

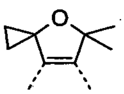 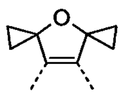 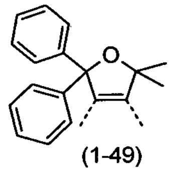 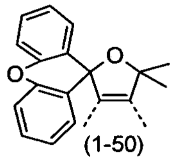 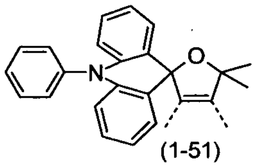

(1-47) (1-48) (1-49) (1-50) (1-51)

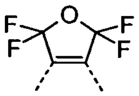 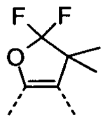 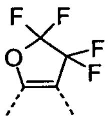 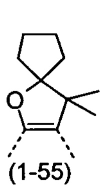 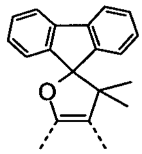 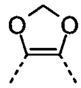 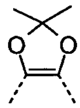

(1-52) (1-53) (1-54) (1-55) (1-56) (1-57) (1-58)

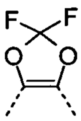 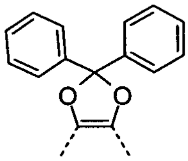 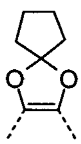 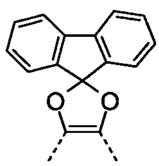 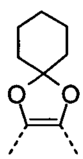 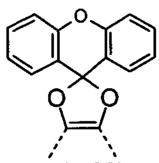

(4-58) (4-59) (4-60) (4-61) (4-62) (4-63)

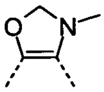 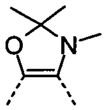 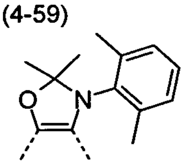 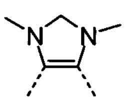 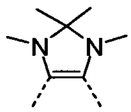 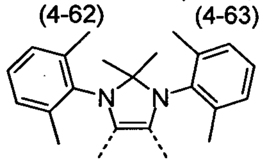

(4-64) (4-65) (4-66) (4-67) (4-68) (4-69)

Beispiele für besonders geeignete Gruppen der Formel (2) sind die im Folgenden aufgeführten Gruppen (2-1) bis (2-14):

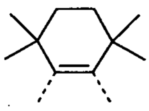 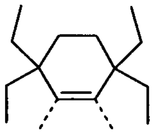 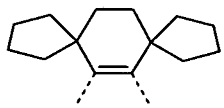 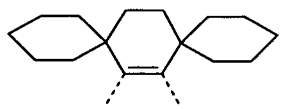

(2-1) (2-2) (2-3) (2-4)

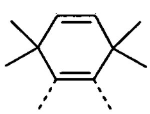 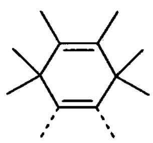 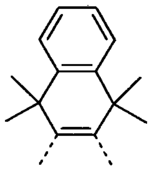 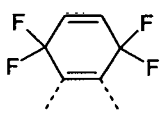 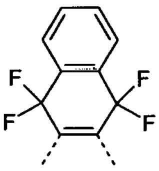

(2-5) (2-6) (2-7) (2-8) (2-9)

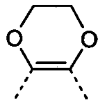
(2-10)

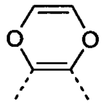
(2-11)

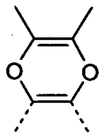
(2-12)

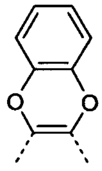
(2-13)

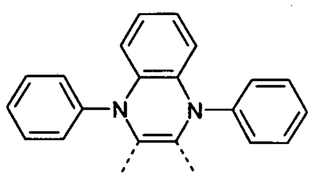
(2-14) .

Beispiele für besonders geeignete Gruppen der Formeln (3), (6) und (7) sind die im Folgenden aufgeführten Gruppen (3-1), (6-1), (7-1) und (7-2):

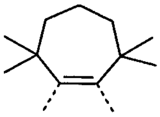
(3-1)

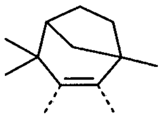
(6-1)

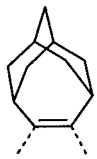
(7-1)

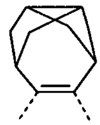
(7-2) .

Beispiele für besonders geeignete Gruppen der Formel (4) sind die im Folgenden aufgeführten Gruppen (4-1) bis (4-22):

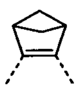
(4-1)

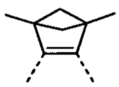
(4-2)

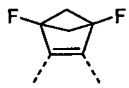
(4-3)

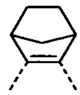
(4-4)

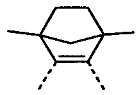
(4-5)

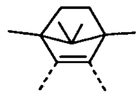
(4-6)

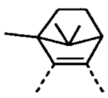
(4-7)

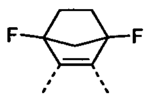
(4-8)

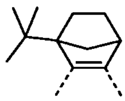
(4-9)

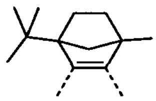
(4-10)

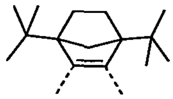
(4-11)

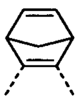
(4-12)

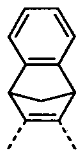
(4-13)

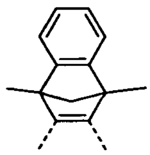
(4-14)

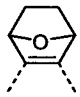
(4-15)

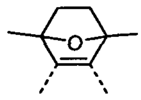
(4-16)

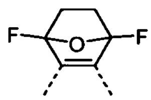
(4-17)

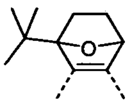
(4-18)

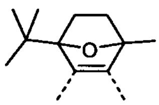
(4-19)

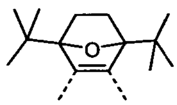
(4-20)

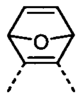
(4-21)

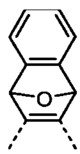
(4-22) .

Beispiele für besonders geeignete Gruppen der Formel (5) sind die im Folgenden aufgeführten Gruppen (5-1) bis (5-5):

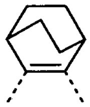 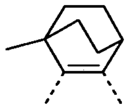 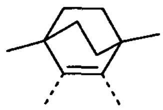 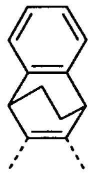 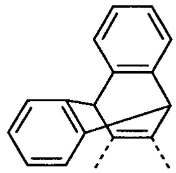

(5-1) (5-2) (5-3) (5-4) (5-5) .

Insbesondere die Verwendung derartiger ankondensierter bicyclischer Strukturen kann aufgrund der Chiralität der Strukturen auch zu chiralen Liganden führen. Hier kann sowohl die Verwendung enantiomerenreiner Liganden wie auch die Verwendung des Racemats geeignet sein. Es kann auch insbesondere geeignet sein, im Metallkomplex nicht nur ein Enantiomer von einem Liganden zu verwenden, sondern gezielt beide Enantiomere. Dies kann Vorteile bezüglich der Löslichkeit des entsprechenden Komplexes gegenüber Komplexen, die nur das eine oder das andere Enantiomer des Liganden enthalten, haben.

Wie oben beschrieben, weist die phosphoreszierende Iridiumverbindung mindestens einen Liganden auf, der mindestens bidentat ist und der über ein Kohlenstoffatom und ein Stickstoffatom oder über zwei Kohlenstoffatome an das Iridium bindet und der mindestens eine der oben genannten Gruppen (1) bis (7) enthält. Bevorzugt handelt es sich bei den Liganden um anionische Liganden, die monoanionisch oder mehrfach anionisch sein können. Wenn es sich um bidentate Liganden handelt, so handelt es sich bevorzugt um monoanionische Liganden. Besonders bevorzugt handelt es sich um eine Iridiumverbindung, die drei bidentate, monoanionische Liganden aufweist, von denen mindestens zwei über ein Kohlenstoffatom und ein Stickstoffatom oder über zwei Kohlenstoffatome koordinieren; dabei können die Liganden über eine verknüpfende Gruppe auch zu einem polypodalen Liganden verbunden sein.

In einer bevorzugten Ausführungsform der Erfindung handelt es sich bei der phosphoreszierenden Iridiumverbindung um eine Verbindung der folgenden Formel (75),

$$Ir(L^1)_p(L^2)_q \qquad \text{Formel (75)}$$

wobei für die verwendeten Symbole und Indizes gilt:

$L^1$ ist ein bidentater monoanionischer Ligand, der mindestens eine Aryloder Heteroarylgruppe aufweist, die an das Iridium über ein Kohlenstoff- oder Stickstoffatom bindet und die eine Gruppe gemäß einer der Formeln (1) bis (7) aufweist;

$L^2$ ist gleich oder verschieden bei jedem Auftreten ein monoanionischer bidentater Ligand;

p ist 1, 2 oder 3;

q ist (3 - p).

Dabei können die Liganden $L^1$ und $L^2$ auch über eine verknüpfende Gruppe auch zu einem polypodalen Liganden verbunden sein.

Im Folgenden werden bevorzugte Liganden $L^1$ beschrieben. In einer Ausführungsform der Erfindung handelt es sich bei der Struktur $Ir(L^1)_p$ um eine Struktur der folgenden Formel (76):

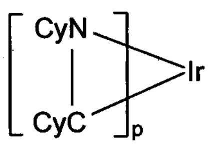

**Formel (76)**

wobei R und p die oben genannten Bedeutungen aufweisen und für die verwendeten Symbole und Indizes gilt:

CyC ist eine Aryl- oder Heteroarylgruppe mit 5 bis 18 aromatischen Ringatomen oder eine Fluorengruppe, welche jeweils über ein Kohlenstoffatom an Ir koordiniert und welche jeweils mit einem oder mehreren Resten R substituiert sein kann und welche jeweils über eine kovalente Bindung mit CyN verbunden ist;

CyN ist eine Heteroarylgruppe mit 5 bis 18 aromatischen Ringatomen, welche über ein neutrales Stickstoffatom oder über ein Carben-Kohlenstoffatom an Ir koordiniert und welche mit einem oder mehreren Resten R substituiert sein kann und welche über eine kovalente Bindung mit CyC verbunden ist;

dabei können CyC und CyN auch über eine Gruppe ausgewählt aus $C(R^1)=C(R^1)$, $C(R^1)_2$, $C(R^1)_2$-$C(R^1)_2$-, $NR^1$, O oder S miteinander verknüpft sein;
dabei bilden zwei direkt benachbarte Reste R an CyC und/oder an CyN zusammen mit den Kohlenstoffatomen, an die sie binden, eine Gruppe gemäß einer der oben genannten Formeln (1) bis (7) aus.

In einer bevorzugten Ausführungsform der vorliegenden Erfindung ist CyC eine Aryl- oder Heteroarylgruppe mit 5 bis 14 aromatischen Ringatomen, besonders bevorzugt 6 bis 13 aromatischen Ringatomen, ganz besonders bevorzugt mit 6 bis 10 aromatischen Ringatomen, insbesondere bevorzugt mit 6 aromatischen Ringatomen, welche über ein Kohlenstoffatom an Ir koordiniert und welche mit einem oder mehreren Resten R substituiert sein kann und welche über eine kovalente Bindung mit CyN verbunden ist.

Bevorzugte Ausführungsformen der Gruppe CyC sind die Strukturen der folgenden Formeln (CyC-1) bis (CyC-19), wobei die Gruppe CyC jeweils an der durch # gekennzeichneten Position an CyN bindet und an der durch * gekennzeichneten Position an das Metall M koordiniert,

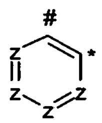
(CyC-1)

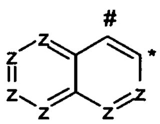
(CyC-2)

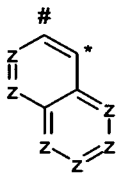
(CyC-3)

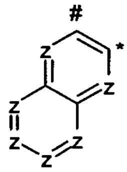
(CyC-4)

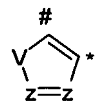
(CyC-5)

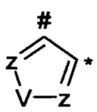
(CyC-6)

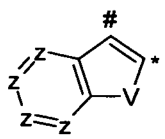
(CyC-7)

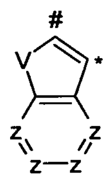
(CyC-8)

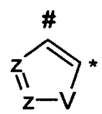
(CyC-9)

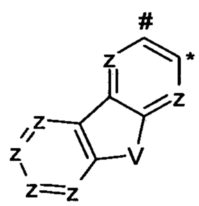
(CyC-10)

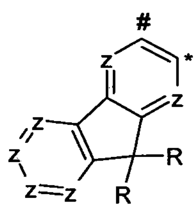
(CyC-11)

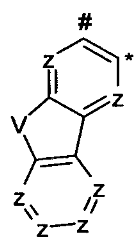
(CyC-12)

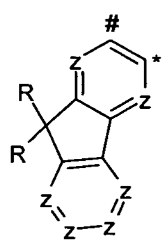
(CyC-13)

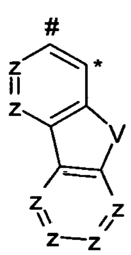
(CyC-14)

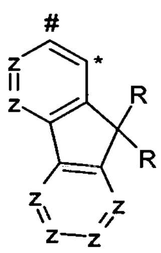
(CyC-15)

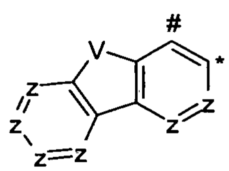
(CyC-16)

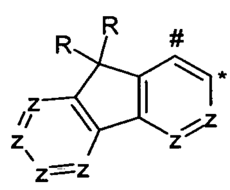
(CyC-17)

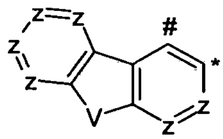

(CyC-18)

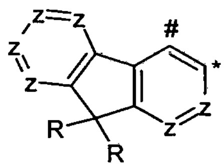

(CyC-19)

wobei R die oben genannten Bedeutungen aufweist und für die weiteren verwendeten Symbole gilt:

Z ist bei jedem Auftreten gleich oder verschieden CR oder N;

V ist bei jedem Auftreten gleich oder verschieden NR, O oder S.

Falls die Gruppe gemäß einer der Formeln (1) bis (7) an CyC gebunden ist, stehen zwei benachbarte Gruppen Z in CyC für CR und bilden zusammen mit den Resten R, die an diese Kohlenstoffatome gebunden sind, eine Gruppe gemäß einer der oben genannten Formeln (1) bis (7).

Bevorzugt stehen maximal drei Symbole Z in CyC für N, besonders bevorzugt stehen maximal zwei Symbole Z in CyC für N, ganz besonders bevorzugt steht maximal ein Symbol Z in CyC für N. Insbesondere bevorzugt stehen alle Symbole Z für CR.

Besonders bevorzugte Gruppen CyC sind die Gruppen der folgenden Formeln (CyC-1a) bis (CyC-19a),

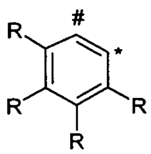

(CyC-1a)

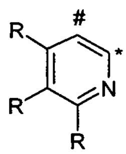

(CyC-1b)

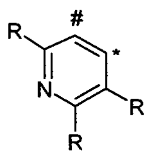

(CyC-1c)

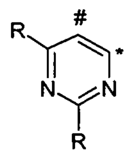

(CyC-1d)

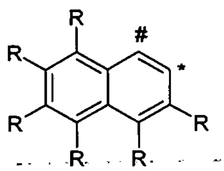

(CyC-2a)

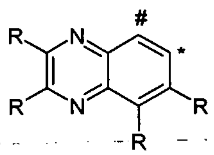

(CyC-2b)

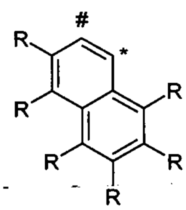

(CyC-3a)

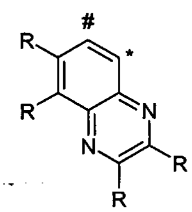

(CyC-3b)

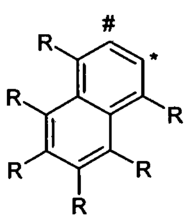

(CyC-4a)

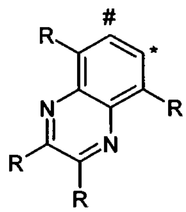

(CyC-4b)

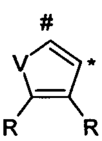

(CyC-5a)

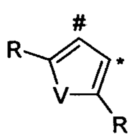

(CyC-6a)

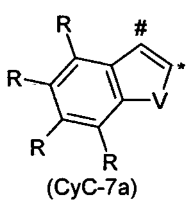

(CyC-7a)

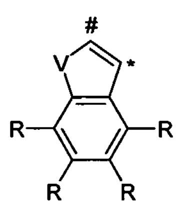

(CyC-8a)

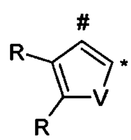

(CyC-9a)

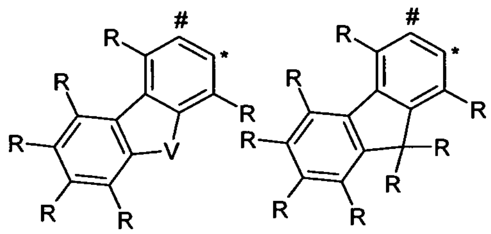

(CyC-10a) (CyC-11a)

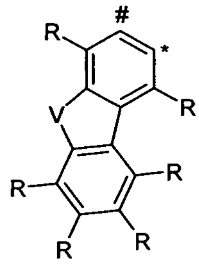

(CyC-12a)

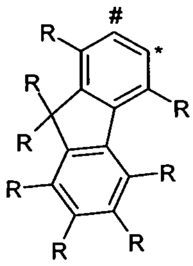

(CyC-13a)

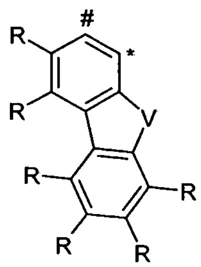

(CyC-14a)

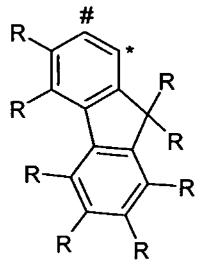

(CyC-15a)

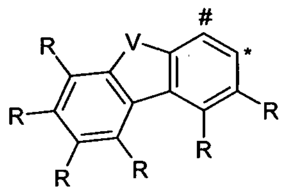

(CyC-16a)

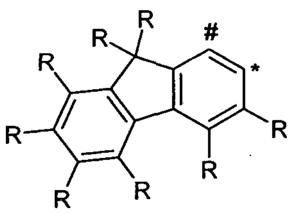

(CyC-17a)

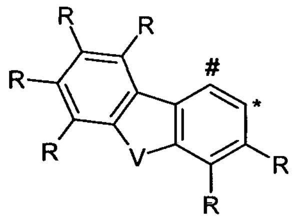

(CyC-18a)

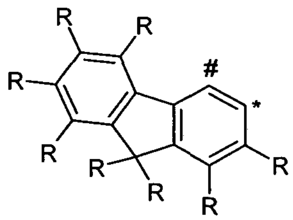

(CyC-19a)

wobei die verwendeten Symbole die oben genannten Bedeutungen aufweisen. Wenn an CyC die Gruppe gemäß einer der Formeln (1) bis (7) vorliegt, spannen zwei benachbarte Reste R zusammen mit den Kohlenstoffatomen, an die sie binden, einen Ring gemäß einer der Formeln (1) bis (7) auf.

Bevorzugte Gruppen unter den Gruppen (CyC-1) bis (CyC-19) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyN eine Heteroarylgruppe mit 5 bis 13 aromatischen Ringatomen, besonders bevorzugt mit 5 bis 10 aromatischen Ringatomen, welche über ein neutrales Stickstoffatom oder über ein Carben-Kohlenstoffatom an M koordiniert und welche mit einem oder mehreren Resten R substituiert sein kann und welche über eine kovalente Bindung mit CyC verbunden ist.

Bevorzugte Ausführungsformen der Gruppe CyN sind die Strukturen der folgenden Formeln (CyN-1) bis (CyN-10), wobei die Gruppe CyN jeweils an der durch # gekennzeichneten Position an CyC bindet und an der durch * gekennzeichneten Position an das Metall M koordiniert,

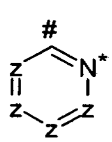

(CyN-1)

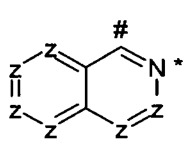

(CyN-2)

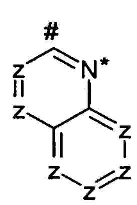

(CyN-3)

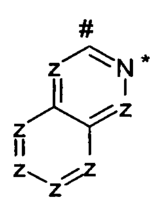

(CyN-4)

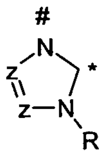
(CyN-5)

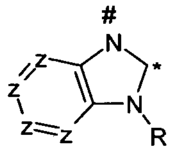
(CyN-6)

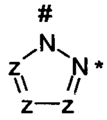
(CyN-7)

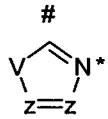
(CyN-8)

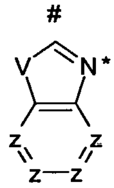
(CyN-9)

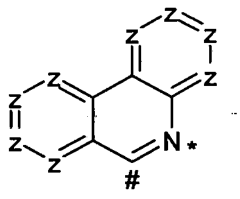
(CyN-10)

wobei Z, V und R die oben genannten Bedeutungen aufweisen.

Falls die Gruppe gemäß einer der Formeln (1) bis (7) an CyN gebunden ist, stehen zwei benachbarte Gruppen Z in CyN für CR und bilden zusammen mit den Resten R, die an diese Kohlenstoffatome gebunden sind, eine Gruppe gemäß einer der oben genannten Formeln (1) bis (7).

Bevorzugt stehen maximal drei Symbole Z in CyN für N, besonders bevorzugt stehen maximal zwei Symbole Z in CyN für N, ganz besonders bevorzugt steht maximal ein Symbol Z in CyN für N. Insbesondere bevorzugt stehen alle Symbole Z für CR.

Besonders bevorzugte Gruppen CyD sind die Gruppen der folgenden Formeln (CyN-1a) bis (CyN-10a),

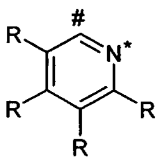
(CyN-1a)

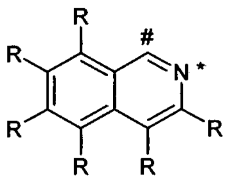
(CyN-2a)

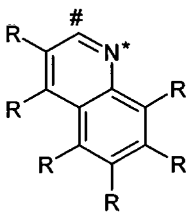
(CyN-3a)

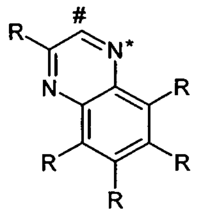
(CyN-3b)

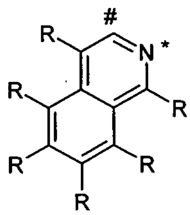
(CyN-4a)

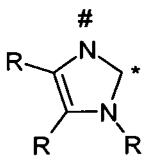
(CyN-5a)

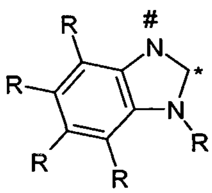
(CyN-6a)

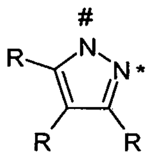
(CyN-7a)

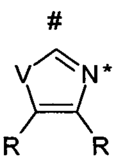
(CyN-8a)

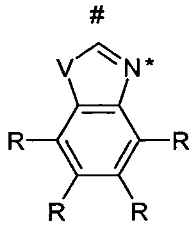
(CyN-9a)

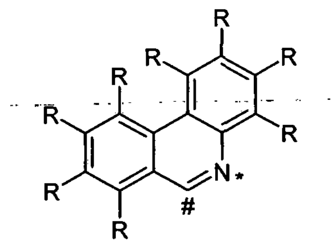
(CyN-10a)

wobei die verwendeten Symbole die oben genannten Bedeutungen aufweisen. Wenn an CyN die Gruppe gemäß einer der Formeln (1) bis (7) vorliegt, spannen zwei benachbarte Reste R zusammen mit den Kohlenstoffatomen, an die sie

binden, einen Ring gemäß einer der Formeln (1) bis (7) auf.

Bevorzugte Gruppen unter den Gruppen (CyN-1) bis (CyN-10) sind die Gruppen (CyN-1), (CyN-3), (CyN-4), (CyN-5) und (CyN-6), und besonders bevorzugt sind die Gruppen (CyN-1a), (CyN-3a), (CyN-4a), (CyN-5a) und (CyN-6a).

In einer bevorzugten Ausführungsform der vorliegenden Erfindung ist CyC eine Aryl- oder Heteroarylgruppe mit 5 bis 14 aromatischen Ringatomen und gleichzeitig ist CyN eine Heteroarylgruppe mit 5 bis 13 aromatischen Ringatomen. Besonders bevorzugt ist CyC eine Aryl- oder Heteroarylgruppe mit 6 bis 13 aromatischen Ringatomen, bevorzugt mit 6 bis 10 aromatischen Ringatomen, insbesondere mit 6 aromatischen Ringatomen, und gleichzeitig ist CyN eine Heteroarylgruppe mit 5 bis 10 aromatischen Ringatomen. Dabei können CyC und CyN mit einem oder mehreren Resten R substituiert sein. Die oben genannten bevorzugten Gruppen CyC und CyN können beliebig miteinander kombiniert werden.

In einer bevorzugten Ausführungsform der Erfindung enthält der Ligand entweder genau eine Gruppe gemäß einer der Formeln (1) bis (7), oder er enthält zwei Gruppen gemäß einer oder mehrerer der Formeln (1) bis (7), von denen eine an CyC und die andere an CyN gebunden ist. In einer besonders bevorzugten Ausführungsform enthält der Ligand L genau eine Gruppe gemäß einer der Formeln (1) bis (7). Dabei kann diese Gruppe entweder an CyC oder an CyN vorliegen, wobei sie in jeder möglichen Position an CyC oder CyN gebunden sein kann. Bevorzugt ist diese Gruppe an CyC gebunden.

In den folgenden Gruppen (CyC-1-1) bis (CyC-19-1) und (CyN-1-1) bis (CyN-10-1) sind jeweils die bevorzugten Positionen für benachbarte Gruppen Z, welche für CR stehen, abgebildet, wobei die jeweiligen Reste R zusammen mit den C-Atomen, an die sie gebunden sind, einen Ring gemäß einer der oben genannten Formeln (1) bis (7) aufspannen,

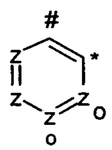
(CyC-1-1)

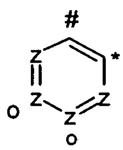
(CyC-1-2)

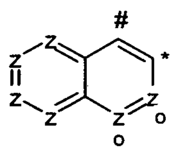
(CyC-2-1)

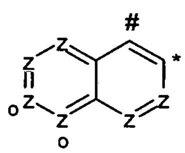
(CyC-2-2)

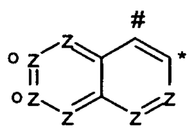
(CyC-2-3)

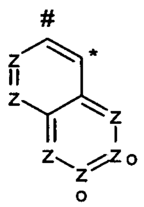
(CyC-3-1)

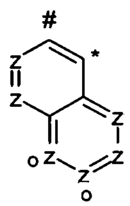
(CyC-3-2)

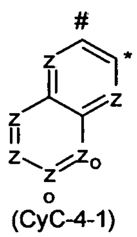
(CyC-4-1)

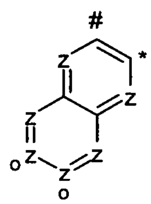
(CyC-4-2)

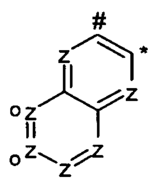
(CyC-4-3)

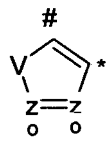
(CyC-5-1)

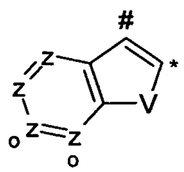
(CyC-7-1)

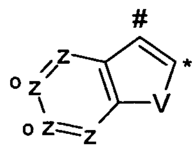
(CyC-7-2)

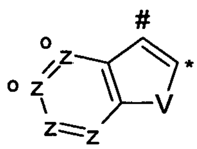
(CyC-7-3)

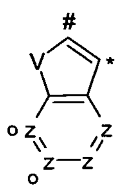
(CyC-8-1)

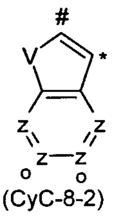
(CyC-8-2)

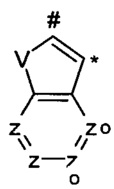
(CyC-8-3)

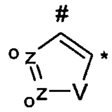
(CyC-9-1)

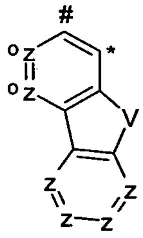
(CyC-14-1)

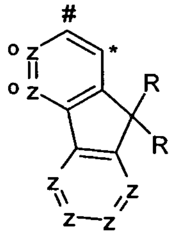
(CyC-15-1)

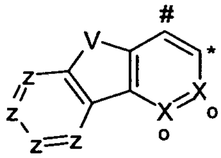
(CyC-16-1)

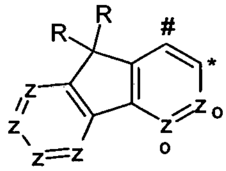
(CyC-17-1)

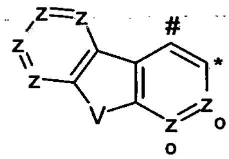
(CyC-18-1)

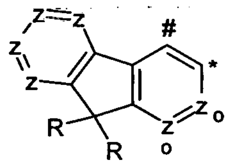
(CyC-19-1)

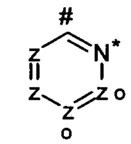
(CyN-1-1)

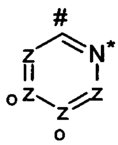
(CyN-1-2)

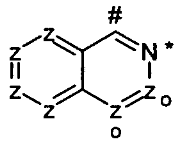
(CyN-2-1)

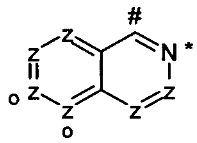
(CyN-2-2)

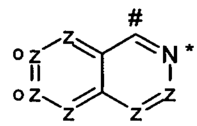
(CyN-2-3)

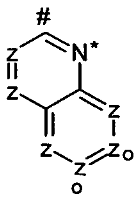
(CyN-3-1)

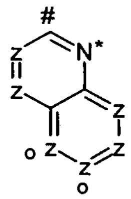
(CyN-3-2)

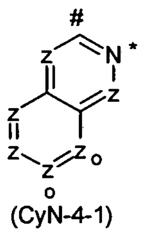
(CyN-4-1)

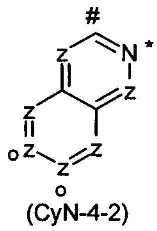
(CyN-4-2)

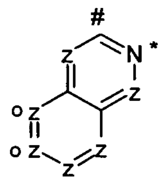
(CyN-4-3)

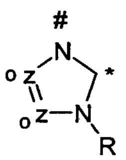
(CyN-5-1)

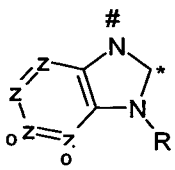
(CyN-6-1)

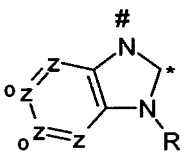
(CyN-6-2)

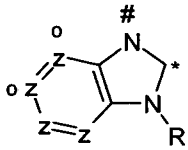
(CyN-6-3)

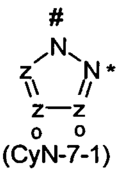
(CyN-7-1)

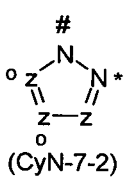
(CyN-7-2)

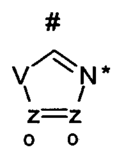
(CyN-8-1)

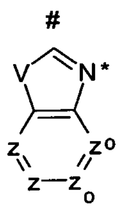
(CyN-9-1)

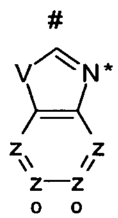
(CyN-9-2)

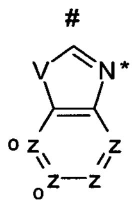
(CyN-9-3)

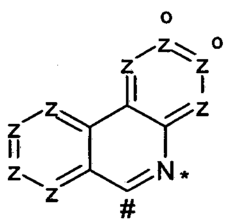
(CyN-10-1)

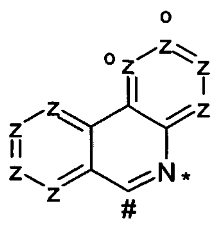
(CyN-10-2)

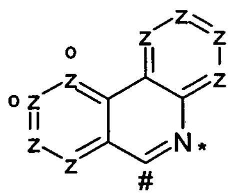
(CyN-10-3)

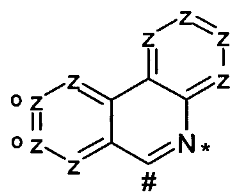
(CyN-10-4)

wobei die verwendeten Symbole die oben genannten Bedeutungen aufweisen und ° jeweils die Positionen kennzeichnet, die für CR stehen, wobei die jeweiligen Reste R zusammen mit den C-Atomen, an die sie gebunden sind, einen Ring gemäß einer der oben genannten Formeln (1) bis (7) aufspannen.

In einer weiteren Ausführungsform der Erfindung ist die Gruppe der Formel $Ir(L^1)_p$ eine Gruppe der folgenden Formel (77),

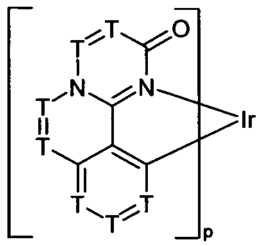
Formel (77)

wobei für die verwendeten Symbole und Indizes gilt:

T ist bei jedem Auftreten gleich oder verschieden CR oder N mit der Maßgabe, dass maximal ein Symbol T pro Cyclus für N steht, oder zwei benachbarte Symbole T stehen zusammen für eine Gruppe der folgenden Formel (78),

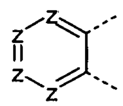
Formel (78)

wobei die gestrichelten Bindungen die Verknüpfung dieser Gruppe im Liganden symbolisieren;

Z ist bei jedem Auftreten gleich oder verschieden CR oder N mit der Maßgabe, dass maximal zwei Symbole Z pro Ligand für N stehen;

dadurch gekennzeichnet, dass benachbarte Gruppen T oder Z für CR stehen und die jeweiligen Reste R zusammen mit den C-Atomen einen Ring gemäß einer der Formeln (1) bis (7) aufspannen.

In einer weiteren bevorzugten Ausführungsform der Erfindung ist in den erfindungsgemäßen Verbindungen maximal eine Gruppe gemäß Formel (78) vorhanden. Es handelt sich also bevorzugt um Verbindungen der folgenden Formeln (79), (80), (81) oder (82),

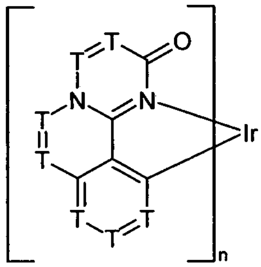

Formel (79)

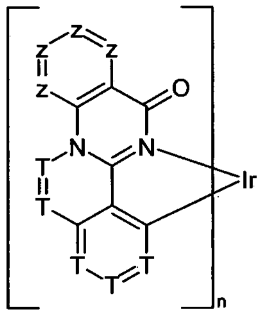

Formel (80)

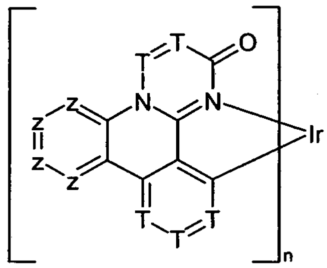

Formel (81)

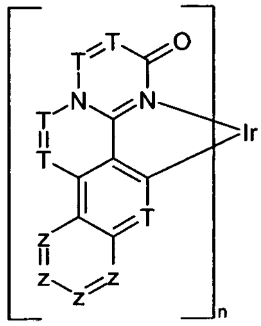

Formel (82)

wobei T bei jedem Auftreten gleich oder verschieden für CR oder N steht und die weiteren Symbole und Indizes die oben genannten Bedeutungen aufweisen.

In einer bevorzugten Ausführungsform der Erfindung stehen im oben genannten Liganden $L^1$ insgesamt 0, 1 oder 2 der Symbole T und, falls vorhanden, Z für N. Besonders bevorzugt stehen im Liganden $L^1$ insgesamt 0 oder 1 der Symbole T und, falls vorhanden, Z für N. Insbesondere bevorzugt stehen in dem Cyclus, der über das Kohlenstoffatom an das Iridium koordiniert, die Symbole T gleich oder verschieden bei jedem Auftreten für CR.

Bevorzugte Ausführungsformen der Formel (79) sind die Strukturen der folgenden Formeln (79-1) bis (79-5), bevorzugte Ausführungsformen der Formel (80) sind die Strukturen der folgenden Formeln (80-1) bis (80-8), bevorzugte Ausführungsformen der Formel (81) sind die Strukturen der folgenden Formeln (81-1) bis (81-8), und bevorzugte Ausführungsformen der Formel (82) sind die Strukturen der folgenden Formeln (82-1) bis (82-9),

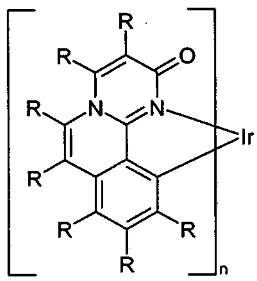

Formel (79-1)

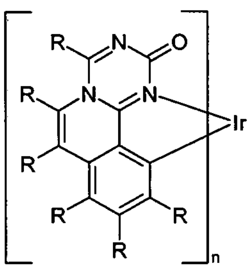

Formel (79-2)

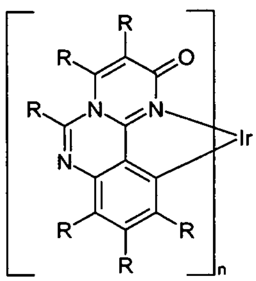

Formel (79-3)

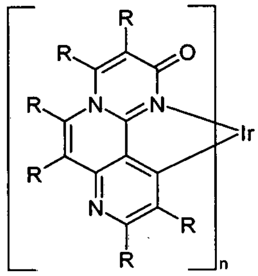
Formel (79-4)

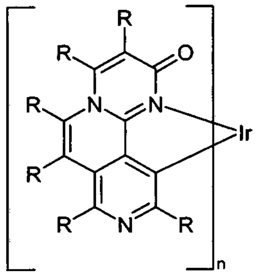
Formel (79-5)

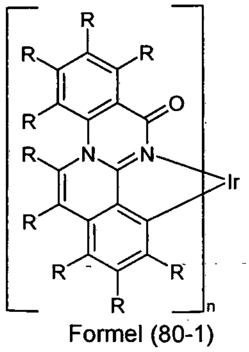
Formel (80-1)

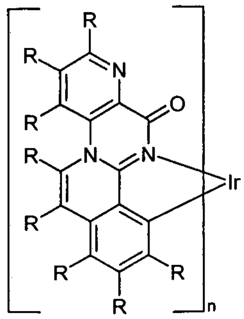
Formel (80-2)

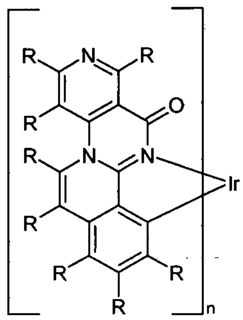
Formel (80-3)

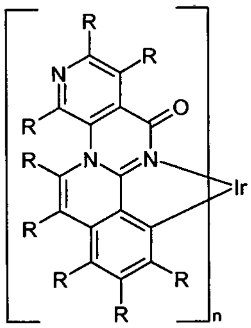
Formel (80-4)

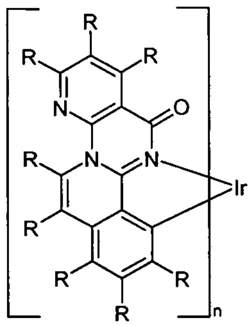
Formel (80-5)

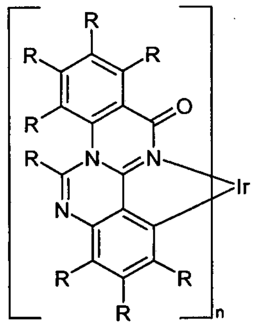
Formel (80-6)

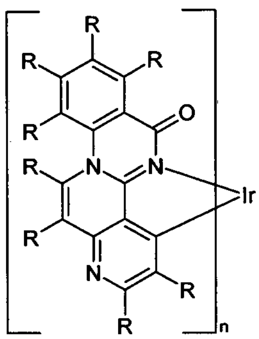
Formel (80-7)

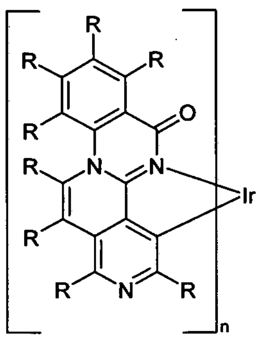
Formel (80-8)

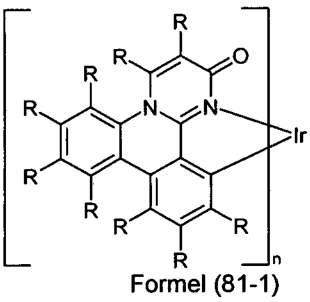
Formel (81-1)

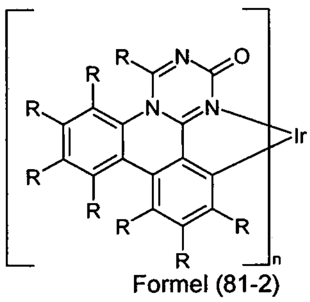
Formel (81-2)

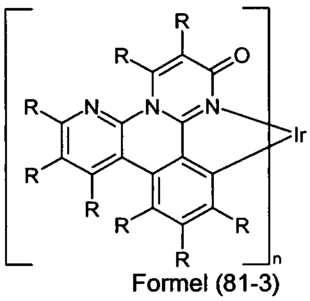
Formel (81-3)

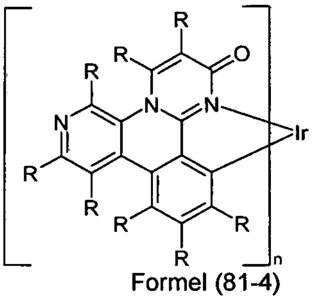
Formel (81-4)

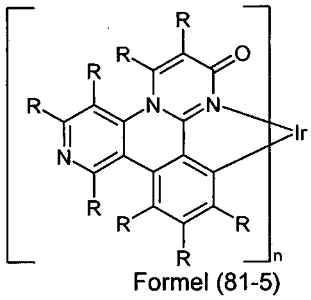
Formel (81-5)

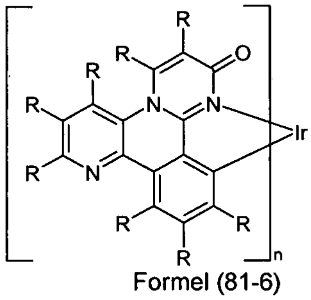
Formel (81-6)

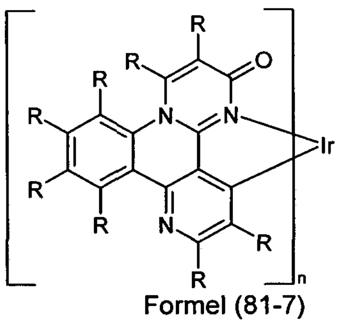
Formel (81-7)

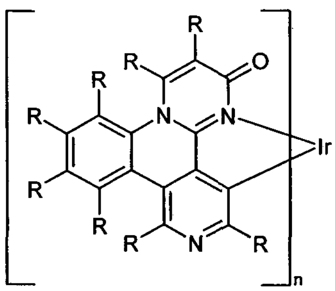
Formel (81-8)

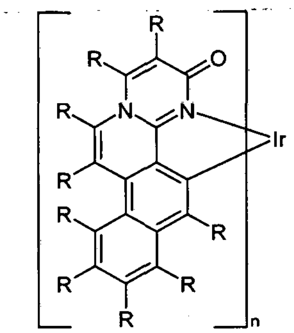
Formel (82-1)

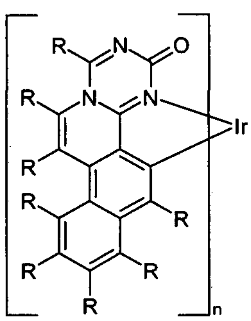
Formel (82-2)

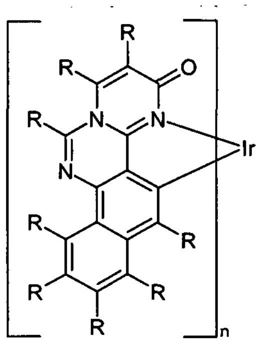
Formel (82-3)

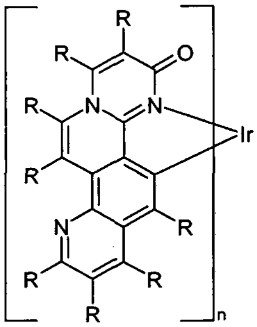

Formel (82-4)

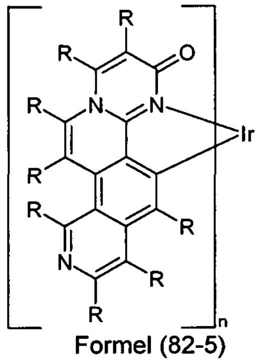

Formel (82-5)

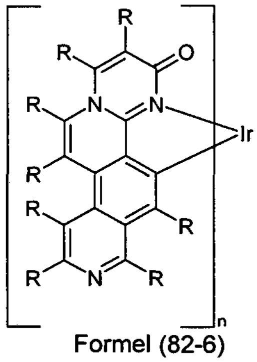

Formel (82-6)

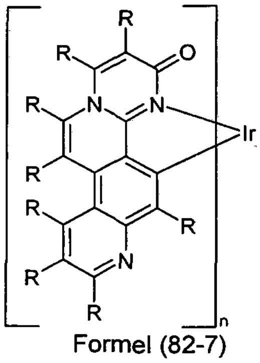

Formel (82-7)

wobei die verwendeten Symbole und Indizes die oben genannten Bedeutungen aufweisen.

In einer bevorzugten Ausführungsform der Erfindung steht die Gruppe T, die in ortho-Position zur Koordination an das Iridium vorliegt, für CR. Dabei ist dieser Rest R, der in ortho-Position zur Koordination an das Iridium gebunden ist, bevorzugt ausgewählt aus der Gruppe bestehend aus H, D, F und Methyl. Dies gilt insbesondere, wenn es sich um faciale, homoleptische Komplexe handelt, während bei meridionalen oder heteroleptischen Komplexen auch andere Reste R in dieser Position bevorzugt sein können.

Die Gruppen der Formeln (1) bis (7) können in jeder Position der oben genannten Teilstruktur vorliegen, in der zwei Gruppen T bzw., falls vorhanden, zwei Gruppen Z direkt aneinander gebunden sind.

Im Folgenden werden bevorzugte Liganden $L^2$ beschrieben, wie sie in den Iridiumverbindungen der Formel (75) vorkommen können. Die Liganden $L^2$ sind definitionsgemäß bidentate, monoanionische Liganden.

Bevorzugte monoanionische, bidentate Liganden $L^2$ sind ausgewählt aus 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 2,2,6,6-Tetramethyl-3,5-heptandion, 3-Ketonaten abgeleitet von 3-Ketoestern, wie z. B. Acetylacetat, Carboxylaten, abgeleitet von Aminocarbonsäuren, wie z. B. Pyridin-2-carbonsäure, Chinolin-2-carbonsäure, Glycin, N,N-Dimethylglycin, Alanin, N,N-Dimethylaminoalanin, und Salicyliminaten abgeleitet von Salicyliminen, wie z. B. Methylsalicylimin, Ethylsalicylimin oder Phenylsalicylimin.

In einer weiteren bevorzugten Ausführungsform der Erfindung handelt es sich bei den Liganden $L^2$ um bidentate monoanionische Liganden, welche mit dem Iridium einen cyclometallierten Fünfring oder Sechsring mit mindestens einer Iridium-Kohlenstoff-Bindung aufspannen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand $L^2$ für Verbindungen gemäß Formel (75) auswählen. Generell eignet sich dafür besonders die Kombination aus zwei Gruppen, wie sie durch die folgenden Formeln (83) bis (105) dargestellt sind, wobei eine Gruppe über ein neutrales Atom und die andere Gruppe über ein negativ geladenes Atom bindet. Dabei ist das neutrale Atom insbesondere ein neutrales Stickstoffatom oder ein Carben-Kohlenstoffatom und das negativ geladene Atom insbesondere ein negativ geladenes Kohlenstoffatom, ein negativ geladenes Stickstoffatom oder ein negativ geladenes Sauerstoffatom. Der Ligand $L^2$ kann dann aus den Gruppen der Formeln (83) bis (105) gebildet werden, indem diese Gruppen jeweils an der durch # gekennzeichneten Position aneinander binden. Die Position, an der die Gruppen an das Metall koordinieren, sind durch * gekennzeichnet. Weiterhin können hier auch zwei benachbarte Reste R, die jeweils an den beiden Gruppen der Formeln (83) bis (105) gebunden sind, miteinander ein

aliphatisches oder aromatisches Ringsystem bilden.

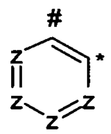
Formel (83)

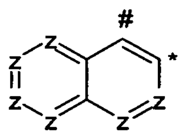
Formel (84)

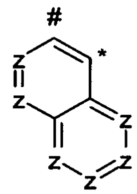
Formel (85)

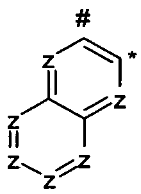
Formel (86)

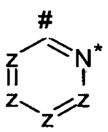
Formel (87)

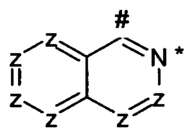
Formel (88)

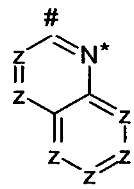
Formel (89)

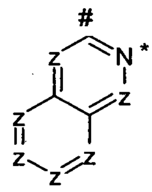
Formel (90)

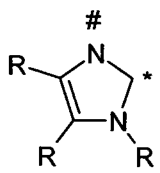
Formel (91)

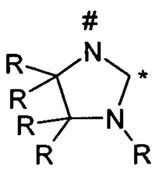
Formel (92)

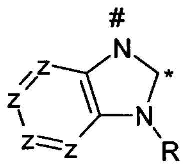
Formel (93)

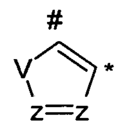
Formel (94)

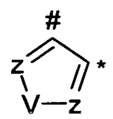
Formel (95)

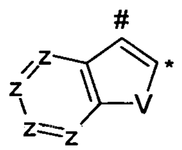
Formel (96)

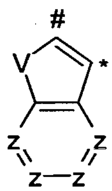
Formel (97)

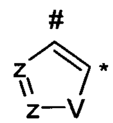
Formel (98)

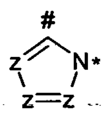
Formel (99)

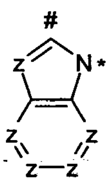
Formel (100)

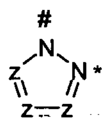
Formel (101)

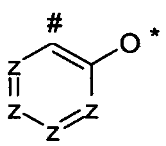
Formel (102)

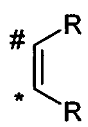
Formel (103)

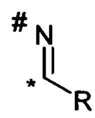
Formel (104)

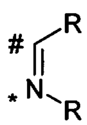
Formel (105).

Dabei haben die verwendeten Symbole dieselbe Bedeutung wie oben beschrieben, und bevorzugt stehen maximal zwei Symbole Z in jeder Gruppe für N, besonders bevorzugt steht maximal ein Symbol Z in jeder Gruppe für N. Ganz besonders bevorzugt stehen alle Symbole Z für CR.

In einer ganz besonders bevorzugten Ausführungsform der Erfindung handelt es sich bei dem Liganden $L^2$ um einen monoanionischen bidentaten Liganden, der aus zwei der Gruppen der Formeln (83) bis (105) gebildet wird, wobei eine dieser Gruppen über ein negativ geladenes Kohlenstoffatom und die andere dieser Gruppen über ein neutrales Stickstoffatom an das Iridium koordiniert.

Die weiteren bevorzugten Reste R in den oben aufgeführten Strukturen sind wie oben definiert.

Beispiele für geeignete Iridiumverbindungen sind die in der folgenden Tabelle aufgeführten Strukturen:

| | | |
|---|---|---|
| 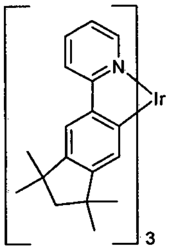 | 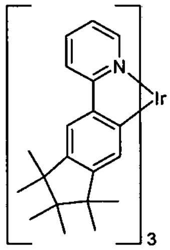 | 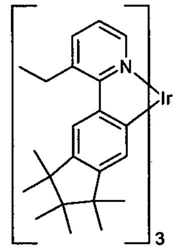 |
| 1 | 2 | 3 |
| 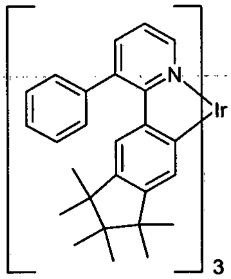 | 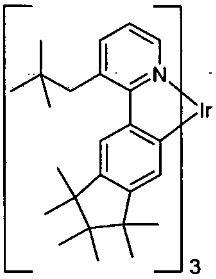 | 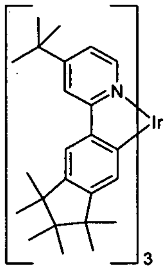 |
| 4 | 5 | 6 |
| 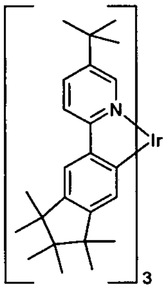 | 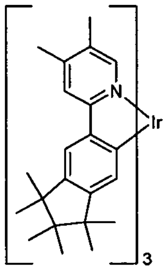 | 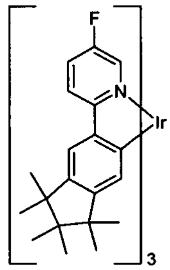 |
| 7 | 8 | 9 |
| 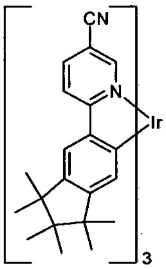 | 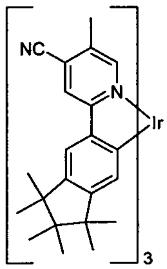 | 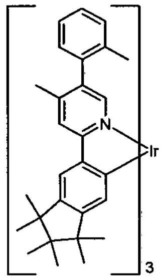 |
| 10 | 11 | 12 |

(fortgesetzt)

| | | |
|---|---|---|
| 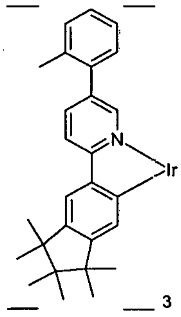 | 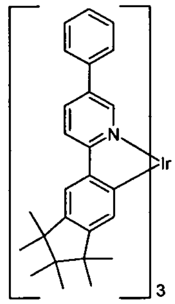 | 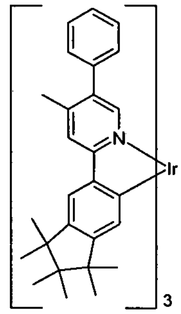 |
| 13 | 14 | 15 |
| 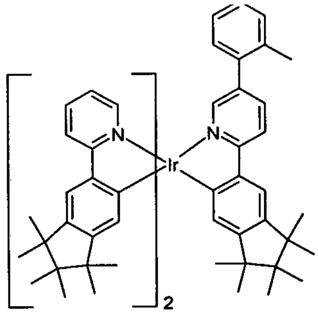 | 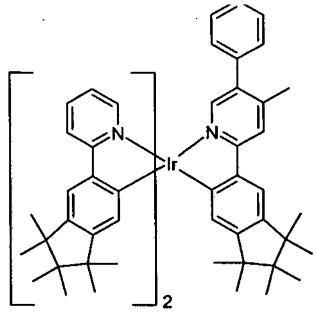 | 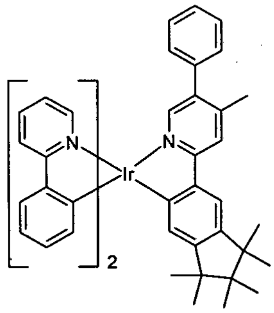 |
| 16 | 17 | 18 |
| 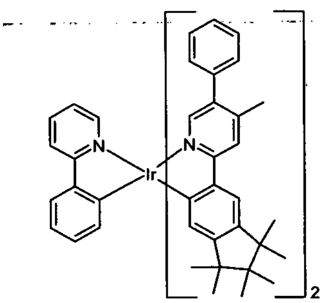 | 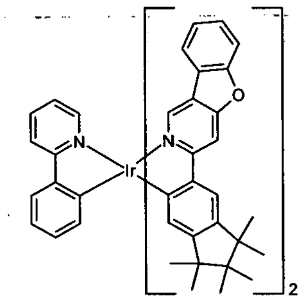 | 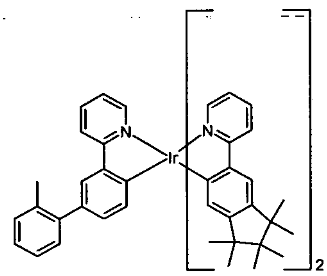 |
| 19 | 20 | 21 |
| 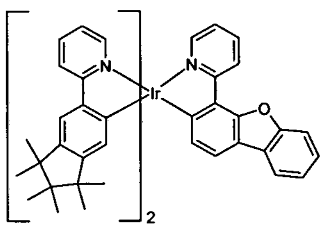 | 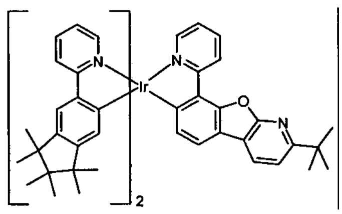 | 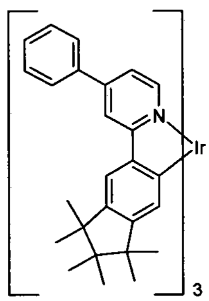 |
| 22 | 23 | 24 |

(fortgesetzt)

| | | |
|---|---|---|
| 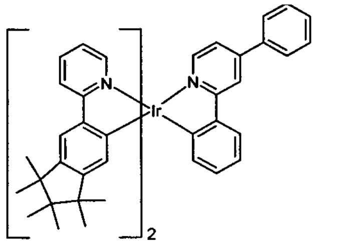 | 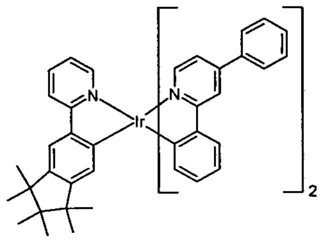 | 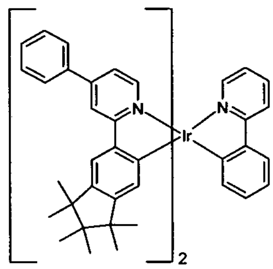 |
| 25 | 26 | 27 |
| 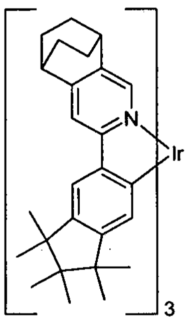 | 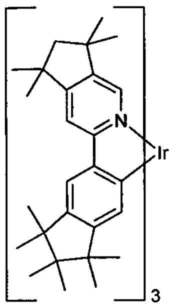 | 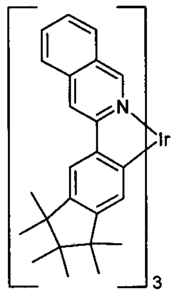 |
| 28 | 29 | 30 |
| 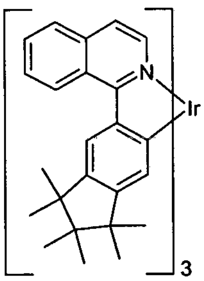 | 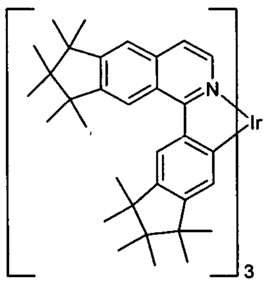 | 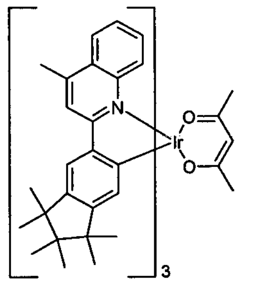 |
| 31 | 32 | 33 |
| 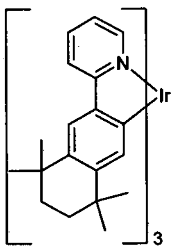 | 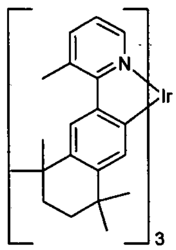 | 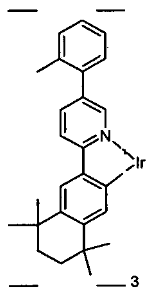 |
| 34 | 35 | 36 |

(fortgesetzt)

| | | |
|---|---|---|
| 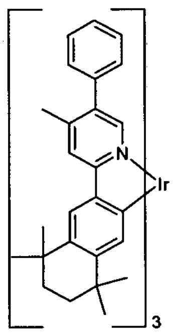 | 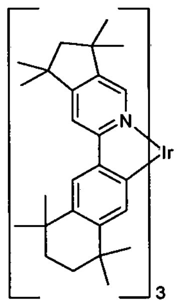 | 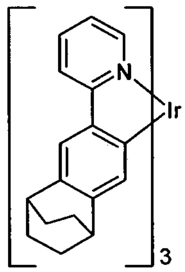 |
| 37 | 38 | 39 |
| 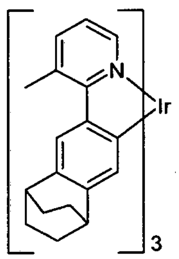 | 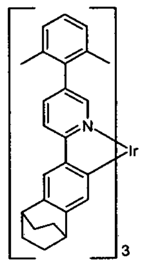 | 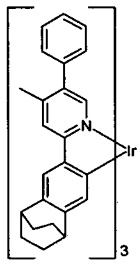 |
| 40 | 41 | 42 |
| 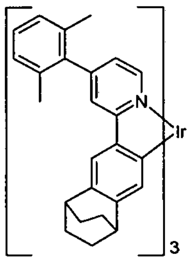 | 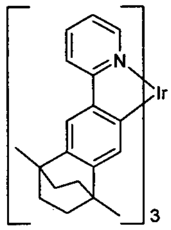 | 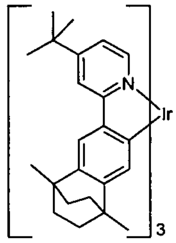 |
| 43 | 44 | 45 |
| 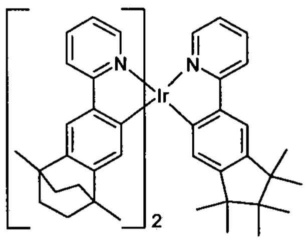 | 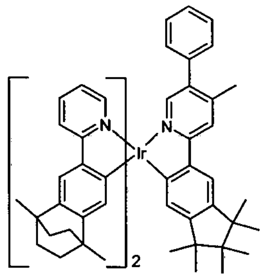 | 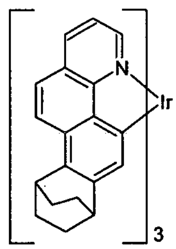 |
| 46 | 47 | 48 |
| 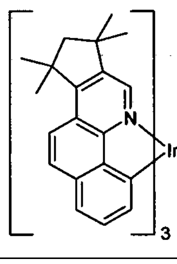 | 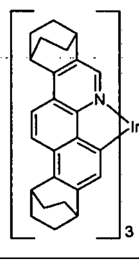 | 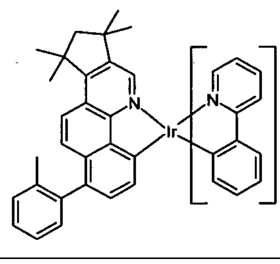 |
| 49 | 50 | 51 |

(fortgesetzt)

| | | |
|---|---|---|
| 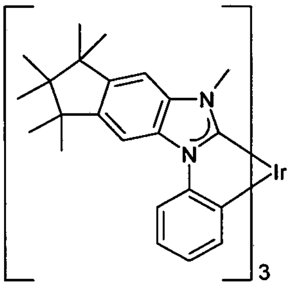 | 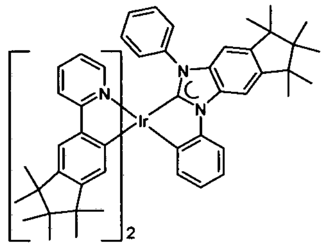 | 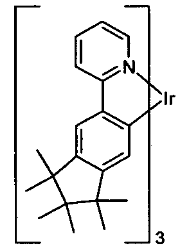 |
| 52 | 53 | 54 |
| 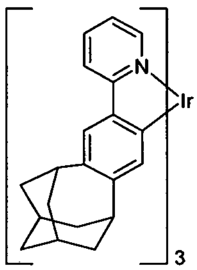 | 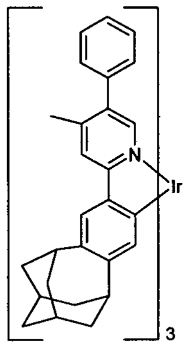 | 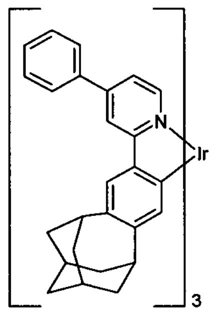 |
| 55 | 56 | 57 |
| 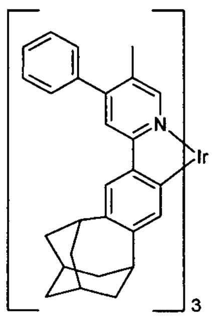 | 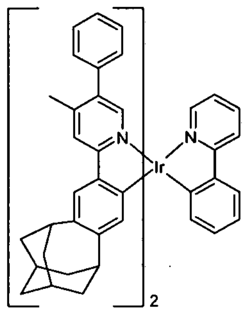 | 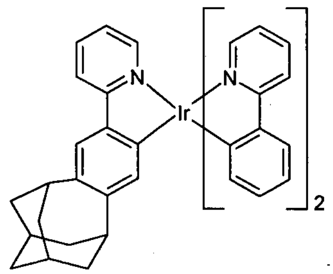 |
| 58 | 59 | 60 |

Weitere Beispiele für geeignete phosphoreszierende Iridiumverbindungen und deren Synthesen finden sich in den Anmeldungen WO 2014/008982, WO 2014/023377 und WO 2014/094960, sowie den noch nicht offen gelegten Anmeldungen EP 13004411.8, EP 14000345.0, EP 14000417.7 und EP 14002623.8. Diese sind via Zitat Bestandteil der vorliegenden Anmeldung.

Im Folgenden wird die organische Elektrolumineszenzvorrichtung näher beschrieben.

Die organische Elektrolumineszenzvorrichtung enthält Kathode, Anode und emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Es sei aber darauf hingewiesen, dass nicht notwendigerweise jede dieser Schichten vorhanden sein muss.

In den weiteren Schichten der erfindungsgemäßen organischen Elektrolumineszenzvorrichtung, insbesondere in den Lochinjektions- und -transportschichten und in den Elektroneninjektions- und -transportschichten, können alle Materialien verwendet werden, wie sie üblicherweise gemäß dem Stand der Technik eingesetzt werden. Dabein können die Lochtransportschichten auch p-dotiert bzw. die Elektronentransportschichten auch n-dotiert sein. Dabei wird unter einer p-dotierten Schicht eine Schicht verstanden, in der freie Löcher erzeugt werden und deren Leitfähigkeit dadurch erhöht ist. Eine umfassende Diskussion von dotierten Transportschichten in OLEDs findet sich in Chem. Rev. 2007, 107, 1233. Besonders bevorzugt ist der p-Dotand in der Lage, das Lochtransportmaterial in der Lochtransportschicht zu oxidieren, hat also ein ausreichend hohes Redoxpotential, insbesondere ein höheres Redoxpotential als das Lochtransportmaterial. Als Dotanden sind prinzipiell alle Verbindungen geeignet, welche Elektronenakzeptorverbindungen darstellen und die Leitfähigkeit der organischen Schicht durch Oxidation des Hosts erhöhen können. Der Fachmann kann im Rahmen seines allgemeinen Fachwissens ohne größeren Aufwand geeignete Verbindungen identifizieren. Insbesondere geeignet als Dotanden sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709 und US 2010/0096600 offenbarten Verbindungen.

Der Fachmann kann daher ohne erfinderisches Zutun alle für organische Elektrolumineszenzvorrichtungen bekannten Materialien in Kombination mit der erfindungsgemäßen emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/$NiO_x$, Al/$PtO_x$) bevorzugt sein. Dabei muss mindestens eine der Elektroden transparent oder teiltransparent sein, um die Auskopplung von Licht zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer _ derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber auch möglich, dass der Anfangsdruck noch geringer ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Ein weiterer Gegenstand der vorliegenden Erfindung ist daher ein Verfahren zur Herstellung einer erfindungsgemäßen organischen Elektrolumineszenzvorrichtung, dadurch gekennzeichnet, dass mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

Die erfindungsgemäßen organischen Elektrolumineszenzvorrichtungen zeichnen sich durch einen oder mehrere der folgenden überraschenden Vorteile gegenüber dem Stand der Technik aus:

1. Die erfindungsgemäßen organischen Elektrolumineszenzvorrichtungen weisen gleichzeite eine sehr gute Effizienz, eine sehr gute Lebensdauer und eine geringe Betriebsspannung auf.

2. Die durchweg sehr guten Deviceeigenschaften lassen sich auch mit einer geringen Emitterkonzentration erreichen. Dies wird nur bei Verwendung einer Iridiumverbindung gemäß der vorliegenden Anmeldung erreicht. Wird dagegen eine andere Iridiumverbindung in einer gemischten Matrix verwendet, wie sie in der vorliegenden Erfindung beschrieben ist, oder auch in einer gemischten Matrix aus einem loch-und einem elektronentransportierenden Material, so können gute Ergebnisse nur bei einer höheren Emitterkonzentration erreicht werden.

3. Der oben beschriebene positive Effekt wird nur erzielt, wenn genau die erfindungsgemäße Kombination aus zwei elektronentransportierenden Verbindungen und einer phosphoreszierenden Iridiumverbindung, wie oben beschrieben, verwendet werden.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße organische Elektrolumineszenzvorrichtungen herstellen.

**Beispiele:**

**Bestimmung von HOMO, LUMO, Singulett- und Triplettniveau**

Die HOMO- und LUMO-Energieniveaus sowie die Energie des niedrigsten Triplettzustands $T_1$ bzw. des niedrigsten angeregten Singulettzustands $S_1$ der Materialien werden über quantenchemische Rechnungen bestimmt. Hierzu wird das Programmpaket "Gaussian09W" (Gaussian Inc.) verwendet. Zur Berechnung organischer Substanzen ohne Metalle wird zuerst eine Geometrieoptimierung mit der Methode "Ground State/Semiempirical/Default Spin/AM1/Charge 0/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31G(d)" verwendet (Charge 0, Spin Singlet). Für metallhaltige Verbindungen wird die Geometrie über die Methode "Ground State/ Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$\mathrm{HOMO(eV)} = ((\mathrm{HEh}*27.212)-0.9899)/1.1206$$

$$\mathrm{LUMO(eV)} = ((\mathrm{LEh}*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

In Tabelle 4 sind die HOMO- und LUMO-Energieniveaus sowie $S_1$ und $T_1$ der verschiedenen Materialien angegeben.

**Synthesebeispiele**

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

**A: Synthese der Synthone S:**

**Beispiel S1: Dispiro[cyclopentan-1,1'-[1H]inden-3'(2'H),1''-cyclopentan]-5-boronsäure-pinakolester**

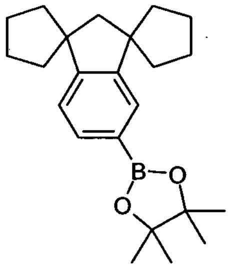

**a) Dispiro[cyclopentan-1,1'-[1H]inden-3'(2'H),1"-2-on-cyclopentan], [1620682-15-6]**

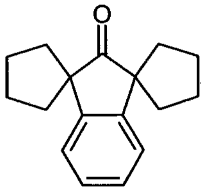

Eine Lösung von 66.1 g (500 mmol) Indan-2-on [615-13-4] und 340.9 g (1100 mmol) 1,4-Diodbutan [628-21-7] in 500 ml THF wird während 2 h zu einer gut gerührten Mischung aus 40.0 g (1 mol) NaOH, 40 ml Wasser, 18.5 g (50 mmol) Tetrabutylammoniumiodid [311-28-4] und 1500 ml THF getropft. Nach beendeter Zugabe rührt man 14 h bei Raumtemperatur nach, trennt die wässrige Phase ab und engt die organische Phase komplett ein. Man nimmt den Rückstand in 1000 ml n-Heptan auf, wäscht fünfmal mit je 300 ml Wasser und trocknet über Magnesiumsulfat. Das nach Entfernen des n-Heptans erhaltene Rohprodukt wird im Ölpumpenvakuum (ca. 0.2 mbar, T ca. 135 °C) fraktioniert destilliert. Ausbeute: 83.0 g (345 mmol), 69 %. Reinheit ca. 95 % ig n. $^1$H-NMR.

**b) Dispiro[cyclopentan-1,1'-[1H]inden-3'(2'H),1"-cyclopentan]**

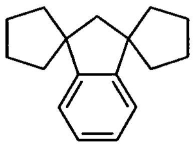

Ein Gemisch aus 83 g (345 mmol) Dispiro[cyclopentan-1,1'-[1H]inden-3'(2'**H**),1"-2-on-cyclopentan] aus a), 100.1 g (2.0 mol) Hydrazinhydrat, 112.2 g (2.5 mol) Kaliumhydroxid und 500 ml Triethylenglykol wird unter gutem Rühren 16 h bei 180 °C gerührt. Danach steigert man schrittweise die Temperatur bis 250 °C erreicht sind, wobei gebildetes Destillat über einen Wasserabscheider abgenommen und verworfen wird, und rührt nach, bis die Stickstoffentwicklung versiegt. Nach Erkalten verdünnt man die Reaktionsmischung mit 500 ml Wasser und extrahiert dreimal mit je 300 ml n-Heptan. Die vereinigten n-Heptanphasen werden fünfmal mit je 200 ml Wasser gewaschen und über Magnesiumsulfat getrocknet. Das nach Entfernen des n-Heptans erhaltene Rohprodukt wird im Ölpumpenvakuum (ca. 0.2 mbar, T ca. 105 °C) fraktioniert destilliert.-Ausbeute: 57.7 g (255 mmol), 74 %. Reinheit ca. 95 % ig n. $^1$H-NMR.

**c) Dispiro[cyclopentan-1,1'-[1H]inden-3'(2'H),1"-cyclopentan]-5-boronsäure-pinakolester**

Ein Gemisch aus 1.7 g (2.5 mmol) Methoxy(cyclooctadien)iridium(I)-Dimer [12148-71-9], 1.4 g (5 mmol), 4,4'-Di-tert-butyl-[2,2]bipyridinyl [72914-19-3] und 500 ml n-Heptan wird unter Rühren mit 14.0 g (55 mmol) Bispinacolatodiboran [73183-34-3] versetzt und 15 min. bei Raumtemperatur gerührt. Danach gibt man weitere 50.8 g (200 mmol) Bis-pinacolatodiboran und dann 57.7 g (255 mmol) Dispiro[cyclopentan-1,1'-[1H]inden-3'(2'H),1"-cyclopentan] aus b) zu und erhitzt die Reaktionsmischung 16 h auf 80 °C. Nach Erkalten entfernt man das n-Heptan im Vakuum und rührt den Rückstand zweimal mit je 400 ml Methanol aus. Ausbeute: 70.1 g (199 mmol), 78 %. Reinheit ca. 98 % ig n. $^1$H-NMR.

**B. Synthese der Liganden L**

**Beispiel L1: 2-(Dispiro[cyclopentan-1,1'-[1H]inden-3'(2'H),1"-5-yl-cyclopentan]pyridin**

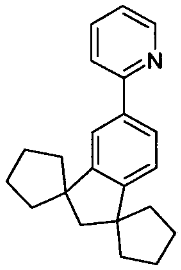

Ein gut gerührtes Gemisch aus 70.1 g (199 mmol) Dispiro[cyclopentan-1,1'-[1**H**]inden-3'(2'**H**),1"-cyclopentan]-5-boronsäure-pinakolester S1, 39.5 g (250 mmol) 2-Brompyridin [109-04-6], 115.1 g (500 mmol) Trikaliumphosphat Monohydrat, 600 ml Toluol, 600 ml Dioxan und 600 ml Wasser wird mit 841 mg (3 mmol) Tricyclohexylphosphin [2622-14-2] und dann mit 449 mg (2 mmol) Palladium(II)acetat versetzt und dann 40 h unter Rückfluss erhitzt. Nach Erkalten trennt man die organische Phase ab, wäscht diese dreimal mit je 200 ml Wasser und einmal mit 200 ml gesättigter Kochsalzlösung und trocknet über Magnesiumsulfat. Man filtriert über ein Celite-Bett vom Trockenmittel ab, zieht das Lösungsmittel und überschüssiges 2-Brompyridin ab, und Kugelrohr-destilliert das verbliebene Öl zweimal fraktioniert im Vakuum (p ca. $10^{-4}$ mbar, T ca. 220 °C). Ausbeute: 40.7 g (134 mmol), 67 %. Reinheit ca. 99 %ig nach $^1$H-NMR.

**C. Synthese der Komplexe**

**Beispiel Ir(L1)$_3$:**

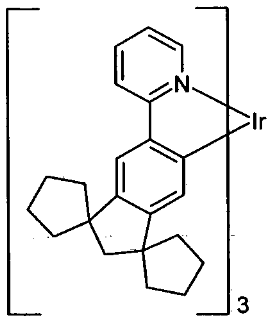

Ein Gemisch aus 30.3 g (100 mmol) des Liganden L1 und 12.2 g (25 mmol) Tris-acetylacetonato-iridium(III) [15635-87-7] werden in einem 250 ml Zweihalsrundkolben mit glasummanteltem Magnetkern vorgelegt. Der Kolben wird mit einem Wasserabscheider und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus den Seitenhals des Zweihalskolben ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch abisoliert, wobei die Isolation bis zur Mitte des Steigrohres des Wasserabscheiders geführt wird. Dann wird die Apparatur schnell mit einem Laborheizrührwerk auf 275 °C, gemessen am Pt-100 Thermofühler der in die aufgeschmolzene, gerührte Reaktionsmischung eintaucht, erhitzt. Während der nächsten 20 h wird das Reaktionsgemisch bei 270-275 °C gehalten, wobei sukzessive ca. 5 ml Acetylaceton abdestillieren und sich im Wasserabscheider sammeln. Nach Erkalten wird der Schmelzkuchen mechanisch zerkleinert und dann mit 300 ml Methanol ausgekocht. Die so erhaltenene beige Suspension wird über eine Umkehrfritte filtriert, der beige Feststoff wird einmal mit Methanol gewaschen und dann im Vakuum getrocknet. Rohausbeute: quantitativ. Anschließend wird das so erhaltene Rohprodukt unter Luft- und Lichtausschluss mit Toluol an Kieselgel (ca. 100 g pro g Rohprodukt) chromatographiert, wobei das Produkt (gelbe Bande) fast mit der Laufmittelfront eluiert und dunkle Nebenkomponenten am Start zurückbleiben. Man schneidet die Kernfraktion der gelben Bande heraus, entfernt das Toluol im Vakuum und nimmt das verbleibende gelbe Glas in 200 ml heißem Acetonitril auf, wobei die Kristallisation des Produktes eintritt. Nach einstündigem Nachrühren saugt man die erkaltete Suspension über eine Umkehrfritte ab und wäscht den gelben Feststoff einmal mit 50 ml Acetonitril. Die weitere Reinigung erfolgt durch fünfmalige kontinuierliche Heißextraktion mit Acetonitril (Vorlagemenge Acetonitril ca. 300 ml, Extraktionshülse: standard Soxhletthülsen aus Cellulose der Fa. Whatman) unter sorgfältigem Luft- und Lichtausschluss. Abschließend wird das Produkt zweimal im Vakuum fraktioniert sublimiert (p ca. $10^{-5}$ mbar, T ca. 340 °C). Ausbeute: 11.5 g, 42 %. Reinheit: > 99.9 % nach HPLC.

**Beispiel: Herstellung der OLEDs**

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (50 nm, Indium-Zinn-Oxid) bilden die Substrate, auf weiche die OLEDs aufgebracht werden. Die OLEDs haben prinzipiell folgenden Schichtaufbau: Substrat / Lochtransportschicht 1 (HTL1) bestehend aus HTM dotiert mit 3 % NDP-9 (kommerziell erhältlich von der Fa. Novaled), 20 nm / Lochtransportschicht 2 (HTL2) / optionale Elektronenblockierschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M3:M2:$Ir(LH1)_3$ (55%:35%:10%) bedeutet hierbei, dass das Material M3 in einem Volumenanteil von 55%, M2 in einem Anteil von 35% und $Ir(LH1)_3$ in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 3 gezeigt.

Die OLEDs werden standardmäßig charakterisiert. Hierfür werden die Elektrolumineszenzspektren, die Stromeffizienz (gemessen in cd/A) und die Spannung (gemessen bei 10 $mA/cm^2$ in V) bestimmt aus den Strom-Spannungs-Helligkeits-Kennlinien (IUL-Kennlinien). Daraus abgeleitet werden die externe Quanteneffizienz (EQE) und die Farbkoordinaten nach CIE 1931. Für ausgewählte Versuche wird die Lebensdauer bestimmt. Als Lebensdauer wird die Zeit definiert, nach der die Leuchtdichte bei definiertem, festgehaltenem Betriebsstrom (typischerweise 50 $mA/cm^2$) von ihrer Startleuchtdichte auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist. Die Werte für die Lebensdauer können mit Hilfe dem Fachmann bekannten Umrechnungsformeln auf eine Angabe für andere Startleuchtdichten umgerechnet werden.

In der unten folgenden Tabelle 1 sind die Schichtaufbauten und verwendeten Materialien (siehe Tabelle 3) sowohl für erfindungesgemäße OLEDs als auch Vergleichsbeispiele dargestellt. Die zughörigen Ergebnisse der OLEDs sind in Tabelle 2 zusammengefasst. Als HTL1 wurde grundsätzlich HTM dotiert mit 3% NDP-9 verwendet.

Die Beispiele 1-3 verdeutlichen den entscheidenen Effekt dieser Erfindung. Die erfindungsgemäße Mischung von zwei elektronentransportierenden Matrixmaterialien mit einem gemäß der Erfindung definierten Emitter (siehe 1a, 1b, 1c) führt zu OLEDs, die gleichzeitig eine hohe Effizienz, niedrige Spannung und lange Lebensdauer aufweisen. Vorteilhaft ist darüber hinaus, dass bei Reduktion der Emitterkonzentration von 18% auf 12% auf 6% die Spannung dabei niedriger wird und gleichzeitig die Effizienz höher, ohne die Lebensdauer wesentlich negativ zu beeinflussen. Im Gegensatz dazu zeigt Beispiel 2, dass bei Verwendung von einem nicht der Erfindung entsprechenden Emitter im gleichen Matrixsystem die Effizienz deutlich schwächer ist. Ebenso führt eine Reduktion der Emitterkonzentration nicht zu einer Reduktion der Spannung, sondern im Gegenteil zu einer Erhöhung. Umgekehrt führt die Verwendung einer nicht erfindungesgemäßen Mischung aus einem elektronen- und einem lochleitenden Matrixmaterial mit dem Emitter aus Beispiel 1 zu OLEDs mit einer erhöhten Betriebsspannung (siehe Beispiel 3).

Nur die erfindungsgemäße Kombination aus geeigneten Emittern, wie in der vorliegenden Erfindung definiert, mit zwei elektronentransportierenden Matrizes führt zu OLEDs, die in allen drei Parametern Effizienz, Spannung und Lebensdauer (und das im Nebeneffekt bei geringer Emitterkonzentration) gleichzeitig gute Leistungsdaten zeigen. Dass dieser Effekt nicht auf die spezifisch in Beispiel 1 gewählten Materialien oder Schichtarchitekturen beschränkt ist, demonstrieren die weiteren Ausführungsbeispiele ab Beispiel 4, in denen weitere Materialien erfindungsgemäß kombiniert werden, teilweise auch mit anderen Elektronen- oder Lochblockierschichten.

Tabelle 1: Aufbau der OLEDs

| Bsp. | HTL2 Dicke | EBL Dicke | EML Dicke | HBL Dicke | ETL Dicke |
|---|---|---|---|---|---|
| **Grüne OLEDs** | | | | | |
| 1a | HTM 220 nm | EBM 20 nm | eM1:eM4:G1 (44%:44%: 12%) 30 nm | ETM110 nm | ETM1:ETM2 (50%: 50%) 30 nm |
| 1b | HTM 220 nm | EBM 20 nm | eM1:eM4:G1 (47%:47%: 6%) 30 nm | ETM110 nm | ETM1:ETM2 (50%: 50%) 30 nm |
| 1c | HTM 220 nm | EBM 20 nm | eM1:eM4:G1 (41%:41%: 18%) 30 nm | ETM110 nm | ETM1:ETM2 (50%: 50%) 30 nm |
| 2a (Vergleich) | HTM 220 nm | EBM 20 nm | eM1:eM4:Irppy (44%: 44%:12%) 30 nm | ETM110 nm | ETM1:ETM2 (50%: 50%) 30 nm |
| 2b (Vergleich) | HTM 220 nm | EBM 20 nm | eM1:eM4:Irppy (47%: 47%:6%) 30 nm | ETM110 nm | ETM1:ETM2 (50%: 50%) 30 nm |
| 2c (Vergleich) | HTM 220 nm | EBM 20 nm | eM1:eM4:Irppy (41%: 41%:18%) 30 nm | ETM110 nm | ETM1:ETM2 (50%: 50%) 30 nm |
| 3a (Vergleich) | HTM 220 nm | EBM 20 nm | hM1:eM4:G1 (44%:44%: 12%) 30nm | ETM110 nm | ETM1:ETM2 (50%: 50%) 30 nm |
| 3b (Vergleich) | HTM 220 nm | EBM 20 nm | hM1:eM4:G1 (47%:47%: 6%) 30 nm | ETM110 nm | ETM1:ETM2 (50%: 50%) 30 nm |
| 3c (Vergleich) | HTM 220 nm | EBM 20 nm | hM1:eM4:G1 (41%:41%: 18%) 30 nm | ETM110 nm | ETM1:ETM2 (50%: 50%) 30 nm |
| 4a | HTM 220 nm | EBM 20 nm | eM1:eM5:G1 (44%:44%: 12%) 30 nm | ETM110 nm | ETM1:ETM2 (50%: 50%) 30 nm |
| 4b | HTM 220 nm | EBM 20 nm | eM1:eM5:G1 (47%:47%: 6%) 30 nm | ETM110 nm | ETM1:ETM2 (50%: 50%) 30 nm |
| 4c | HTM 220 nm | EBM 20 nm | eM1:eM5:G1 (41%:41%: 18%) 30 nm | ETM110 nm | ETM1:ETM2 (50%: 50%) 30 nm |
| 5a (Vergleich) | HTM 220 nm | EBM 20 nm | hM2:eM2:G1 (44%:44%: 12%) 30 nm | ETM110 nm | ETM1:ETM2 (50%: 50%) 30 nm |
| 5b (Vergleich) | HTM 220 nm | EBM 20 nm | hM2:eM5:G1 (47%:47%: 6%) 30 nm | ETM110 nm | ETM1:ETM2 (50%: 50%) 30 nm |
| 5c (Vergleich) | HTM 220 nm | EBM 20 nm | hM2:eM5:G1 (41%:41%: 18%) 30 nm | ETM110nm | ETM1:ETM2 (50%: 50%) |
| 6a | HTM 220 nm | EBM 20 nm | eM2:eM4:G1 (44%:44%: 12%) 30 nm | eM210 nm | ETM1:ETM2 (50%: 50%) 30 nm |
| 6b | HTM 220 nm | EBM 20 nm | eM2:eM4:G1 (47%:47%: 6%) 30 nm | eM210 nm | ETM1:ETM2 (50%: 50%) 30 nm |
| 6c | HTM 220 nm | EBM 20 nm | eM2:eM4:G1 (41%:41%: 18%) 30 nm | eM210 nm | ETM1:ETM2 (50%: 50%) 30 nm |
| 7a | HTM 220 nm | EBM 20 nm | eM1:eM4:G1 (24%:70%: 6%) 30 nm | ETM110 nm | ETM1:ETM2 (50%: 50%) 30 nm |
| 7b | HTM 220 nm | EBM 20 nm | eM1:eM4:G1 (70%:24%: 6%) 30 nm | ETM110 nm | ETM1:ETM2 (50%: 50%) 30 nm |
| 8 | HTM 240 nm | --- | eM1:eM4:G1 (44%:44%: 12%) 30 nm | ETM110 nm | ETM1:ETM2 (50%: 50%) 30 nm |

(fortgesetzt)

| Bsp. | HTL2 Dicke | EBL Dicke | EML Dicke | HBL Dicke | ETL Dicke |
|---|---|---|---|---|---|
| **Grüne OLEDs** | | | | | |
| 9 | HTM 240 nm | --- | eM1:eM4:G1 (44%:44%: 12%) 30 nm | --- | ETM1:ETM2 (50%: 50%) 40 nm |
| 10 | HTM 220 nm | EBM 20 nm | eM3:eM4:G1 (47%:47%: 6%) 30 nm | ETM110 nm | ETM1:ETM2 (50%: 50%) 30 nm |
| 11 | HTM 220 nm | EBM 20 nm | eM5:eM6:G1 (47%:47%: 6%) 30 nm | ETM110 nm | ETM1:ETM2 (50%: 50%) 30 nm |
| 12 | HTM 220 nm | EBM 20 nm | eM1:eM4:G2 (47%:47%: 6%) 30 nm | ETM110 nm | ETM1:ETM2 (50%: 50%) 30 nm |
| 13 | HTM 220 nm | EBM 20 nm | eM1:eM4:G3 (47%:47%: 6%) 30 nm | ETM110 nm | ETM1:ETM2 (50%: 50%) 30 nm |
| **Rote OLEDs** | | | | | |
| 14 (Vergleich) | HTM 280 nm | --- | eM1:hM1:R1 (63%:31%: 6%) 40 nm | --- | ETM1:ETM2 (50%: 50%) 30 nm |
| 15a (Vergleich) | HTM 280 nm | --- | eM1:eM4:Irpiq (47%:47%: 3%) 40 nm | --- | ETM1:ETM2 (50%: 50%) 30 nm |
| 15b (Vergleich) | HTM 280 nm | --- | eM1:eM4:Irpiq (47%:47%: 7%) 40 nm | --- | ETM1:ETM2 (50%: 50%) 30 nm |
| 16a | HTM 280 nm | --- | eM1:eM4:R1 (47%:47%: 3%) 40 nm | --- | ETM1:ETM2 (50%: 50%) 30 nm |
| 16b | HTM 280 nm | --- | eM1:eM4:R1 (47%:47%: 7%) 40 nm | --- | ETM1:ETM2 (50%: 50%) 30 nm |
| **Gelbe OLEDs** | | | | | |
| 17a (Vergleich) | HTM 220 nm | EBM 20 nm | hM1:eM1:Y1 (41%:41%: 18%) 30 nm | ETM110 nm | ETM1:ETM2 (50%: 50%) 30 nm |
| 17b (Vergleich) | HTM 220 nm | EBM 20 nm | hM1:eM1:Y1 (44%:44%: 12%) 30 nm | ETM110 nm | ETM1:ETM2 (50%: 50%) 30 nm |
| 17c (Vergleich) | HTM 220 nm | EBM 20 nm | hM1:eM1:Y1 (47%:47%: 6%) 30 nm | ETM110 nm | ETM1:ETM2 (50%: 50%) 30 nm |
| 18a | HTM 220 nm | EBM 20 nm | eM1:eM4:Y1 (41%:41%: 18%) 30 nm | ETM110 nm | ETM1:ETM2 (50%: 50%) 30 nm |
| 18b | HTM 220 nm | EBM 20 nm | eM1:eM4:Y1 (44%:44%: 12%) 30 nm | ETM110 nm | ETM1:ETM2 (50%: 50%) 30 nm |
| 18c | HTM 220 nm | EBM 20 nm | eM1:eM4:Y1 (47%:47%: 6%) 30 nm | ETM110 nm | ETM1:ETM2 (50%: 50%) 30 nm |

Tabelle 2: Ergebnisse der Vakuum-prozessierten OLEDs

| Bsp. | EQE (%) [Leist.-Eff.] 10 mA/cm² | Spannung (V) 10 mA/cm² | CIE x/y 10 mA/cm² | LD50 (h) 50 mA/cm² |
|---|---|---|---|---|
| **Grüne OLEDs** | | | | |
| 1a | 19.8 [55.3 lmW] | 4.3 | 0.34/0.63 | 500 |
| 1b | 21.0 [63.1 lm/W] | 4.0 | 0.32/0.64 | 400 |

(fortgesetzt)

| Bsp. | EQE (%) [Leist.-Eff.] 10 mA/cm2 | Spannung (V) 10 mA/cm2 | CIE x/y 10 mA/cm2 | LD50 (h) 50 mA/cm2 |
|---|---|---|---|---|
| **Grüne OLEDs** | | | | |
| 1c | 17.2 [43.9 lmW/] | 4.7 | 0.35/0.62 | 500 |
| 2a (Vergleich) | 15.3 [41.4 lm/W] | 4.3 | 0.30/0.64 | 300 |
| 2b (Vergleich) | 15.6 [38.8 lmW/] | 4.7 | 0.31/0.64 | 250 |
| 2c (Vergleich) | 15.0 [42.9 lm/W] | 4.1 | 0.31/0.64 | 300 |
| 3a (Vergleich) | 21.2 [50.9 lm/W] | 5.0 | 0.33/0.64 | 400 |
| 3b (Vergleich) | 22.2 [55.4 lm/W] | 4.8 | 0.33/0.64 | 400 |
| 3c (Vergleich) | 19.7 [43.7 lm/W] | 5.4 | 0.32/0.65 | 400 |
| 4a | 20.0 [55.8 lm/W] | 4.3 | 0.34/0.63 | 600 |
| 4b | 21.2 [63.6 lm/W] | 4.0 | 0.32/0.64 | 400 |
| 4c | 16.8 [44.8 lm/W] | 4.5 | 0.35/0.62 | 500 |
| 5a (Vergleich) | 19.6 47.0 lm/W | 5.0 | 0.33/0.64 | 300 |
| 5b (Vergleich) | 21.2 [54.1 lm/W] | 4.7 | 0.34/0.63 | 350 |
| 5c (Vergleich) | 19.4 42.3 lm/W] | 5.5 | 0.32/0.65 | 400 |
| 6a | 20.4 [55.6 lm/W] | 4.4 | 0.34/0.63 | 500 |
| 6b | 21.5 [62.9 lm/W] | 4.1 | 0.32/0.64 | 500 |
| 6c | 18.2 [47.5 lm/W] | 4.6 | 0.35/0.62 | 600 |
| 7a | 19.9 [55.1 lm/W] | 4.3 | 0.33/0.64 | 450 |
| 7b | 20.8 [63.4 lm/W] | 3.9 | 0.33/0.63 | 400 |
| 8 | 19.4 [56.4 lm/W] | 4.1 | 0.34/0.63 | 600 |
| 9 | 19.3 [56.5 lm/W] | 4.1 | 0.34/0.63 | 600 |
| 10 | 20.5 [61.5 lm/W] | 4.0 | 0.32/0.63 | 400 |
| 11 | 19.5 [57.1 lm/W] | 4.1 | 0.33/0.63 | 350 |
| 12 | 19.7 [58.1 lm/W] | 4.0 | 0.36/0.62 | 350 |
| 13 | 19.3 [59.0 lm/W] | 3.9 | 0.33/0.64 | 300 |
| **Rote OLEDs** | | | | |
| 14 (Vergleich) | 16.2 | 3.9 | 0.70/0.30 | 700 |
| 15a (Vergleich) | 13.5 | 3.7 | 0.68/0.32 | 1400 |
| 15b (Vergleich) | 13.2 | 3.7 | 0.68/0.32 | 1700 |

(fortgesetzt)

| | | | | |
|---|---|---|---|---|
| **Rote OLEDs** | | | | |
| 16a | 16.7 | 3.5 | 0.70/0.30 | 3500 |
| 16b | 16.2 | 3.7 | 0.70/0.30 | 5000 |
| | | | | |
| **Gelbe OLEDs** | | | | |
| 17a (Vergleich) | 17.9 | 4.7 | 0.48/0.52 | 850 |
| 17b (Vergleich) | 18.0 | 4.8 | 0.48/0.52 | 800 |
| 17c (Vergleich) | 18.3 | 4.6 | 0.46/0.53 | 600 |
| 18a | 18.9 | 4.4 | 0.48/0.52 | 1000 |
| 18b | 18.4 | 4.2 | 0.48/0.52 | 900 |
| 18c | 16.0 | 4.1 | 0.46/0.53 | 750 |

Tabelle 3: Strukturformeln der verwendeten Materialien

| | |
|---|---|
| 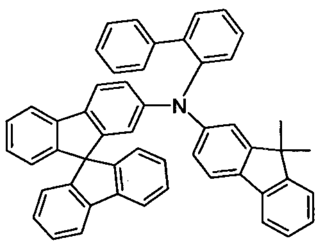 | 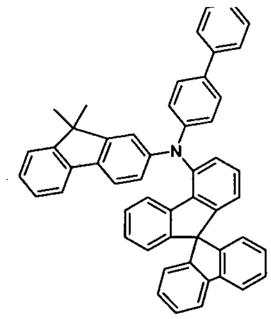 |
| HTM | EBM |
| 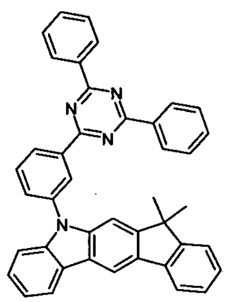 | 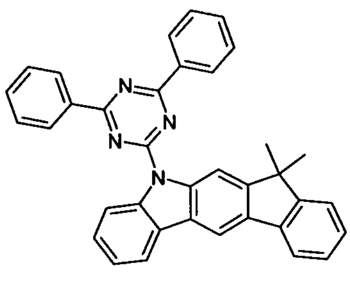 |
| eM1 | eM2 |
| 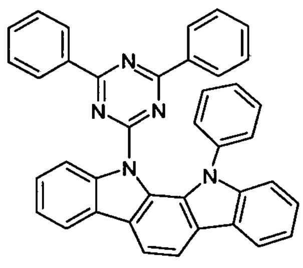 | 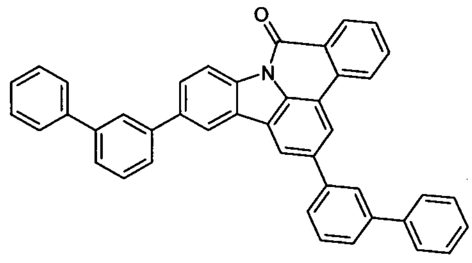 |

(fortgesetzt)

| | |
|---|---|
| eM3 | eM4 |
| 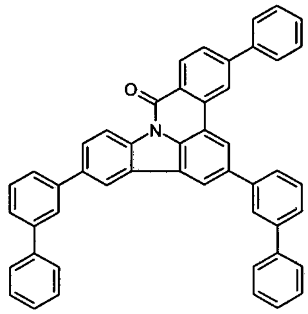 | 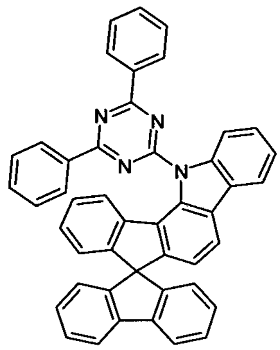 |
| eM5 | eM6 |
| 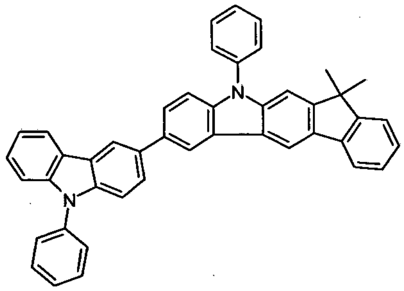 | 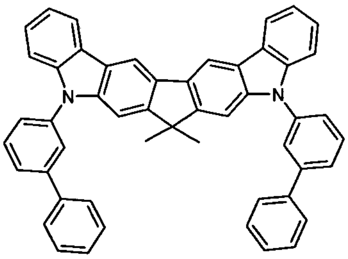 |
| hM1 | hM2 |
| 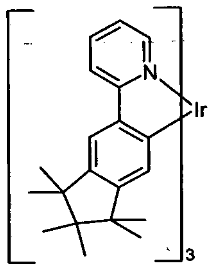 | 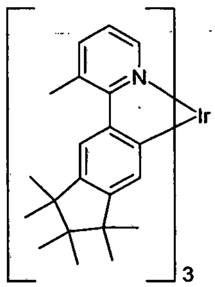 |
| G1 | G2 |
| 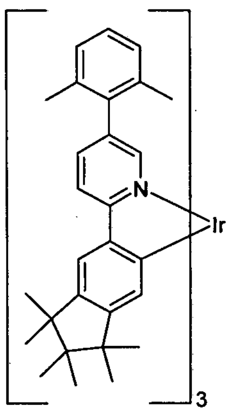 | 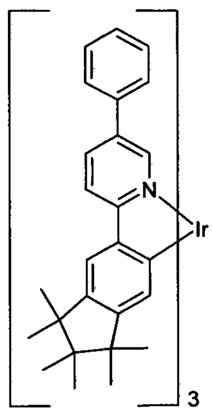 |
| G3 | Y1 |

(fortgesetzt)

| | |
|---|---|
| 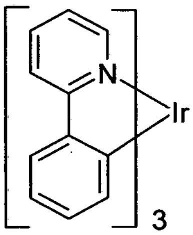 | 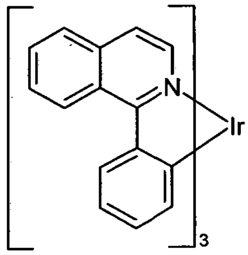 |
| Irppy | Irpiq |
| 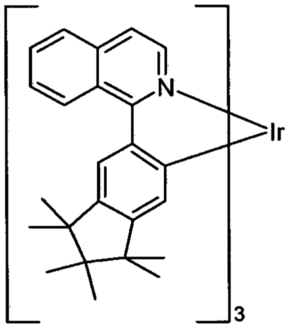 | |
| R1 | |
| 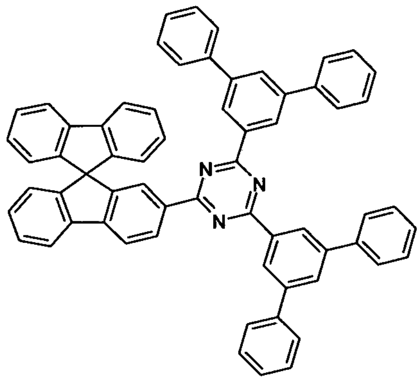 | 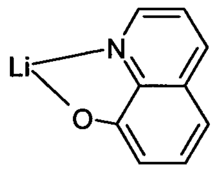 |
| ETM1 | ETM2 / Liq |

Tabelle 4: HOMO, LUMO, $S_1$ und $T_1$ der verwendeten Materialien

| Material | HOMO [eV] | LUMO [eV] | S1 [eV] | T1 [eV] |
|---|---|---|---|---|
| eM1 | -5.47 | -2.60 | 2.87 | 2.72 |
| eM2 | -5.68 | -2.55 | 3.09 | 2.69 |
| eM3 | -5.67 | -2.49 | 3.07 | 2.75 |
| eM4 | -5.95 | -2.54 | 3.27 | 2.68 |
| eM5 | -5.94 | -2.60 | 3.21 | 2.66 |
| eM6 | -5.76 | -2.58 | 3.14 | 2.72 |
| hM1 | -5.32 | -1.84 | 3.24 | 2.80 |
| hM2 | -5.21 | -1.58 | 3.14 | 2.73 |

## Patentansprüche

1. Organische Elektrolumineszenzvorrichtung, enthaltend Kathode, Anode und eine emittierende Schicht, die die folgenden Verbindungen enthält:

(A) mindestens eine elektronentransportierende Verbindung, die ein LUMO $\leq$ -2.4 eV aufweist; und
(B) mindestens eine weitere elektronentransportierende Verbindung, die von der ersten elektronentransportierenden Verbindung verschieden ist und ein LUMO $\leq$ -2.4 eV aufweist; und
(C) mindestens eine phosphoreszierende Iridiumverbindung, die mindestens einen mindestens bidentaten Liganden aufweist, der über ein Kohlenstoffatom und ein Stickstoffatom oder über zwei Kohlenstoffatome an das Iridium bindet und der mindestens eine Einheit gemäß einer der folgenden Formeln (1) bis (7) aufweist,

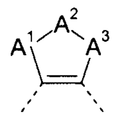
Formel (1)

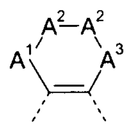
Formel (2)

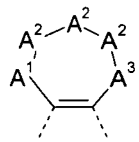
Formel (3)

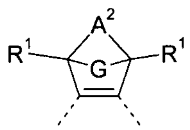
Formel (4)

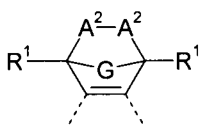
Formel (5)

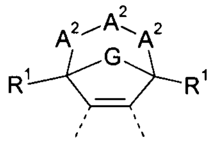
Formel (6)

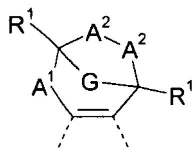
Formel (7)

wobei die beiden explizit eingezeichneten Kohlenstoffatome Atome sind, die Teil des Liganden sind, und die gestrichelten Bindungen die Verknüpfung der beiden Kohlenstoffatome im Liganden andeuten und weiterhin gilt:

$A^1$, $A^3$ ist gleich oder verschieden bei jedem Auftreten $C(R^3)_2$, O, S, $NR^3$ oder C(=O);
$A^2$ ist $C(R^1)_2$, O, S, $NR^3$ oder C(=O);
mit der Maßgabe, dass in den Gruppen der Formeln (1) bis (7) nicht zwei Heteroatome direkt aneinander gebunden sind und dass nicht zwei Gruppen C=O direkt aneinander gebunden sind;

G ist eine Alkylengruppe mit 1, 2 oder 3 C-Atomen, welche mit einem oder mehreren Resten $R^2$ substituiert sein kann, $-CR^2=CR^2-$ oder eine ortho-verknüpfte Arylen- oder Heteroarylengruppe mit 5 bis 14 aromatischen Ringatomen, welche durch einen oder mehrere Reste $R^2$ substituiert sein kann;
$R^1$ ist bei jedem Auftreten gleich oder verschieden H, D, F, Cl, Br, I, $N(R^2)_2$, CN, $Si(R^2)_3$, $B(OR^2)_2$, $C(=O)R^2$, eine geradkettige Alkyl-, Alkoxy- oder Thioalkoxygruppe mit 1 bis 20 C-Atomen oder eine geradkettige Alkenyl- oder Alkinylgruppe mit 2 bis 20 C-Atomen oder eine verzweigte oder cyclische Alkyl-, Alkenyl-, Alkinyl-, Alkoxy- oder Thioalkoxygruppe mit 3 bis 20 C-Atomen, die jeweils mit einem oder mehreren Resten $R^2$ substituiert sein kann, wobei eine oder mehrere nicht benachbarte $CH_2$-Gruppen durch $R^2C=CR^2$, $Si(R^2)_2$, C=O, $NR^2$, O, S oder $CONR^2$ ersetzt sein können und wobei ein oder mehrere H-Atome durch D, F oder CN ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 40 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann; dabei können zwei oder mehrere benachbarte Reste $R^1$ miteinander ein aliphatisches Ringsystem bilden;
$R^2$ ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch D oder F ersetzt sein können; dabei können zwei oder mehrere Substituenten $R^2$ auch miteinander ein aliphatisches oder aromatisches Ringsystem bilden;
$R^3$ ist gleich oder verschieden bei jedem Auftreten F, eine geradkettige Alkyl- oder Alkoxygruppe mit 1 bis 10 C-Atomen, eine verzweigte oder cyclische Alkyl- oder Alkoxygruppe mit 3 bis 10 C-Atomen,

die jeweils mit einem oder mehreren Resten $R^2$ substituiert sein kann, wobei eine oder mehrere nicht benachbarte $CH_2$-Gruppen durch $R^2C=CR^2$, $Si(R^2)_2$, C=O, $NR^2$, O, S oder $CONR^2$ ersetzt sein können und wobei ein oder mehrere H-Atome durch D oder F ersetzt sein können, oder ein aromatisches oder heteroaromatisches Ringsystem mit 5 bis 24 aromatischen Ringatomen, das jeweils durch einen oder mehrere Reste $R^2$ substituiert sein kann, oder eine Aryloxy- oder Heteroaryloxygruppe mit 5 bis 24 aromatischen Ringatomen, die durch einen oder mehrere Reste $R^2$ substituiert sein kann, oder eine Aralkyl- oder Heteroaralkylgruppe mit 5 bis 24 aromatischen Ringatomen, die durch einen oder mehrere Reste $R^2$ substituiert sein kann; dabei können zwei Reste $R^3$, welche an dasselbe Kohlenstoffatom gebunden sind, miteinander ein aliphatisches oder aromatisches Ringsystem bilden und so ein Spirosystem aufspannen; weiterhin kann $R^3$ mit einem benachbarten Rest $R^1$ ein aliphatisches Ringsystem bilden.

2. Organische Elektrolumineszenzvorrichtung nach Anspruch 1, **dadurch gekennzeichnet, dass** das LUMO von jeder der elektronentransportierenden Verbindungen $\leq$ -2.50 eV beträgt.

3. Organische Elektrolumineszenzvorrichtung nach Anspruch 1 oder 2, **dadurch gekennzeichnet, dass** die emittierende Schicht nur aus den beiden elektronentransportierenden Verbindungen und der phosphoreszierenden Iridiumverbindung besteht oder dass die emittierende Schicht außer den beiden elektronentransportierenden Verbindungen und der phosphoreszierenden Iridiumverbindung noch mindestens eine weitere lumineszierende Iridiumverbindung enthält.

4. Organische Elektrolumineszenzvorrichtung nach einem oder mehreren der Ansprüche 1 bis 3, **dadurch gekennzeichnet, dass** für jede der beiden elektronentransportierenden Verbindungen gilt: $T_1$(Matrix) $\geq$ $T_1$(Emitter), wobei $T_1$(Matrix) für die niedrigste Triplettenergie der jeweiligen elektronentransportierenden Verbindung und $T_1$(Emitter) für die niedrigste Triplettenergie der phosphoreszierenden Iridiumverbindung steht.

5. Organische Elektrolumineszenzvorrichtung nach einem oder mehreren der Ansprüche 1 bis 4, **dadurch gekennzeichnet, dass** die elektronentransportierenden Verbindungen ausgewählt sind aus den Klassen der Triazine, der Pyrimidine, der Pyrazine, der Pyridazine, der Pyridine, der Lactame, der Metallkomplexe, der aromatischen Ketone, der aromatischen Phosphinoxide, der Azaphosphole, der Azaborole, welche mit mindestens einem elektronentransportierenden Substituenten substituiert sind, und der Chinoxaline.

6. Organische Elektrolumineszenzvorrichtung nach einem oder mehreren der Ansprüche 1 bis 5, **dadurch gekennzeichnet, dass** die eine der elektronentransportierenden Verbindungen eine Triazin- oder Pyrimidinverbindung und die andere der elektronentransportierenden Verbindungen eine Lactamverbindung ist.

7. Organische Elektrolumineszenzvorrichtung nach einem oder mehreren der Ansprüche 1 bis 6, **dadurch gekennzeichnet, dass** mindestens eine elektronentransportierende Verbindung ausgewählt ist aus den Verbindungen der Formeln (8) bzw. (9),

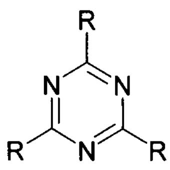

Formel (8)

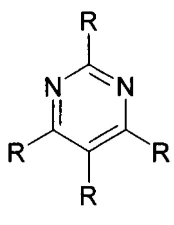

Formel (9)

wobei $R^1$ und $R^2$ die in Anspruch 1 genannten Bedeutungen aufweisen und weiterhin gilt:

R ist bei jedem Auftreten gleich oder verschieden ausgewählt aus der Gruppe bestehend aus H, D, F, Cl, Br, I, CN, $NO_2$, $N(R^1)_2$, $C(=O)R^1$, $P(=O)R^1$, einer geradkettigen Alkyl-, Alkoxy- oder Thioalkylgruppe mit 1 bis 20 C-Atomen oder einer verzweigten oder cyclischen Alkyl-, Alkoxy- oder Thioalkylgruppe mit 3 bis 20 C-Atomen oder einer Alkenyl- oder Alkinylgruppe mit 2 bis 20 C-Atomen, die jeweils mit einem oder mehreren Resten $R^1$ substituiert sein kann, wobei eine oder mehrere nicht-benachbarte $CH_2$-Gruppen durch $R^1C=CR^1$, C=C, $Si(R^1)_2$, C=O, C=S, $C=NR^1$, $P(=O)(R^1)$, SO, $SO_2$, $NR^1$, O, S oder $CONR^1$ ersetzt sein können und wobei ein oder

mehrere H-Atome durch D, F, Cl, Br, I, CN oder $NO_2$ ersetzt sein können, einem aromatischen oder heteroaromatischen Ringsystem mit 5 bis 40 aromatischen Ringatomen, das jeweils mit einem oder mehreren Resten $R^1$ substituiert sein kann, einer Aryloxy- oder Heteroaryloxygruppe mit 5 bis 40 aromatischen Ringatomen, die mit einem oder mehreren Resten $R^1$ substituiert sein kann, oder einer Aralkyl- oder Heteroaralkylgruppe mit 5 bis 40 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann; mit der Maßgabe, dass mindestens einer der Substituenten R für ein aromatisches oder heteroaromatisches Ringsystem steht.

**8.** Organische Elektrolumineszenzvorrichtung nach Anspruch 7, **dadurch gekennzeichnet, dass** mindestens eine elektronentransportierende Verbindung ausgewählt ist aus den Verbindungen der Formeln (8a) bzw. (9a) bis (9d),

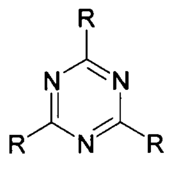
Formel (8a)
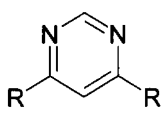
Formel (9a)
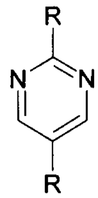
Formel (9b)
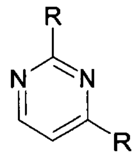
Formel (9c)
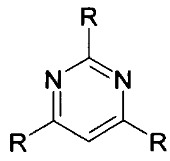
Formel (9d)

wobei R gleich oder verschieden für ein aromatisches oder heteroaromatisches Ringsystem mit 5 bis 40 aromatischen Ringatomen steht, das jeweils mit einem oder mehreren Resten $R^1$ substituiert sein kann, und $R^1$ die in Anspruch 1 genannte Bedeutung aufweist.

**9.** Organische Elektrolumineszenzvorrichtung nach einem oder mehreren der Ansprüche 1 bis 8, **dadurch gekennzeichnet, dass** mindestens eine elektronentransportierende Verbindung ein Lactam ist, das ausgewählt ist aus den Verbindungen der Formeln (53) bzw. (54),

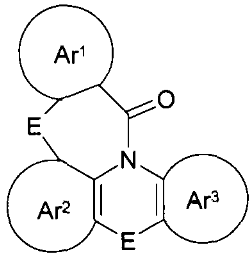
Formel (53)
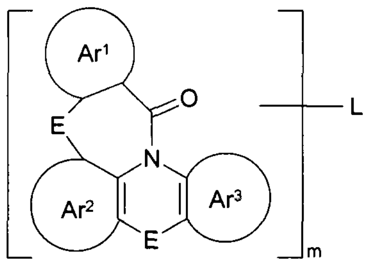
Formel (54)

wobei R, $R^1$ und $R^2$ die in den Ansprüchen 1 und 7 genannten Bedeutungen aufweisen und für die weiteren verwendeten Symbole und Indizes gilt:

E ist gleich oder verschieden bei jedem Auftreten eine Einfachbindung, NR, $CR_2$, O oder S;
$Ar^1$ ist zusammen mit den explizit dargestellten Kohlenstoffatomen ein aromatisches oder heteroaromatisches Ringsystem mit 5 bis 18 aromatischen Ringatomen, welches durch einen oder mehrere Reste R substituiert sein kann;
$Ar^2$, $Ar^3$ ist gleich oder verschieden bei jedem Auftreten zusammen mit den explizit dargestellten Kohlenstoffatomen ein aromatisches oder heteroaromatisches Ringsystem mit 5 bis 18 aromatischen Ringatomen, welches durch einen oder mehrere Reste R substituiert sein kann;
L ist für m = 2 eine Einfachbindung oder eine bivalente Gruppe, bzw. für m = 3 eine trivalente Gruppe bzw. für m = 4 eine tetravalente Gruppe, welche jeweils an eine beliebige Position an $Ar^1$, $Ar^2$ oder $Ar^3$ oder statt einem Rest R an E gebunden ist;
m ist 2, 3 oder 4.

**10.** Organische Elektrolumineszenzvorrichtung nach einem oder mehreren der Ansprüche 1 bis 9, **dadurch gekenn-**

**zeichnet, dass** die Strukturen der Formeln (1) bis (7) ausgewählt sind aus den Strukturen der Formeln (1-A) bis (1-F), (2-A) bis (2-F), (3-A) bis (3-E), (4-A) bis (4-C), (5-A), (6-A) und (7-A),

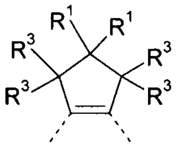
Formel (1-A)

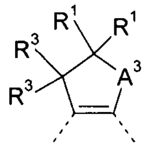
Formel (1-B)

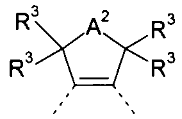
Formel (1-C)

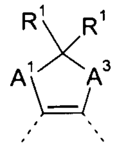
Formel (1-D)

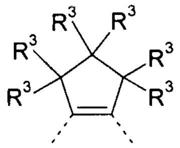
Formel (1-E)

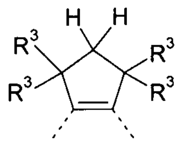
Formel (1-F)

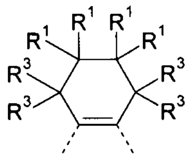
Formel (2-A)

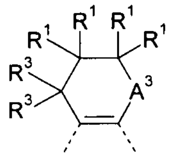
Formel (2-B)

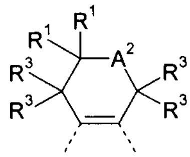
Formel (2-C)

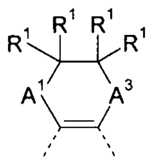
Formel (2-D)

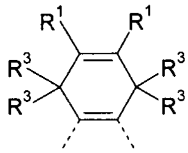
Formel (2-E)

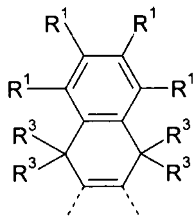
Formel (2-F)

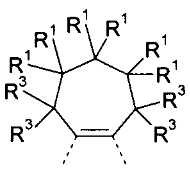
Formel (3-A)

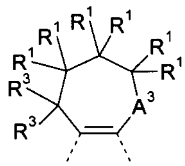
Formel (3-B)

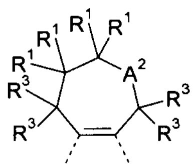
Formel (3-C)

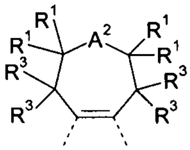
Formel (3-D)

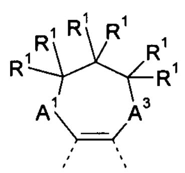
Formel (3-E)

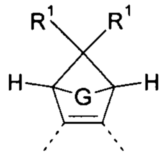
Formel (4-A)

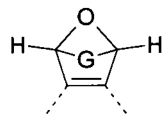
Formel (4-B)

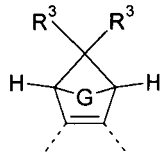
Formel (4-C)

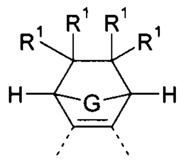
Formel (5-A)

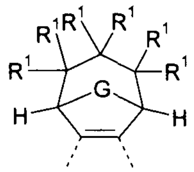
Formel (6-A)

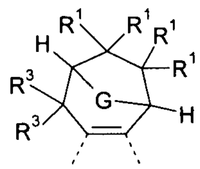
Formel (7-A)

wobei G, $R^1$ und $R^3$ die in Anspruch 1 genannten Bedeutungen aufweisen und $A^1$, $A^2$ und $A^3$ gleich oder verschieden bei jedem Auftreten für O oder $NR^3$ stehen.

**11.** Organische Elektrolumineszenzvorrichtung nach einem oder mehreren der Ansprüche 1 bis 10, **dadurch gekennzeichnet, dass** es sich bei der phosphoreszierenden Iridiumverbindung um eine Verbindung der Formel (75) handelt,

$Ir(L^1)_p(L^2)_q$ Formel (75)

wobei für die verwendeten Symbole und Indizes gilt:

$L^1$ ist ein bidentater monoanionischer Ligand, der mindestens eine Aryloder Heteroarylgruppe aufweist, die an das Iridium über ein Kohlenstoff- oder Stickstoffatom bindet und die eine Gruppe gemäß einer der Formeln (1) bis (7) aufweist;
$L^2$ ist gleich oder verschieden bei jedem Auftreten ein monoanionischer bidentater Ligand;
p ist 1, 2 oder 3;
q ist (3 - p).

**12.** Verfahren zur Herstellung einer organischen Elektrolumineszenzvorrichtung nach einem oder mehreren der Ansprüche 1 bis 11, **dadurch gekennzeichnet, dass** eine oder mehrere Schichten mit einem Sublimationsverfahren hergestellt werden und/oder dass eine oder mehrere Schichten mit dem Organic Vapour Phase Deposition Verfahren oder mit Hilfe einer Trägergassublimation hergestellt werden und/oder dass eine oder mehrere Schichten aus Lösung hergestellt werden.

## Claims

**1.** Organic electroluminescent device comprising cathode, anode and an emitting layer which comprises the following compounds:

(A) at least one electron-transporting compound which has an LUMO ≤ -2.4 eV; and
(B) at least one further electron-transporting compound which is different from the first electron-transporting compound and has an LUMO ≤ -2.4 eV; and
(C) at least one phosphorescent iridium compound which has at least one at least bidentate ligand which is bonded to the iridium via one carbon atom and one nitrogen atom or via two carbon atoms and which has at least one unit of one of the following formulae (1) to (7),

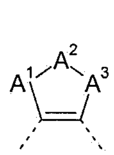
formula (1)

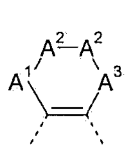
formula (2)

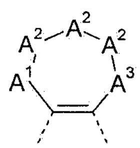
formula (3)

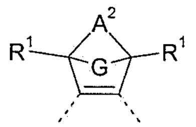
formula (4)

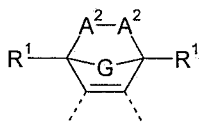
formula (5)

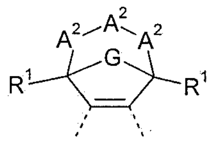
formula (6)

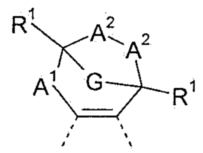
formula (7)

where the two carbon atoms explicitly drawn in are atoms which are part of the ligand, and the dashed bonds indicate the linking of the two carbon atoms in the ligand and furthermore:

$A^1$, $A^3$ are, identically or differently on each occurrence, $C(R^3)_2$, O, S, $NR^3$ or C(=O);
$A^2$ is $C(R^1)_2$, O, S, $NR^3$ or C(=O); with the proviso that no two heteroatoms in the groups of the formulae (1) to (7) are bonded directly to one another and in that no two groups C=O are bonded directly to one another;

G is an alkylene group having 1, 2 or 3 C atoms, which may be substituted by one or more radicals $R^2$, or is $-CR^2=CR^2-$ or an ortho-linked arylene or heteroarylene group having 5 to 14 aromatic ring atoms, which may be substituted by one or more radicals $R^2$;
$R^1$ is on each occurrence, identically or differently, H, D, F, Cl, Br, I, $N(R^2)_2$, CN, $Si(R^2)_3$, $B(OR^2)_2$, $C(=O)R^2$, a straight-chain alkyl, alkoxy or thioalkoxy group having 1 to 20 C atoms or a straight-chain alkenyl or alkynyl group having 2 to 20 C atoms or a branched or cyclic alkyl, alkenyl, alkynyl, alkoxy or thioalkoxy group having 3 to 20 C atoms, which may in each case be substituted by one or more radicals $R^2$, where one or more non-adjacent $CH_2$ groups may be replaced by $R^2C=CR^2$, $Si(R^2)_2$, C=O, $NR^2$, O, S or $CONR^2$ and where one or more H atoms may be replaced by D, F or CN, or an aromatic or heteroaromatic ring system having 5 to 60 aromatic ring atoms, which may in each case be substituted by one or more radicals $R^2$, or an aryloxy or heteroaryloxy group having 5 to 40 aromatic ring atoms, which may be substituted by one or more radicals $R^2$, or a diarylamino group, diheteroarylamino group or arylheteroarylamino group having 10 to 40 aromatic ring atoms, which may be substituted by one or more radicals $R^2$; two or more adjacent radicals $R^1$ may form an aliphatic ring system with one another;
$R^2$ is on each occurrence, identically or differently, H, D, F or an aliphatic, aromatic and/or heteroaromatic organic radical having 1 to 20 C atoms, in which, in addition, one or more H atoms may be replaced by D or F; two or more substituents $R^2$ may also form an aliphatic or aromatic ring system with one another;
$R^3$ is, identically or differently on each occurrence, F, a straightchain alkyl or alkoxy group having 1 to 10 C atoms, a branched or cyclic alkyl or alkoxy group having 3 to 10 C atoms, which may in each case be substituted by one or more radicals $R^2$, where one or more non-adjacent $CH_2$ groups may be replaced by $R^2C=CR^2$, $Si(R^2)_2$, C=O, $NR^2$, O, S or $CONR^2$ and where one or more H atoms may be replaced by D or F, or an aromatic or heteroaromatic ring system having 5 to 24 aromatic ring atoms, which may in each case be substituted by one or more radicals $R^2$, or an aryloxy or heteroaryloxy group having 5 to 24 aromatic ring atoms, which may be substituted by one or more radicals $R^2$, or an aralkyl or heteroaralkyl group having 5 to 24 aromatic ring atoms, which may be substituted by one or more radicals $R^2$; two radicals $R^3$ which are bonded to the same carbon atom may form an aliphatic or aromatic ring system with one another and thus form a spiro system; furthermore, $R^3$ may form an aliphatic ring system with an adjacent radical $R^1$.

2. Organic electroluminescent device according to Claim 1, **characterised in that** the LUMO of each of the electron-transporting compounds is $\leq$ -2.50 eV.

3. Organic electroluminescent device according to Claim 1 or 2, **characterised in that** the emitting layer consists only of the two electron-transporting compounds and the phosphorescent iridium compound or **in that** the emitting layer,

apart from the two electron-transporting compounds and the phosphorescent iridium compound, also comprises at least one further luminescent iridium compound.

**4.** Organic electroluminescent device according to one or more of Claims 1 to 3, **characterised in that** the following applies to each of the two electron-transporting compounds: $T_1$(matrix) $\geq$ $T_1$(emitter), where $T_1$(matrix) stands for the lowest triplet energy of the respective electron-transporting compound and $T_1$(emitter) stands for the lowest triplet energy of the phosphorescent iridium compound.

**5.** Organic electroluminescent device according to one or more of Claims 1 to 4, **characterised in that** the electron-transporting compounds are selected from the classes of the triazines, the pyrimidines, the pyrazines, the pyridazines, the pyridines, the lactams, the metal complexes, the aromatic ketones, the aromatic phosphine oxides, the azaphospholes, the azaboroles, which are substituted by at least one electron-transporting substituent, and the quinoxalines.

**6.** Organic electroluminescent device according to one or more of Claims 1 to 5, **characterised in that** one of the electron-transporting compounds is a triazine or pyrimidine compound and the other of the electron-transporting compounds is a lactam compound.

**7.** Organic electroluminescent device according to one or more of Claims 1 to 6, **characterised in that** at least one electron-transporting compound is selected from the compounds of the formulae (8) and (9),

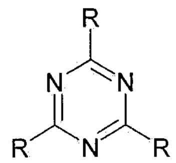
formula (8)

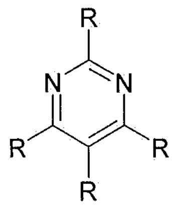
formula (9)

where $R^1$ and $R^2$ have the meanings given in Claim 1 and furthermore:

R is selected on each occurrence, identically or differently, from the group consisting of H, D, F, Cl, Br, I, CN, $NO_2$, $N(R^1)_2$, $C(=O)R^1$, $P(=O)R^1$, a straight-chain alkyl, alkoxy or thioalkyl group having 1 to 20 C atoms or a branched or cyclic alkyl, alkoxy or thioalkyl group having 3 to 20 C atoms or an alkenyl or alkynyl group having 2 to 20 C atoms, which may in each case be substituted by one or more radicals $R^1$, where one or more non-adjacent $CH_2$ groups may be replaced by $R^1C=CR^1$, C=C, $Si(R^1)_2$, C=O, C=S, $C=NR^1$, $P(=O)(R^1)$, SO, $SO_2$, $NR^1$, O, S or $CONR^1$ and where one or more H atoms may be replaced by D, F, Cl, Br, I, CN or $NO_2$, an aromatic or heteroaromatic ring system having 5 to 40 aromatic ring atoms, which may in each case be substituted by one or more radicals $R^1$, an aryloxy or heteroaryloxy group having 5 to 40 aromatic ring atoms, which may be substituted by one or more radicals $R^1$, or an aralkyl or heteroaralkyl group having 5 to 40 aromatic ring atoms, which may be substituted by one or more radicals $R^1$, where two or more adjacent substituents R may optionally form a monocyclic or polycyclic, aliphatic, aromatic or heteroaromatic ring system, which may be substituted by one or more radicals $R^1$; with the proviso that at least one of the substituents R stands for an aromatic or heteroaromatic ring system.

**8.** Organic electroluminescent device according to Claim 7, **characterised in that** at least one electron-transporting compound is selected from the compounds of the formulae (8a) and (9a) to (9d),

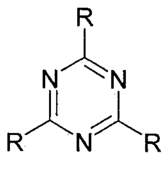
formula (8a)

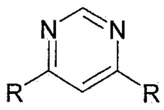
formula (9a)

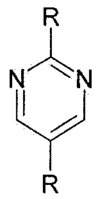
formula (9b)

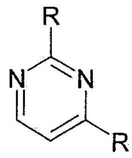
formula (9c)

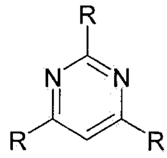
formula (9d)

where R stands, identically or differently, for an aromatic or heteroaromatic ring system having 5 to 40 aromatic ring atoms, which may in each case be substituted by one or more radicals $R^1$, and $R^1$ has the meaning given in Claim 1.

9. Organic electroluminescent device according to one or more of Claims 1 to 8, **characterised in that** at least one electron-transporting compound is a lactam which is selected from the compounds of the formulae (53) and (54),

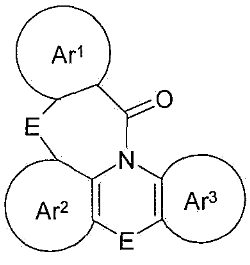
formula (53)

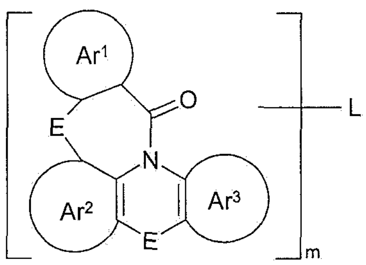
formula (54)

where R, $R^1$ and $R^2$ have the meanings given in Claims 1 and 7 and the following applies to the other symbols and indices used:

E is, identically or differently on each occurrence, a single bond, NR, $CR_2$, O or S;
$Ar^1$ is, together with the carbon atoms explicitly depicted, an aromatic or heteroaromatic ring system having 5 to 18 aromatic ring atoms, which may be substituted by one or more radicals R;
$Ar^2$, $Ar^3$ are, identically or differently on each occurrence, together with the carbon atoms explicitly depicted, an aromatic or heteroaromatic ring system having 5 to 18 aromatic ring atoms, which may be substituted by one or more radicals R;
L for m = 2 is a single bond or a divalent group, or for m = 3 is a trivalent group or for m = 4 is a tetravalent group, which is in each case bonded to $Ar^1$, $Ar^2$ or $Ar^3$ at any desired position or is bonded to E in place of a radical R;
m is 2, 3 or 4.

10. Organic electroluminescent device according to one or more of Claims 1 to 9, **characterised in that** the structures of the formulae (1) to (7) are selected from the structures of the formulae (1-A) to (1-F), (2-A) to (2-F), (3-A) to (3-E), (4-A) to (4-C), (5-A), (6-A) and (7-A),

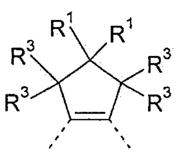
formula (1-A)

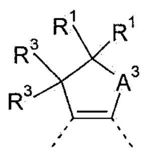
formula (1-B)

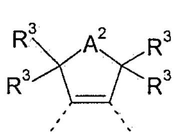
formula (1-C)

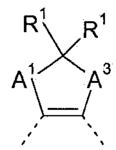
formula (1-D)

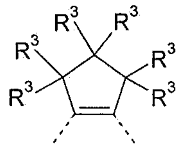
formula (1-E)

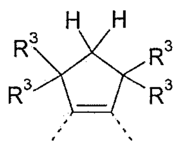
formula (1-F)

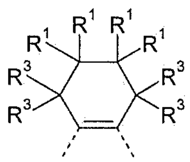
formula (2-A)

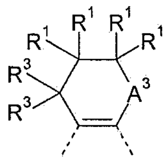
formula (2-B)

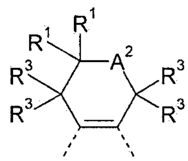
formula (2-C)

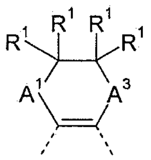
formula (2-D)

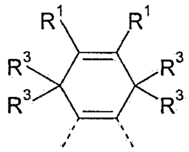
formula (2-E)

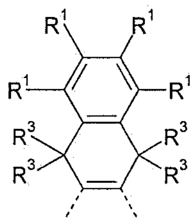
formula (2-F)

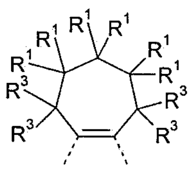
formula (3-A)

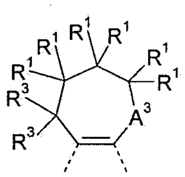
formula (3-B)

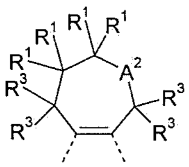
formula (3-C)

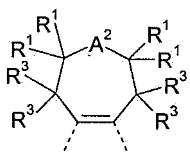
formula (3-D)

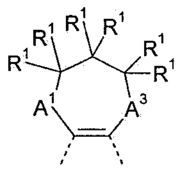
formula (3-E)

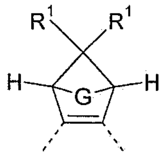
formula (4-A)

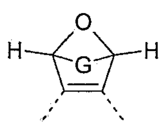
formula (4-B)

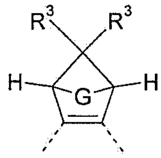
formula (4-C)

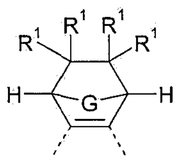

formula (5-A)

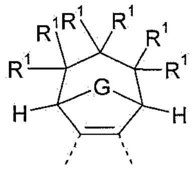

formula (6A)

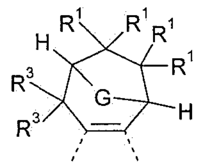

formula (7-A)

where G, $R^1$ and $R^3$ have the meanings given in Claim 1 and $A^1$, $A^2$ and $A^3$ stand, identically or differently on each occurrence, for O or $NR^3$.

**11.** Organic electroluminescent device according to one or more of Claims 1 to 10, **characterised in that** the phosphorescent iridium compound is a compound of the formula (75),

$Ir(L^1)_p(L^2)_q$ formula (75)

where the following applies to the symbols and indices used:

$L^1$ is a bidentate monoanionic ligand which contains at least one aryl or heteroaryl group which is bonded to the iridium via a carbon or nitrogen atom and which contains a group of one of the formulae (1) to (7);
$L^2$ is, identically or differently on each occurrence, a monoanionic bidentate ligand;
p is 1, 2 or 3;
q is (3 - p).

**12.** Process for the production of an organic electroluminescent device according to one or more of Claims 1 to 11, **characterised in that** one or more layers are produced by a sublimation process and/or **in that** one or more layers are produced by the organic vapour phase deposition process or with the aid of carrier-gas sublimation and/or **in that** one or more layers are produced from solution.

**Revendications**

**1.** Dispositif électroluminescent organique comprenant une cathode, une anode et une couche d'émission qui comprend les composés qui suivent :

(A) au moins un composé de transport d'électrons qui présente une orbitale moléculaire non occupée de plus basse énergie, soit une LUMO ≤ -2,4 eV ; et
(B) au moins un autre composé de transport d'électrons qui est différent du premier composé de transport d'électrons et qui présente une LUMO ≤ -2,4 eV ; et
(C) au moins un composé d'iridium phosphorescent qui comporte au moins un ligand bidenté qui est lié à l'iridium via un atome de carbone et un atome d'azote ou via deux atomes de carbone et qui comporte au moins une unité de l'une des formules (1) à (7) qui suivent :

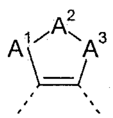

formule (1)

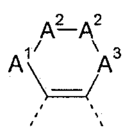

formule (2)

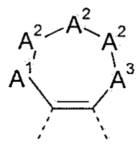

formule (3)

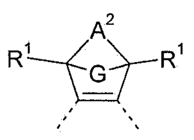
formule (4)

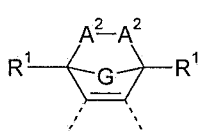
formule (5)

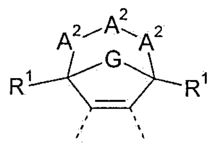
formule (6)

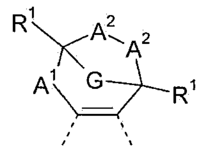
formule (7)

dans lesquelles les deux atomes de carbones qui sont dessinés de façon explicite sont des atomes qui constituent une partie du ligand, et les liens en pointillés indiquent la liaison des deux atomes de carbone dans le ligand et en outre :

$A^1$, $A^3$ sont, de manière identique ou différente pour chaque occurrence, $C(R^3)_2$, O, S, $NR^3$ ou C(=O) ;
$A^2$ est $C(R^1)_2$, O, S, $NR^3$ ou C(=O) ;
étant entendu que deux hétéroatomes dans les groupes des formules (1) à (7) ne sont pas liés directement l'un à l'autre et étant entendu que deux groupes C=O ne sont pas liés directement l'un à l'autre ;

G est un groupe alkylène qui comporte 1, 2 ou 3 atome(s) de C , lequel peut être substitué par un radical ou par plusieurs radicaux $R^2$, ou est $-CR^2=CR^2-$ ou un groupe arylène ou hétéroarylène ortho-lié qui comporte de 5 à 14 atomes de cycle aromatique, lequel peut être substitué par un radical ou par plusieurs radicaux $R^2$ ;
$R^1$ est pour chaque occurrence, de manière identique ou différente, H, D, F, Cl, Br, I, $N(R^2)_2$, CN, $Si(R^2)_3$, $B(OR^2)_2$, $C(=O)R^2$, un groupe alkyle, alcoxy ou thioalcoxy en chaîne droite qui comporte de 1 à 20 atome(s) de C ou un groupe alkényle ou alkynyle en chaîne droite qui comporte de 2 à 20 atomes de C ou un groupe alkyle, alkényle, alkynyle, alcoxy ou thioalcoxy ramifié ou cyclique qui comporte de 3 à 20 atomes de C, lequel peut dans chaque cas être substitué par un radical ou par plusieurs radicaux $R^2$, où un ou plusieurs groupe(s) $CH_2$ non adjacents peut/peuvent être remplacé(s) par $R^2C=CR^2$, $Si(R^2)_2$, C=O, $NR^2$, O, S ou $CONR^2$ et où un ou plusieurs atome(s) de H peut/peuvent être remplacé(s) par D, F ou CN, ou un système de cycle aromatique ou hétéroaromatique qui comporte de 5 à 60 atomes de cycle aromatique, lequel peut dans chaque cas être substitué par un radical ou par plusieurs radicaux $R^2$, ou un groupe aryloxy ou hétéroaryloxy qui comporte de 5 à 40 atomes de cycle aromatique, lequel peut être substitué par un radical ou par plusieurs radicaux $R^2$, ou un groupe diarylamino, un groupe dihétéroarylamino ou un groupe arylhétéroarylamino qui comporte de 10 à 40 atomes de cycle aromatique, lequel peut être substitué par un radical ou par plusieurs radicaux $R^2$; deux radicaux $R^1$ adjacents ou plus peuvent former un système de cycle aliphatique l'un avec l'autre ou les uns avec les autres ;
$R^2$ est pour chaque occurrence, de manière identique ou différente, H, D, F ou un radical organique aliphatique, aromatique et/ou hétéroaromatique qui comporte de 1 à 20 atome(s) de C, où, en outre, un ou plusieurs atome(s) de H peut/peuvent être remplacé(s) par D ou par F ; deux substituants $R^2$ ou plus peuvent également former un système de cycle aliphatique ou aromatique l'un avec l'autre ou les uns avec les autres ;
$R^3$ est, de manière identique ou différente pour chaque occurrence, F, un groupe alkyle ou alcoxy en chaîne droite qui comporte de 1 à 10 atome(s) de C, un groupe alkyle ou alcoxy ramifié ou cyclique qui comporte de 3 à 10 atomes de C, lequel peut dans chaque cas être substitué par un radical ou par plusieurs radicaux $R^2$, où un ou plusieurs groupe(s) $CH_2$ non adjacents peut/peuvent être remplacé(s) par $R^2C=CR^2$, $Si(R^2)_2$, C=O, $NR^2$, O, S ou $CONR^2$ et où un ou plusieurs atome(s) de H peut/peuvent être remplacé(s) par D ou par F, ou un système de cycle aromatique ou hétéroaromatique qui comporte de 5 à 24 atomes de cycle aromatique, lequel peut dans chaque cas être substitué par un radical ou par plusieurs radicaux $R^2$, ou un groupe aryloxy ou hétéroaryloxy qui comporte de 5 à 24 atomes de cycle aromatique, lequel peut être substitué par un radical ou par plusieurs radicaux $R^2$, ou un groupe aralkyle ou hétéroaralkyle qui comporte de 5 à 24 atomes de cycle aromatique, lequel peut être substitué par un radical ou par plusieurs radicaux $R^2$; deux radicaux $R^3$ qui sont liés au même atome de carbone peuvent former un système de cycle aliphatique ou aromatique l'un avec l'autre et peuvent ainsi former un système spiro ; qui plus est, $R^3$ peut former un système de cycle aliphatique avec un radical $R^1$ adjacent.

**2.** Dispositif électroluminescent organique selon la revendication 1, **caractérisé en ce que** la LUMO de chacun des composés de transport d'électrons est ≤ -2,50 eV.

3. Dispositif électroluminescent organique selon la revendication 1 ou 2, **caractérisé en ce que** la couche d'émission est constituée par seulement les deux composés de transport d'électrons et par le composé d'iridium phosphorescent ou **en ce que** la couche d'émission, indépendamment des deux composés de transport d'électrons et du composé d'iridium phosphorescent, comprend également au moins un autre composé d'iridium luminescent.

4. Dispositif électroluminescent organique selon une ou plusieurs des revendications 1 à 3, **caractérisé en ce que** ce qui suit s'applique à chacun des deux composés de transport d'électrons : $T_1$(matrice) $\geq$ $T_1$(émetteur), où $T_1$(matrice) représente l'énergie de triplet la plus basse du composé de transport d'électrons respectif et $T_1$(émetteur) représente l'énergie de triplet la plus basse du composé d'iridium phosphorescent.

5. Dispositif électroluminescent organique selon une ou plusieurs des revendications 1 à 4, **caractérisé en ce que** les composés de transport d'électrons sont sélectionnés parmi les classes des triazines, des pyrimidines, des pyrazines, des pyridazines, des pyridines, des lactames, des complexes métalliques, des cétones aromatiques, des oxydes de phosphine aromatiques, des azaphospholes, des azaboroles, lesquels sont substitués par au moins un substituant de transport d'électrons, et les quinoxalines.

6. Dispositif électroluminescent organique selon une ou plusieurs des revendications 1 à 5, **caractérisé en ce que** l'un des composés de transport d'électrons est un composé de triazine ou de pyrimidine et l'autre des composés de transport d'électrons est un composé de lactame.

7. Dispositif électroluminescent organique selon une ou plusieurs des revendications 1 à 6, **caractérisé en ce qu'**au moins un composé de transport d'électrons est sélectionné parmi les composés des formules (8) et (9) :

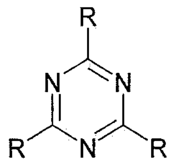
formule (8)

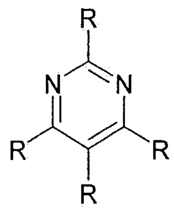
formule (9)

dans lesquelles $R^1$ et $R^2$ présentent les significations qui ont été données selon la revendication 1 et en outre :

R est sélectionné pour chaque occurrence, de manière identique ou différente, parmi le groupe qui est constitué par H, D, F, Cl, Br, I, CN, $NO_2$, $N(R^1)_2$, $C(=O)R^1$, $P(=O)R^1$, un groupe alkyle, alcoxy ou thioalkyle en chaîne droite qui comporte de 1 à 20 atome(s) de C ou un groupe alkyle, alcoxy ou thioalkyle ramifié ou cyclique qui comporte de 3 à 20 atomes de C ou un groupe alkényle ou alkynyle qui comporte de 2 à 20 atomes de C, lequel peut dans chaque cas être substitué par un radical ou par plusieurs radicaux $R^1$, où un ou plusieurs groupe(s) $CH_2$ non adjacents peut/peuvent être remplacé(s) par $R^1C=CR^1$, $C\equiv C$, $Si(R^1)_2$, C=O, C=S, $C=NR^1$, $P(=O)(R^1)$, SO, $SO_2$, $NR^1$, O, S ou $CONR^1$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 40 atomes de cycle aromatique, lequel peut dans chaque cas être substitué par un radical ou par plusieurs radicaux $R^1$, un groupe aryloxy ou hétéroaryloxy qui comporte de 5 à 40 atomes de cycle aromatique, lequel peut être substitué par un radical ou par plusieurs radicaux $R^1$, ou un groupe aralkyle ou hétéroaralkyle qui comporte de 5 à 40 atomes de cycle aromatique, lequel peut être substitué par un radical ou par plusieurs radicaux $R^1$, où deux substituants R adjacents ou plus peuvent en option former un système de cycle aliphatique, aromatique ou hétéroaromatique monocyclique ou polycyclique, lequel peut être substitué par un radical ou par plusieurs radicaux $R^1$ ; étant entendu qu'au moins l'un des substituants R représente un système de cycle aromatique ou hétéroaromatique.

8. Dispositif électroluminescent organique selon la revendication 7, **caractérisé en ce qu'**au moins un composé de transport d'électrons est sélectionné parmi les composés des formules (8a) et (9a) à (9d) :

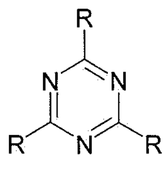
formule (8a)

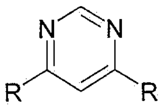
formule (9a)

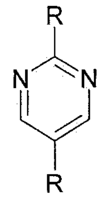
formule (9b)

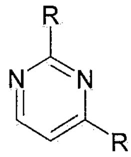
formule (9c)

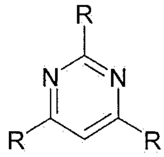
formule (9d)

dans lesquelles R représente, de manière identique ou différente, un système de cycle aromatique ou hétéroaromatique qui comporte de 5 à 40 atomes de cycle aromatique, lequel peut dans chaque cas être substitué par un radical ou par plusieurs radicaux $R^1$, et $R^1$ présente la signification qui a été donnée selon la revendication 1.

**9.** Dispositif électroluminescent organique selon une ou plusieurs des revendications 1 à 8, **caractérisé en ce qu'**au moins un composé de transport d'électrons est un lactame qui est sélectionné parmi les composés des formules (53) et (54) :

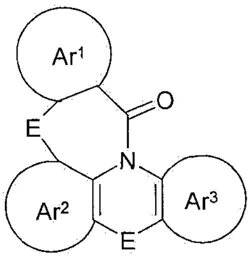
formule (53)

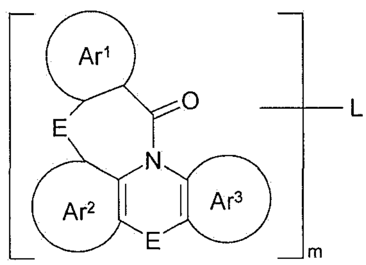
formule (54)

dans lesquelles R, $R^1$ et $R^2$ présentent les significations qui ont été données selon les revendications 1 et 7 et ce qui suit s'applique aux autres symboles et aux autres indices qui sont utilisés :

E est, de manière identique ou différente pour chaque occurrence, une liaison simple, NR, $CR_2$, O ou S ;
$Ar^1$ est, en association avec les atomes de carbone qui sont représentés de façon explicite, un système de cycle aromatique ou hétéroaromatique qui comporte de 5 à 18 atomes de cycle aromatique, lequel peut être substitué par un radical ou par plusieurs radicaux R ;
$Ar^2$, $Ar^3$ sont, de manière identique ou différente pour chaque occurrence, en association avec les atomes de carbone qui sont représentés de façon explicite, un système de cycle aromatique ou hétéroaromatique qui comporte de 5 à 18 atomes de cycle aromatique, lequel peut être substitué par un radical ou par plusieurs radicaux R ;
L pour m = 2 est une liaison simple ou un groupe divalent, ou pour m = 3 est un groupe trivalent ou pour m = 4 est un groupe tétravalent, lequel est dans chaque cas lié à $Ar^1$, $Ar^2$ ou $Ar^3$ au niveau de n'importe quelle position souhaitée ou est lié à E en lieu et place d'un radical R ;
m est 2, 3 ou 4.

**10.** Dispositif électroluminescent organique selon une ou plusieurs des revendications 1 à 9, **caractérisé en ce que** les structures des formules (1) à (7) sont sélectionnées parmi les structures des formules (1-A) à (1-F), (2-A) à (2-F), (3-A) à (3-E), (4-A) à (4-C), (5-A), (6-A) et (7-A) :

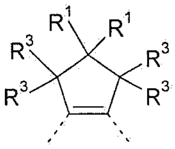
formule (1-A)

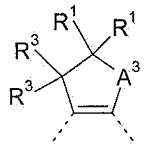
formule (1-B)

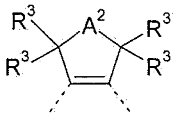
formule (1-C)

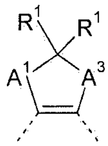
formule (1-D)

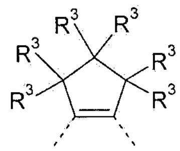
formule (1-E)

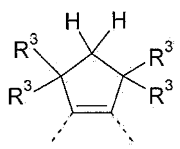
formule (1-F)

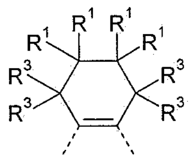
formule (2-A)

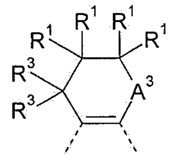
formule (2-B)

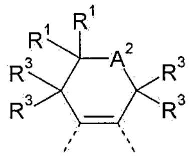
formule (2-C)

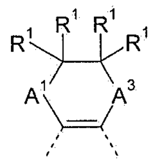
formule (2-D)

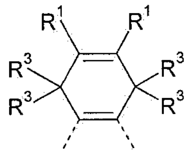
formule (2-E)

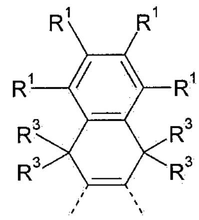
formule (2-F)

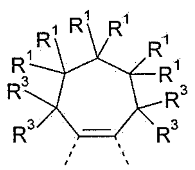
formule (3-A)

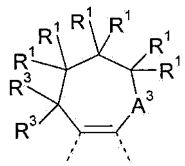
formule (3-B)

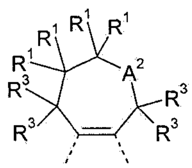
formule (3-C)

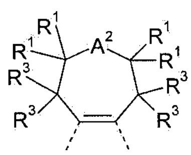
formule (3-D)

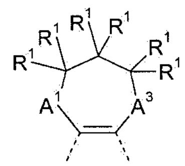
formule (3-E)

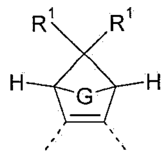
formule (4-A)

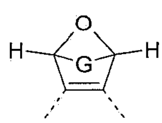
formule (4-B)

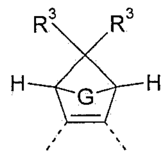
formule (4-C)

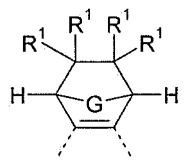

formule (5-A)

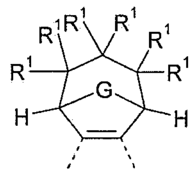

formule (6A)

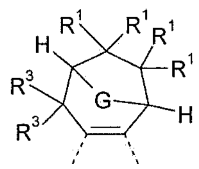

formule (7-A)

dans lesquelles G, $R^1$ et $R^3$ présentent les significations qui ont été données selon la revendication 1 et $A^1$, $A^2$ et $A^3$ représentent, de manière identique ou différente pour chaque occurrence, O ou $NR^3$.

**11.** Dispositif électroluminescent organique selon une ou plusieurs des revendications 1 à 10, **caractérisé en ce que** le composé d'iridium phosphorescent est un composé de la formule (75) :

$Ir(L^1)_p(L^2)_q$ formule (75)

dans laquelle ce qui suit s'applique aux symboles et aux indices qui sont utilisés :

$L^1$ est un ligand monoanionique bidenté qui contient au moins un groupe aryle ou hétéroaryle qui est lié à l'iridium via un atome de carbone ou d'azote et qui contient un groupe de l'une des formules (1) à (7) ;
$L^2$ est, de manière identique ou différente pour chaque occurrence, un ligand bidenté monoanionique ;
p est 1, 2 ou 3 ;
q est (3 - p).

**12.** Procédé pour la fabrication d'un dispositif électroluminescent organique selon une ou plusieurs des revendications 1 à 11, **caractérisé en ce qu'**une ou plusieurs couche(s) est/sont produite(s) au moyen d'un procédé de sublimation et/ou **en ce qu'**une ou plusieurs couche(s) est/sont produite(s) au moyen d'un procédé de dépôt organique en phase vapeur ou à l'aide d'une sublimation par gaz porteur et/ou **en ce qu'**une ou plusieurs couche(s) est/sont produite(s) à partir d'une solution.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 02047457 A
- WO 2004062324 A
- WO 2014094964 A
- WO 2014023377 A
- WO 2014094964 A1
- WO 2011116865 A
- WO 2011137951 A
- WO 2004093207 A
- WO 2005003253 A
- WO 2010006680 A
- WO 2010054730 A
- WO 2013091762 A
- WO 2014008982 A
- WO 2014094960 A
- EP 13004411 A
- EP 14000345 A
- EP 14000417 A
- EP 14002623 A
- WO 2011073149 A
- EP 1968131 A
- EP 2276085 A
- EP 2213662 A
- EP 1722602 A
- EP 2045848 A
- DE 102007031220
- US 8044390 B
- US 8057712 B
- WO 2009003455 A
- WO 2010094378 A
- WO 2011120709 A
- US 20100096600 A
- WO 2004058911 A


### In der Beschreibung aufgeführte Nicht-Patentliteratur


- **M. A. BALDO et al.** *Appl. Phys. Lett.,* 1999, vol. 75, 4-6
- *Chem. Rev.,* 2007, vol. 107, 1233
- **M. S. ARNOLD et al.** *Appl. Phys. Lett.,* 2008, vol. 92, 053301